# EUROPEAN PATENT SPECIFICATION

(11) **EP 0 399 054 B1**
(45) Date of publication and mention of the grant of the patent: **30.08.1995**
(21) Application number: 90900331.1
(22) Date of filing: 08.12.1989
(51) Int. Cl.: C21D 6/00, C21D 8/12, C21D 9/46, C30B 1/02

(54) **PRODUCTION METHOD OF CRYSTAL MEMBER HAVING CONTROLLED CRYSTAL ORIENTATION**
HERSTELLUNGSVERFAHREN VON KRISTALLINEN GEGENSTÄNDEN MIT GERICHTETER KRISTALLORIENTIERUNG
PROCEDE DE PRODUCTION D'UN ELEMENT CRISTALLIN PRESENTANT UNE ORIENTATION DETERMINEE

(30) Priority: 10.12.1988 JP 311024/88; 10.12.1988 JP 311025/88
(43) Date of publication of application: 28.11.1990
(73) Proprietor: KAWASAKI STEEL CORPORATION, Chuo-Ku, Kobe-City Hyogo 651 (JP)
(72) Inventor: MITSUNORI, Hiromi Kawasaki Steel Corporation, Chiba-shi Chiba 260 (JP); SADAYORI, Toshio Kawasaki Steel Corporation, Chiba-shi Chiba 260 (JP)
(74) Representative: Overbury, Richard Douglas
(86) International application number: PCT/JP89/01238
(87) International publication number: WO 90/06378

(56) References cited:
- JP-A- 0 582 289
- JP-A- 6 335 490
- JP-A- 6 365 024
- JP-A-63 149 318

## Description

### TECHNICAL FIELD

This invention relates to a method of producing a crystal body having a controlled crystalline orientation, and more particularly to a method of producing crystal bodies having a predetermined orientation such as single metal crystal, grain oriented silicon steel sheet, bidirectional oriented silicon steel sheet and the like wherein the crystal body having the predetermined orientation is rapidly and simply produced by artificially planting a seed crystal of an suitable orientation irrespective of the size of the crystal body and hence enabling mass production on an industrial scale.

### BACKGROUND ART

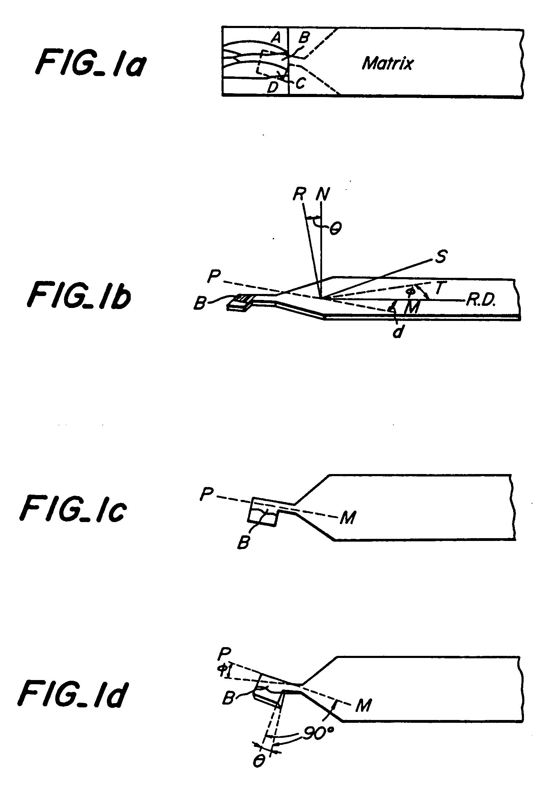

There are four methods for obtaining crystal bodies having a desired orientation, as mentioned below.
① Firstly, the simplest method is a method wherein a block-like single crystal is prepared and then a crystal body having a desired orientation is cut from the single crystal in accordance with the measured orientation of the single crystal.
   In this method, however, the cutting takes long time and is expensive, Also the size of the single crystal to be prepared is critical so the method is not suitable for mass production.
② Secondly, there is a method known as the strain-slant annealing method.
   This method is a method of growing a single crystal of desirable orientation from an end of a sample. A seed crystal is first prepared on the end of the sample and rotated in a desired direction to grow the whole of the seed crystal into a single crystal having the desirable orientation. The method was proposed by Fujiwara et al [T. Fujiwara and T. Hudita; J. Sci. Hiroshima Univ. A8 (1938), P293∼296].
   They have succeeded the preparation of single crystals by the above method from aluminum and also from pure iron.
   Thereafter, Dunn et al have applied the above method to large silicon steel sheets. [C. G. Dunn and G. C. Nonken: Metal Progress, 64 (1953) 6, P71∼75].
   According to their method for growing a plate crystal having a specified crystalline orientation, the end of a sample which has been previously subjected to strain is placed in the high temperature region of a temperature tilting furnace to prepare some seed crystals, as shown in Fig. 1a, among which a crystal grain having an adequate orientation is selected and cut out as shown in Fig. 1b. Then, a necked portion of the cut out crystal grain is bent as shown in Figs. 1c and 1d to align the seed crystal into a predetermined orientation with respect to the sample plate. Next, the seed crystal is annealed by heating in the temperature tilting furnace so as to grow over the whole of the plate.
   In this method, however, it is necessary to strictly control both the operation of selecting and cutting out a seed crystal having a suitable orientation from many crystal groups and the operation of bending the seed crystal into a predetermined orientation, which takes much labour and time. Hence mass production cannot be expected in the same way as for method ①.
③ Method utilizing secondary recrystallization phenomenon
   The secondary recrystallization is a phenomenon in which a seed of nucleating secondary grains largely grows due to the grain boundary energy of primary recrystallized grains which acts as a driving force. This phenomenon is widely utilized as a method of producing grain oriented silicon steel sheets and is well-known.
   The grain oriented silicon steel sheet is required to have excellent magnetic properties in the rolling direction. Since, it is required that the magnetizing force (magnetized properties), the magnetic flux density represented by the B₁₀ value (magnetic flux density in the rolling direction produced when the magnetizing force is 1000A /m), is high and that the iron loss represented by W_{17/50} value (iron loss when being magnetized at a magnetic flux density of 1.7T and a frequency of 50 Hz) is low, it is fundamentally necessary to highly align the 〈001〉 axis of the secondary recrystallized grains in steel into the rolling direction. Fine precipitates such as MnS, MnSe and the like are generally added as an inhibitor for this purpose. Furthermore, if necessary, a small amount of Sb (as disclosed in Japanese Patent Application Publication No. 51-13469), a small amount of Mo (as disclosed in Japanese Patent Application Publication No. 57-14737) or a combination of Al, N, Sn, Cu and the like (as disclosed in Japanese Patent Application Publication No. 60-48886) is added, which are carefully combined with the treating conditions in each of the hot rolling and cold rolling steps. In this way, grain oriented silicon steel sheets having high magnetic flux density and low iron loss, in which the B₁₀ value of magnetic flux density is more than 1.90T and the W_{17/50} value of iron loss is not more than 1.05 W/kg (thickness 0.30 mm), have been produced recently.
   Furthermore, a technique of producing bidirectional oriented silicon steel sheets by conducting the cold rolling crossways is proposed in Japanese Patent Application Publication No. 35-2657 and the like.
   However, in order to highly align the 〈001〉 axis of secondary recrystallized grains in the product into the rolling direction or a direction perpendicular to the rolling direction, it is necessary to adjust the components and to strictly control the numerous complicated steps of steel-making including; hot rolling, cold rolling and heat treatment. In the actual industrial production, however, the treating conditions are apt to be shifted from the correct conditions as mentioned above. If the treating conditions are slightly shifted, there is the problem that the orientation of the 〈001〉 axis into the rolling direction or the direction perpendicular to the rolling direction becomes poor.
   Lately, attempts have been made to reduce the thickness of product plate in order to reduce the iron loss. However, as the final thickness becomes small, the alignment of the 〈001〉 axis of secondary recrystallized grains into the rolling direction or the direction perpendicular to the rolling direction becomes unreliable. Hence improvement in the alignment of the 〈001〉 axis under such conditions is demanded.
   Japanese Patent Application Publication No. 58-50295 discloses a method utilizing the same method as described above in item ②, wherein secondary grains locally subjected to secondary recrystallization are used as a seed and a temperature gradient is applied to a steel sheet at the boundary between primary and secondary recrystallization regions in order to grow the seed. However, the production of a commercial material using this method has not yet been achieved.
   One basic problem is that the resulting crystalline orientation range is restricted in the aforementioned secondary recrystallization method, and consequently there is a problem that an orientation which is largely shifted from (110)[001] orientation or (100)[001] orientation is not obtained.
④ Method utilizing third order recrystallization
   Third order recrystallization proceeds using surface energy as a driving force, and is utilized for mainly growing (100)[hkl] grains in bidirectional oriented silicon steel sheet or the like. However, there are problems with the atmosphere control at high temperature, the accuracy of orientation control and the like.

As mentioned above, mass production cannot be achieved in a method capable of strictly controlling a specified orientation, since the orientation selectivity and control accuracy cause problems in methods capable of mass production. Hence methods capable or enabling mass production and strictly controlling the specified orientation are not yet known.

Moreover, the production of single crystals using the solidification method, in which a seed crystal is planted on an end of molten liquid metal and gradually cooled below the melting point to grow the seed crystal into a large crystal, is known as the Bridgeman method or previously as the Tanmann-Bridgeman method. However, the invention uses a technique in which the treating material growing the seed material is not liquid but is a solid having a crystal structure, and is entirely different from the aforementioned solidification method.

As mentioned above, if it is desired to strictly control the crystal orientation, much labor and time are spent to obtain a suitable seed, so that mass production cannot be conducted industrially. On the other hand, if mass production is intended, the seed must be prepared by rolling and recrystallization, thereby causing a problem in the accuracy of controlling the specified orientation due to the variations in production conditions. Furthermore, the growing orientation is restricted by the essential crystal structure of the starting material, so that there is still the problem that the orientation cannot be selected.

In this connection, the inventors have already found a method of directly planting a previously and strictly controlled seed crystal on a steel sheet using welding as a method of preparing a nucleus of secondary recrystallized grains, without rolling and recrystallization as in the production of grain oriented silicon steel sheets. This method is disclosed in Japanese Patent laid open No. 63-149318.

In this method, however, the quality of the joint portion is changed by the heat due to welding, so the problem remains that it is very difficult to preferentially grow the planted secondary grain nucleus stably over the weld portion.

The invention advantageously solves the aforementioned problems and provides a method of producing crystal bodies having a strictly controlled crystalline orientation. The method allows both industrial mass production and strict orientation control to a specified crystalline orientation.

Further, the invention improves the iron loss properties by positively shifting the 〈001〉 axis of Goss grains from the rolling face when producing grain oriented silicon steel sheet.

That is, in order to improve the iron loss properties, it is favorable that the 〈001〉 axis of the Goss grain is not completely coincident with the rolling face but is somewhat shifted therefrom. This is described, for example, in Japanese Patent Application Publication No. 57-61102 and [IEEE. Transactions on Magnetics Vol. Mag 21. No. 1 (1985)]. Insofar as |β| is concerned, about 2.5° is optimum for the reduction of iron loss. Thus an orientation alignment near to β=2.5° is strongly demanded. In the conventional method, if it is intended to raise the degree of aligning into {110}〈001〉 orientation by rolling and recrystallisation, of |α|, |β| and |γ|, |β| is particularly easy to be aligned near to 0. Therefore, in order to control the orientation so as to be near to β=2.5°, as disclosed in Japanese Patent Application Publication No. 58-5969, a nonproductive method is adopted in which waves are formed on a cold rolled steel sheet in a direction crossing with the cold rolling direction. The waved steel sheet is subjected to decarburization annealing and further to secondary recrystallization annealing in a continuous strip system, and then the sheet is subjected to purification annealing in a box after the coating with a slurry of an annealing separator and further to correcting treatment to flatten the waves on the waved sheet.

The inventors have previously noticed the method of planting a seed and made various proposals on the method of planting seed crystal by welding. In these proposals, however, there is a problem that the seed cannot stably ride over the weld portion due to the heat of welding, as previously mentioned.

Therefore, the inventors made further studies on a joining method which lessens the effects of heat as far as possible and found an effective means for achieving essential conditions required in low temperature joining, that is :
1) few impurities are present in the joint face;
2) the joint face is approached as far as possible.

Furthermore, it has been found that when utilizing such a low temperature joining method, it is not necessary to subject the steel sheet itself, as a treating material, to the strict orientation control as in the conventional method. Hence the orientation of the seed material is strictly controlled so the orientation of the seed material grows over the whole region of the steel sheet, whereby the properties equal to or better than those of the conventional case using complicated steps are obtained.

The invention is based on the above knowledge.

According to one aspect of the present invention there is provided a method of producing crystal bodies having a controlled crystalline orientation, wherein a seed material which has a crystal structure the same as that of a treating material and a predetermined crystalline orientation which is in a lower energy state than that of the treating material is joined to the treating material, wherein either the faces of the seed material and the treating material which are to be joined have been activated or an insert member which has a melting point lower than those of the seed material and the treating material is placed between the faces to be joined, and wherein the seed material and the treating material are heated to a temperature so that grain boundary movement renders the whole joined body into a single crystal body having the predetermined crystalline orientation.

In an embodiment, the method comprises the steps:
(a) forming the treating material by hot rolling a slab of silicon-containing steel, forming the hot rolled sheet into a final thickness, optionally by annealing and/or cold rolling, and then subjecting it to finish annealing,
(b) joining recrystallised seed material on to an edge portion of the treating material after hot rolling and before finish annealing so that the following orientation relationships are satisfied$\begin{matrix}\begin{matrix}\text{¦α¦ ≦ 5°} \\ \text{1 ≦ ¦β¦ ≦ 5°}\end{matrix}\end{matrix}$ where α = the angle defined by a projection line of the 〈001〉 axis of the seed material with respect to the rolling face of the steel sheet and the rolling direction of the steel sheet;
   β = the inclination angle of the 〈001〉 axis of the seed material with respect to the rolling face of the steel sheet, and
(c) heating the joint to a temperature sufficient to cause grain boundary movement so that orientation of the seed material grows over the whole of the steel sheet.

In an alternative embodiment, the method comprises the steps:
(a) forming the treating material by hot rolling a slab of silicon-containing steel, forming the hot rolled sheet into a final thickness, optionally by annealing and/or cold rolling, and then subjecting it to a finish annealing,
(b) joining recrystallized seed material on to an edge portion of the steel sheet after hot rolling and before finish annealing so that the following orientation relationships are satisfied$\begin{matrix}\begin{matrix}\text{¦α¦ ≦ 10°} \\ \text{¦β¦ ≦ 10°}\end{matrix}\end{matrix}$ where α = the angle defined by a projection line of the 〈001〉 axis of the seed material with respect to the rolling face of the steel sheet and the rolling direction of the steel sheet;
   β = the inclination angle of the {001} face of the seed material with respect to the rolling face of the steel sheet, and
(c) heating the joint to a temperature sufficient to cause grain boundary movement so that orientation of the seed material grows over the whole of the steel sheet.

In another embodiment, the method further includes the step of subjecting the steel sheet to primary recrystallization annealing before finish annealing. In a further embodiment, the amount of C in the steel before cold rolling is reduced to not more than 0.010% by weight. In yet another embodiment, a coil-like steel sheet may be used as the treating material.

In each of the above embodiments, the joining of the treating material and the seed material is preferably carried out under an application of stress.

Furthermore, in each of the above embodiments, the heating atmosphere is preferably a non-oxidizing atmosphere.

In the production methods of grain oriented electromagnetic steel sheets and bidirectional oriented electromagnetic steel sheets, it is desirable to reduce C amount in steel before cold rolling to not more than 0.010 wt% (hereinafter simply shown by %).

The term "same crystal structure" used herein means a structure in which the crystal system and lattice constant are the same.

Moreover, the term "energy state" used in the present invention is concerned with inner strain and surface and is mainly dependent upon the quantity and mass of the crystal grain boundary, dislocation, point defect and surface energy of crystal. As these quantities increase, the energy state becomes higher.

The basic experiments which led to the success of the invention are now described below.

### Experiment 1

A single crystal plate was provided as a seed material A at a low energy state, the single crystal plate comprising Si: 3% and the balance being substantially Fe and having a (110) face in its plate surface, a thickness of 0.3 mm and a 10 mm square surface. Treating material B at high energy state was a steel sheet 10 mm square obtained by hot rolling an ingot of silicon steel comprising Si: 3%, S: 0.020%, Al: 0.025% and N: 0.0080%, with the balance being substantially Fe, and cold rolling the ingot to a thickness of 0.3 mm and cutting out the steel sheet therefrom.

Two plate surfaces of each of A and B were finished to a mirror state, having a center-line average roughness Ra of not more than 0.01 »m, by Emery polishing, buff polishing or float polishing.

The polished surfaces of A, B were subjected to an ion sputtering of Ar under a high vacuum of 10⁻⁶ Torr (1·33 × 10⁻⁴ Pa), and thereafter the mirror surfaces of A, B were contacted with each other to form two joined bodies C and D.

Annealing at 1000°C for 5 hours was performed on body C under a superhigh vacuum of 10⁻¹⁰ Torr (1·33 × 10⁻⁸ Pa) and on body D in N₂, respectively.

As a result, the grain boundary locally remained in the joint face of body D. Further, when the crystalline orientation of A, B including the joint face was measured, portions restraining the grain boundary in the joint face had different orientations, and the portions having no grain boundary had the same orientation.

On the other hand, no grain boundary was recognized in the joint face of body C, so that when the crystalline orientation of A, B including the joint face was measured, the same orientation was observed. Consequently B was a single crystal body having the same orientation as in A.

That is, material A having a crystal structure at a low energy state was joined with material B having a crystal structure at a high energy state by heating and by controlling the atmosphere during heating so as not to form an impurity film at the joint face between materials A and B, whereby the amount of the material A having a crystal structure at a low energy state could be increased to two times.

In order to advantageously perform industrial production at lower cost, the atmosphere used during heating is conveniently a non-oxidizing gas (N₂ or Ar) atmosphere rather than a vacuum. This aim was achieved by joining the joint surfaces through a low melting point metal as mentioned below.

Each of the above seed material A and the treating material B was subjected to a plate surface treatment of:
i) pickling with hydrochloric acid;
ii) grinding;
iii) Emery polishing;
iv) chemical polishing;
v) chemical polishing + ion etching
and then the treated surface was subjected to Sn plating at a thickness of 0.5 »m. Then, the Sn plated surfaces A and B were contacted with each other as sets of A and B and were annealed in a N₂ atmosphere at 1000°C for 10 hours by varying the stress vertically applied to the contacted surface for every plate surface treating condition. Then the presence (X) and absence (○) of a crystal grain boundary at the joint interface was observed.

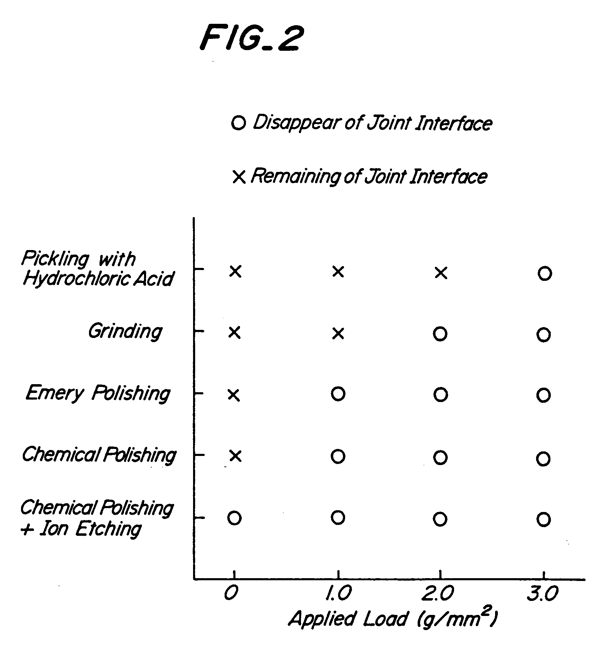

The results are shown in Fig. 2.

As seen from the results of this figure, in the case of the pickling treatment with hydrochloric acid, which makes the roughness large and retains many impurities on the surface, a strong applied load was required to make the crystal grain boundary disappear, while in the case of chemical polishing + ion etching, which make the surface smooth and reduce impurities, the crystal grain boundary disappeared without the application of a load.

Thus, the feature that a Sn film having a melting point as low as 232°C is interposed to make the crystal grain boundary disappear is considered to be due to the fact that the liquid Sn is closely filled in the joint interface during heating which shuts off the joint interface from air at a relatively low temperature. Thus the influence of the atmosphere is removed the formation of impurity film is prevented. This effect of the crystal grain boundary disappearing becomes large when the surface roughness of the joint face is small or the applied load is large. This is considered to be due to the fact that as the surface roughness becomes small or the applied load becomes large, the contact area increases and also the extra amount of Sn remaining in gaps at the interface becomes small which makes the movement of the crystal grain boundary at the joint face easy, while the interface becomes active through the increase in dislocation, slide deformation and the like due to the increase in stress. Consequently, the diffusion and dilution of Sn, which naturally obstructs grain boundary movement into the seed material and the treating material, is easy and the contact area of the active surface increases.

From the above experimental results, it has been found that the substance having a predetermined crystalline orientation can easily be produced by heating while holding the joint interface in an activated state or by using a low melting point metal.

These methods will be concretely described in the order of production steps.

Firstly the treating material and the seed material have the same crystal system, such as fcc, bcc or the like, and lattice constant.

Furthermore, there are no particular limitations in the treating material and the seed material to; (i) kind and quantity of impurity contained in the material, (ii) kind and quantity of element added, (iii) recrystallization texture, and (iv) quantity and mass of the crystal grain boundary included, dislocation, point defect and surface energy and the like because they are different in accordance with each substance or production step. However, it is important that the energy state of the treating material is higher than that of the seed material since, when the energy state of the seed material is equal to or lower than that of the treating material, the seed material cannot grow to achieve the object of the invention.

If the energy state of the treating material is too high, a nucleus of unsuitable orientation which is different from that of the seed material is created in the treating material and the object of the invention cannot be achieved. Thus it is necessary that the energy state is adjusted to a proper height in each case.

Moreover, the shape of these materials is not particularly restricted and may be block, plate, line, grain and the like. For example, in case of producing grain oriented silicon steel sheet, bidirectional oriented silicon steel sheet and the like, cold rolled coil obtained in the usual manner, as well as rapidly quenched ribbon obtained by roll quenching method and the like, are advantageously adapted as the treating material.

Then, the seed material and the treating material having a properly adjusted energy state are contacted with each other at their activated surfaces and heated to a temperature capable of causing the grain boundary movement.

This temperature is the temperature required for rearranging the crystal structure at a high energy state to the crystal structure at a low energy state, and is generally not lower than recrystallization temperature.

The term "surface of activated state" used herein means an exposed surface of raw material in the seed material and the treating material, i.e. a surface having no impurities adhered thereto or no impurity film formed thereon, or being very small in the presence thereof. Such a surface is obtained by polishing as well as treatment to remove impurities by the cleaning effect of a conventionally well-known flux such as rosin flux for soldering, inorganic flux of chloride, fluoride or the like, the liquefied cleaning effect of a low melting point metal, or further various cleaning methods. Particularly, better surfaces are obtained by a treatment such as ion etching under vacuum or the like. Therefore, the best atmosphere for maintaining such a surface is a vacuum state, but the non-oxidizing atmosphere is sufficiently adapted.

Furthermore, in order to completely effect joining, the contact area is preferable made as wide as possible, and hence the surface roughness of the contacting surface is ideally made as small as possible. Moreover, reducing the surface roughness is advantageous in view of preventing the remaining of impurities in concave portions.

In such a joint, it is preferable to apply stress to the contacting surface because the application of stress destroys the surface film and, for example, a cavitation effect develops through application of supersonic wave. In addition, the dislocation density locally increases at the contact interface to provide a more preferable activated state at high energy state, and even when the degree of flattening is insufficient flattening is promoted due to plastic deformation of concave and convex portions which increase the contact area. With regard to the component of applied stress, either pressure or a shearing force may be applied to the contacting surface, but the combination of both forces is more effective. Further, with regard to the intensity of such a stress, the deformation stress depends on the starting material and the heating temperature. Hence the intensity is not particularly restricted, but it is generally favorable to apply stress causing no deformation of less than 30%.

Furthermore, the intensity of the applied stress may be changed with time as in the supersonic wave or it may be constant. Particularly, the application of supersonic wave is advantageous in that bubbles in the low melting point substance inserted into the joint portion are removed thus resulting in a joint of high quality.

The action of the low melting point substance interposed between the seed material and the treating material (hereinafter simply referred to as the insert member) is described below.

The reason why the insert member is interposed between the joint faces is that the joint between the seed material and the treating material is easily formed in a suitable inert gas atmosphere and the flexibility and ease of heat diffusion are utilized. The insert member is softened at a relatively low temperature with the increase in temperature increasing the closeness of the joint face and filling member. Furthermore, the contacting portion is liquefied at a relatively low melting point, or at a eutectic temperature exhibiting the eutectic phenomenon with the matrix, to seal the joint interface from a harmful atmosphere and thereby prevent the penetration of impurities into the joint interface. By liquefying the contacting portion, breakage of the film and better contact can be expected and even when the surface treatment is insufficient joining proceeds well. Furthermore, the interposition of the insert member and rubbing between the joint faces due to the application of stress are particularly effective for close joining.

According to the invention, insert members forming a eutectic crystal and/or solid solution with the seed material and the treating material are advantageously used since these materials facilitate the dissolution and diffusion into the matrix by continuous heating, to reduce the liquid phase and make the joint interface narrower. As the liquid phase is reduced as far as possible in this step, joining is completed at the joining temperature in a short time.

Thus, the joint face before heating is ideally sufficiently close and the insert member is small. Therefore, the roughness of the joint face and the stress applied to the joint face become important.

On the other hand, the impurity film on the joint face such as oxide or the like is mixed and aggregated with the molten insert member to form an inclusion at the joint interface, and the aggregation is further facilitated during joining to promote the dissolution, diffusion and scattering into the seed material and the treating material. As a result, the existence of impurity atoms is removed at a part of the joint interface so that it exhibits properties substantially equal to that of the crystal boundary.

In this way, the distance between atoms in the joint interface becomes substantially equal to the lattice constant, and consequently the movement of atoms becomes possible. Then, the heating is continued at a temperature capable of causing the grain boundary movement, whereby the joint interface disappears and also the rearrangement from high energy state to low energy state or the movement of the grain boundary occurs to render the whole material into a crystal body having the predetermined orientation.

The preferred thickness of the insert member is as thin as possible. Further, application method is preferably; foil, plating, vapor deposition, spraying, PVD, CVD, ion implantation and the like. It is necessary that the insert member has a melting point lower than that of the joining material such as the seed material, the treating material or the like, but the use of a eutectic member or a substance which forms solid solutions in both the materials is more advantageous. Moreover, the proper insert member depends on the joining material, and is not particularly restricted. For example, when the treating material is iron or iron alloy, one of the following elements or a compound thereof is preferable as the insert member.

Ga, S, In, Se, Sn, Zn, Te, P, Sb, Al, Sr, Ce, As, Ge, Au, Cu, Mn, Be, Si, Bi, Cd, Pb, Ag.

With regard to the heating, a temperature capable of causing the grain boundary movement is necessary, and in case of pure metal, it is generally required to use at least recrystallization temperature of the metal. Furthermore, the heating removes the defect from the joint interface to produce a completely closed ideal joint interface on an atomic scale, so that it is preferable that the temperature is above a temperature likely to cause heat diffusion and is high enough that other orientation grains are not coarsened in the treating material at high energy state.

Uniform temperature heating can usually be adapted, but it is more advantageous to use such a temperature gradient that the temperature drops from the low energy substance towards the high energy substance as utilized in the long known preparation of a single crystal.

Concerning the treating atmosphere, it is important that a harmful oxide film is not formed on the joint face, and it is particularly preferable that the proximity at the joint interface on an atomic scale is sufficiently close. Therefore, when an insert member is not used, it is favorable to use as high a vacuum as possible. When the insert member is used, even if the surface film is present to some extent as mentioned above, the film is broken by the liquefaction of the insert member to make the surface active, the acceptable range of harmful substances contained in the atmosphere is poorer as compared with the vacuum, but the ratio of the range is different depending on the joining material, insert member, stress, surface state and the like and is not particularly defined. Furthermore, the atmosphere preferably does not react with the insert member until the insert member has diffused and scattered into the matrix and disappeared from the joint interface, while the harmfulness depends on the joining material after the completion of the movement together on the atomic scale; hence the atmosphere is not particularly limited. Moreover, when the joint interface comes into contact with an oxidizing atmosphere, the oxide film formed seals off the connecting movement of atoms between the seed material and the treating material, so that it is particularly favorable that Po₂ is lower when the contacting area in the first embodiment is small or until the insert member in the seventh embodiment is liquefied.

### Experiment 2-1

A slab of steel comprising C: 0.010%, Si: 3.35%, Mn: 0.15%, S: 0.008%, sol Al: 0.025%, N: 0.0085%, with the balance being substantially Fe, was heated at 1250°C for 1 hour and hot rolled to obtain a hot rolled sheet of 0.30 mm final thickness. Four square specimens each having length: 300 mm and width: 35 mm were cut out from the thus obtained hot rolled sheet as raw materials A1, A2, A3 and A4.

In addition, the above hot rolled sheet was subjected to annealing at 900°C for 3 minutes, from which specimens of given shape were cut out as raw materials AX1, AX2, AX3 and AX4.

Moreover, a hot rolled sheet of 2.3 mm thickness was formed by hot rolling, and immediately cold rolled to obtain a cold rolled sheet of 0.30 mm final thickness, from which specimens of given shape were cut out as raw materials AY1, AY2, AY3 and AY4.

Also, a hot rolled sheet of 2.3 mm thickness was formed by hot rolling and then subjected to normalized annealing at 900°C for 3 minutes and further to two-times cold rolling through an intermediate annealing at 950°C for 3 minutes to obtain a cold rolled sheet of 0.30 mm final thickness. Thereafter specimens of given shape were cut out therefrom as raw materials AXY1, AXY2, AXY3 and AXY4.

Two single crystal plates each comprising Si: 3.0%, with the balance being Fe and inevitable impurities, and having a thickness of 0.30 mm, length: 280 mm, width: 5 mm, α=0° and β=2° were provided as raw materials B1 and B2.

Furthermore, two single crystal plates each having the same size as mentioned above, α=0° and β=0° were provided as raw materials C1 and C2.

Then, a section parallel with the rolling direction and perpendicular to the rolling face in each of A1∼A4, AX1∼AX4, AY1∼AY4 and AXY1∼AXY4, as well as the (110) face perpendicular to the plate face in each of B1, B2, C1 and C2, were subjected to Emery polishing, buff polishing and float polishing to render them into a mirror state having a center-line average roughness Ra of not more than 10 nm. Thereafter a pair of two sets between A, AX, AY or AXY and B, and between, A, AX, AY or AXY and C, was prepared to obtain (A1, AX1, AY1, AXY1)-B1, (A2, AX2, AY2, AXY2)-B2, (A3, AX3, AY3, AXY3)-C1, (A4, AX4, AY4, AXY4)-C2. After each polished surface of A, AX, AY, AXY, B, C was subjected to an ion sputtering with Ar under high vacuum (10⁻⁶ Torr) (1·33 × 10⁻⁴ Pa), the mirrored faces of each of (A1, AX1, AY1, AXY1)-B1 and (A3, AX3, AY3, AXY3)-C1 were contacted with each other so that the projection axis of [001] axis of B and C was coincident with the rolling direction of A, AX, AY, AXY, which was annealed at a surface activated state under a superhigh vacuum (10⁻¹⁰ Torr) (1·33 × 10⁻⁸ Pa). After the ion sputtering the mirrored surfaces of each of (A2, AX2, AY2, AXY2)-B2 and (A4, AX4, AY4, AXY4)-C2 were contacted with each other at a surface inactive state in a suitable N₂ atmosphere and then annealed in the N₂ atmosphere. In this case annealing was carried out at 850°C for 50 hours followed by purification annealing at 1180°C in H₂ for 5 hours.

As a result, a crystal grain boundary was formed at the joint face in (A2, AX2, AY2, AXY2)-B2 and in (A4, AX4, AY4, AXY4)-C2 to obtain crystal bodies in which the orientation of A, AX, AY, AXY was different from that of each of B, C. On the contrary, no grain boundary was observed at the joint face in (A1, AX1, AY1, AXY1)-B1 and in (A3, AX3, AY3, AXY3)-C1, so that the resulting joined body was a single crystal body in which the orientation of A1, AX1, AY1, AXY1 was same as in B1 and the orientation of A3, AX3, AY3, AXY3 was same as in C1 when measuring the crystalline orientation around the joint face. Thus, the single crystal (nucleus of Goss grain) grew into a matrix, without changing the orientation, by contacting and heating while controlling the atmosphere so as to not form an impurity film at the joint face.

Moreover, Table 1-1 shows the measured magnetic properties of each joined body after the application of a tension coating.

**Table 1-1**

| | B₁₀ (T) | W_{17/50} (W/kg) |
|---|---|---|
| A1 - B1 | 2.015 | 0.92 |
| A2 - B2 | 1.72 | - |
| A3 - C1 | 2.021 | 1.35 |
| A4 - C2 | 1.68 | - |
| AX1 - B1 | 2.018 | 0.91 |
| AX2 - B2 | 1.80 | - |
| AX3 - C1 | 2.019 | 1.42 |
| AX4 - C2 | 1.75 | - |
| AY1 - B1 | 2.013 | 0.89 |
| AY2 - B2 | 1.77 | - |
| AY3 - C1 | 2.022 | 1.45 |
| AY4 - C2 | 1.73 | - |
| AXY1 - B1 | 2.015 | 0.93 |
| AXY2 - B2 | 1.76 | - |
| AXY3 - C1 | 2.023 | 1.37 |
| AXY4 - C2 | 1.79 | - |

### Experiment 2-2

A slab of steel comprising C: 0.042%, Si: 3.40%, Mn: 0.035%, Se: 0.012%, Sb: 0.020%, with the balance being substantially Fe, was heated at 1300°C for 1 hour and hot rolled to obtain a hot rolled sheet of 0.30 mm final thickness. Then, four square specimens having length: 300 mm and width: 35 mm were cut out from the resulting hot rolled sheet and subjected to decarburization and primary recrystallization annealing at 820°C in a wet hydrogen for 10 minutes to obtain raw materials A1', A2', A3' and A4'.

The hot rolled sheet was annealed at 900°C for 3 minutes, from which the specimens of given shape were cut out and subjected to the same decarburization and primary recrystallization annealing as mentioned above to obtain raw materials AX1', AX2', AX3' and AX4'.

Moreover, a hot rolled sheet of 2.3 mm thickness was formed by hot rolling and immediately cold rolled to obtain a cold rolled sheet of 0.30 mm final thickness, from which specimens of given shape were cut out and subjected to the same decarburization and primary recrystallization annealing as above to obtain raw materials AY1', AY2', AY3' and AY4'.

And also, a hot rolled sheet of 2.3 mm thickness was formed by hot rolling, which was subjected to normalized annealing at 900°C for 3 minutes and further to two-times cold rolling through an intermediate annealing at 950°C for 3 minutes to obtain a cold rolled sheet of 0.30 mm final thickness. Thereafter specimens of given shape were cut out therefrom and subjected to the same decarburization and primary recrystallization annealing as above to obtain raw materials AXY1', AXY2', AXY3' and AXY4'.

Two single crystal plates each comprising Si: 3.0%, with the balance being Fe and inevitable impurities, and having a thickness of 0.30 mm, length: 280 mm, width: 5 mm, α=0° and β=2° were provided as raw materials B1 and B2.

Furthermore, two single crystal plates each having the same size as mentioned above, α=0° and β=0° were provided as raw materials C1 and C2.

Then, a section parallel with the rolling direction and perpendicular to the rolling face in each of A1'∼A4', AX1'∼AX4', AY1'∼AY4' and AXY1'∼AXY4', as well as the (110) face perpendicular to the plate face in each of B1, B2, C1 and C2, were subjected to Emery polishing, buff polishing and float polishing to render them into a mirror state having a center-line average roughness Ra of not more than 10 nm. Thereafter a pair of two sets between A', AX', AY' or AXY' and B, and between A', AX', AY' or AXY' and C, was prepared to obtain (A1', AX1', AY1', AXY1')-B1, (A2', AX2', AY2', AXY2')-B2, (A3', AX3', AY3', AXY3')-C1, (A4', AX4', AY4', AXY4')-C2. After each polished surface of A', AX', AY', AXY', B, C was subjected to ion sputtering with Ar under high vacuum (10⁻⁶ Torr) (1·33 × 10⁻⁴ Pa), the mirrored faces of each of (A1', AX1', AY1', AXY1')-B1 and (A3', AX3', AY3', AXY3')-C1 were contacted with each other so that the projection axis of [001] axis of B and C was coincident with the rolling direction of A', AX', AY', AXY', which was annealed at a surface activated state under a superhigh vacuum (10⁻¹⁰ Torr) (1·33 × 10⁻⁸ Pa). After the ion sputtering, the mirrored surfaces of each of (A2', AX2', AY2', AXY2')-B2 and (A4', AX4', AY4', AXY4')-C2 were contacted with each other at a surface inactive state in a suitable N₂ atmosphere and then annealed in the N₂ atmosphere. In this case, the annealing was carried out at 850°C for 50 hours followed by purification annealing at 1180°C in H₂ for 5 hours.

As a result, crystal grain boundary was formed at the joint face in (A2', AX2', AY2', AXY2')-B2 and in (A4', AX4', AY4', AXY4')-C2 to obtain crystal bodies in which the orientation of A' AX' AY', AXY' was different from that of each of B, C. On the contrary, no grain boundary was observed at the joint face in (A1', AX1', AY1', AXY1')-B1 and in (A3', AX3', AY3', AXY3')-C1, so that the resulting joined body was a single crystal body in which the orientation of A1', AX1', AY1', AXY1' was same as in B1 and the orientation of A3', AX3', AY3', AXY3' was same as in C1 when measuring the crystalline orientation around the joint face. Thus, the single crystal (nucleus of Goss grain) grew into a matrix, without changing orientation, by contacting and heating while controlling the atmosphere so as to not form an impurity film at the joint face.

Moreover, Table 1-2 shows the measured magnetic properties of each joined body after the application of a tension coating.

**Table 1-2**

| | B₁₀ (T) | W_{17/50} (W/kg) |
|---|---|---|
| A1' - B1 | 2.011 | 0.91 |
| A2' - B2 | 1.75 | - |
| A3' - C1 | 2.018 | 1.46 |
| A4' - C2 | 1.69 | - |
| AX1' - B1 | 2.012 | 0.89 |
| AX2' - B2 | 1.78 | - |
| AX3' - C1 | 2.021 | 1.44 |
| AX4' - C2 | 1.71 | - |
| AY1' - B1 | 2.011 | 0.92 |
| AY2' - B2 | 1.73 | - |
| AY3' - C1 | 2.019 | 1.47 |
| AY4' - C2 | 1.80 | - |
| AXY1' - B1 | 2.010 | 0.90 |
| AXY2' - B2 | 1.82 | - |
| AXY3' - C1 | 2.015 | 1.45 |
| AXY4' - C2 | 1.75 | - |

As seen from Tables 1-1 and 1-2 the magnetic properties, even in the case when no annealing and cold rolling (A) were conducted, or in the case when only annealing (AX) or cold rolling (AY) was conducted, are approximately equal to those in the case when both annealing and cold rolling (AXY) are conducted irrespectively of the presence or absence of primary recrystallization annealing after hot rolling.

Even when equivalent single crystal bodies are obtained, the iron loss properties are considerably improved in the case of intentionally shifting the {110} face of the seed material from the rolling face as compared with the case of coinciding them.

In order to reduce the cost for industrial production, a suitable inert gas (N₂ or Ar) atmosphere is advantageous rather than having a vacuum as the atmosphere during heating. Industrial production may be effected by interposing a low melting point metal between contacting faces in the joint as mentioned below.

### Experiment 2-3

Each of the above raw materials AXY', B and C was subjected to a plate surface treatment of each of
i) pickling with hydrochloric acid;
ii) grinding;
iii) Emery polishing;
iv) chemical polishing;
v) chemical polishing + ion etching
and then the treated surface was subjected to Sn plating at a thickness of 0.5 »m. Then, the Sn plated surfaces were contacted with each other as a set of AXY' and B, or AXY' and C, and annealed in N₂ atmosphere at 850°C for 50 hours by varying the strain vertically applied to the contacted surface for every plate surface treating condition and further annealed at 1180°C in H₂ for 5 hours. Thereafter the presence (X) or absence (○) of a crystal grain boundary at the joint interface was observed.

The results are shown in Fig. 2, from which it can be seen that the pickling treatment with hydrochloric acid made the roughness large and caused many impurities to be retained on the surface thus requiring a strong applied load to remove the crystal grain boundary, while in the case of chemical polishing + ion etching the surface was made smooth and the number of impurities was reduced enabling the crystal grain boundary to be removed without the application of a load.

The magnetic properties at an applied load of 10 g/mm² are shown in Table 1-3.

**Table 1-3**

| | Treatment for joint face | Applied load 10 g/mm² | |
|---|---|---|---|
| | | B₁₀ (T) | W_{17/50} (W/kg) |
| AXY'-B | pickling with hydrochloric acid | 1.790 | - |
| | grinding | 1.810 | - |
| | Emery polishing | 2.005 | 0.83 |
| | chemical polishing | 2.010 | 0.80 |
| | chemical polishing + ion etching | 2.007 | 0.82 |
| AXY'-C | pickling with hydrochloric acid | 1.780 | - |
| | grinding | 1.790 | - |
| | Emery polishing | 2.010 | 1.42 |
| | chemical polishing | 2.015 | 1.35 |
| | chemical polishing + ion etching | 2.012 | 1.37 |

As seen from Table 1-3, even when the insert member is interposed, improved iron loss properties were obtained by intentionally shifting the {110} face of the seed material from the rolling face.

Although the case of using AXY' as a treating material has been mainly described in Experiment 2-3, it has been confirmed that similar results are obtained even when the raw materials A, AX, AY, AXY, A', AX', AY' are used as the treating material.

The reason why the crystal grain boundary is removed by interposing Sn film having a melting point as low as 232°C is considered to be due to the same reason described in Experiment 1 above.

From the above experiments, it has been found that grain oriented silicon steel sheets having a predetermined orientation can easily be produced by contacting and heating when having an activated surface state or in the presence of the low melting point metal.

Moreover, it has been found that the growth of a nucleus planted when the amount of C in the starting material is less is particularly good in the experiments on the low temperature joining technique as mentioned above.

In this connection, the inventors made further studies and found that when conducting the cold rolling, if the C amount in steel before the cold rolling is reduced to not more than 0.010%, the occurrence of nuclei other than the nucleus planted in the low temperature joining is effectively suppressed to and the desired orientation grows over the whole of the steel sheet.

### Experiment 2-4

A slab of steel comprising C: 0.080%, Si: 3.30%, Mn: 0.070%, S: 0.020%, sol Al: 0.025%, N: 0.0080%, with the balance being Fe and inevitable impurities, was heated at 1350°C and hot rolled to a thickness of 1.15 mm. Then, the hot rolled sheet was subjected to an annealing;
(A) at 1120°C in N₂ for 2 minutes,
(B) at 1120°C in N₂ for 2 minutes + at 725°C in wet hydrogen for 3 hours.

In this case, the amount of C in the annealed steel sheet was (A) 0.070% and (B) 0.005%. Thereafter, the sheet was cold rolled to a thickness of 0.20 mm and subjected to decarburization and primary recrystallization annealing at 820°C in a wet hydrogen for 5 minutes, from which a plate having length: 300 mm and width: 500 mm was cut out as a raw material D, E.

Furthermore, a plate having length: 300 mm and width: 500 mm was cut out from the cold rolled sheet of the raw material (B) as a raw material F.

A single crystal plate comprising Si: 3.0%, with the balance being substantially Fe, and having thickness: 0.20 mm, length: 300 mm, width: 5 mm, α=0° and β=2.5° was provided as a raw material G.

A section of each of D, E and F parallel with the rolling direction and perpendicular to the rolling face, and a face of G perpendicular to the plate face, were subjected to Emery polishing to render them into a mirror face of Ra<0.1 »m. After Sn film of 0.5 »m thickness was formed on each polished face by plating, the plated face of each of D, E, F was closely joined with the plated face of G while applying a compressive load of 10 g/mm² (0·098 MPa) to the joint face, which was fed into a temperature tilting furnace having a temperature gradient of 5°C/cm between 1150∼850°C at a feed rate of 10 mm/h while holding G at the high temperature side.

Then, MgO was applied to D, E, F, as a separator which were subjected to purification annealing at 1200°C in H₂ for 20 hours. Thereafter the magnetic properties were measured at five positions from side G to obtain the results shown in Table 1-4.

**Table 1-4**

| Position from G | D | | E (Invention) | | F (Invention) | |
|---|---|---|---|---|---|---|
| | B₁₀ (T) | W_{17/50} (W/kg) | B₁₀ (T) | W_{17/50} (W/kg) | B₁₀ (T) | W_{17/50} (W/kg) |
| 1 | 1.99 | 0.80 | 2.00 | 0.79 | 1.99 | 0.80 |
| 2 | 2.01 | 0.79 | 1.99 | 0.80 | 1.99 | 0.80 |
| 3 | 1.97 | 0.83 | 2.01 | 0.78 | 2.00 | 0.80 |
| 4 | 1.95 | 0.88 | 2.00 | 0.78 | 2.00 | 0.79 |
| 5 | 1.93 | 0.95 | 1.99 | 0.81 | 2.01 | 0.78 |

As seen from the above table, in E, F which were decarburized before the cold rolling, the magnetic properties are not degraded even away from the joint portion with the seed material G. This is because no nucleus which has a shifted orientation nucleus is formed during the course of the seed material G growing in other secondary recrystallized grains in the decarburized raw materials E, F as compared with the raw material D. The reason for the occurrence of such a phenomenon is considered to be due to the fact that the formation of a so-called deformation band is suppressed by conducting decarburization before cold rolling in order to reduce the nucleus of secondary grains.

The method of the invention is described below in the order of the production steps.

The starting material according to the invention preferably may be raw material comprising any of; C: not more than 1.0%, Si: 0.1∼7.0% and Mn: 0.002∼1.5% as a main component and containing at least one of; P: 0.010∼0.050%, S: 0.005∼0.05%, Se: 0.005∼0.05%, Te: 0.003∼0.03%, Sb: 0.005∼0.100%, Sn: 0.03∼0.5%, Cu: 0.02∼0.3%, Mo: 0.005∼0.05%, B: 0.0003∼0.0040%, N: 0.001∼0.02%, Al: 0.005∼0.10%, Ti: 0.001∼0.05%, V: 0.001∼0.05%, Cr: 0.05∼0.5% and Nb: 0.001∼0.05% as an inhibitor forming component.

These raw materials are made by conventional well-known steel-making methods, such as steel-making in a convertor or electric furnace, and are further shaped into a slab or a sheet bar by the ingot blooming method, continuous casting method or roll rapid quenching method or the like, or into this steel sheet directly.

In general, the heating is carried out at a temperature of not lower than 1350°C to completely dissolve the inhibitor component into the slab. In the invention, it is not particularly necessary to conduct the slab heating treatment at a high temperature above 1350°C as mentioned above, and it is enough to conduct low-temperature slab heating treatment below about 1250°C, as in the ordinary steel because the crystalline orientation of the steel sheet is fully dependent upon the seed material in the invention. Hence, it is sufficient to strictly control only the orientation of the seed material into a desirable orientation and it is not necessary to make the inhibitor as strong as possible in order to align the orientation of the nucleus. Further, the orientation of the steel sheet used as the treating material need not be strictly controlled, and hence it is not necessary to completely dissolve the inhibitor component into the steel at the slab heating stage.

In the invention, therefore, not only is an energy-saving attained but also no abnormal coarsening of the crystal structure is caused, which arises as a result of high-temperature slab heating. Thus, a uniform fine crystal structure is obtained by the low-temperature slab heating.

Thereafter, silicon-containing steel sheets are obtained by hot rolling. Then, the sheet is treated without annealing and cold rolling, or subjected to annealing (normalized annealing or intermediate annealing) and/or cold rolling at least once. Immediately thereafter or after primary recrystallization annealing, the sheet is subjected to finish annealing. In this case, the normalized annealing or intermediate annealing is intended as a recrystallization treatment and decarburization treatment for homogenizing the crystal structure after the rolling, and is usually carried out at 700∼1200°C for 30 seconds ∼ 10 minutes. In the present invention, it is preferable that the amount of C in the steel before the final cold rolling is reduced to not more than 0·010%, even in the case of conducting cold rolling when the amount of C in the starting material exceeds 0.01%, by adjusting the oxygen potential in the atmosphere or the annealing time such that the normalized annealing or intermediate annealing is decarburization annealing. Because, by reducing the amount of C in the steel before the final cold rolling to not more than 0.010%, the planted secondary recrystallized nucleus is stably grown over the whole of the steel sheet as previously mentioned.

The reason why the amount of C in the steel before the final cold rolling is limited to not more than 0.010% is due to the fact that when the C amount exceeds the above value, the formation of the so-called deformation band becomes active and the frequency of occurrence of α, β shifted nuclei in the primary grains forming the secondary grains increases thereby allowing easy generation and large growth of α, β shifted secondary grains.

Then, primary recrystallization annealing is carried out, if necessary. In primary recrystallization annealing, slow heating at a rate of, for example, about 20°C/h over a long time is preferable for completing the primary recrystallization (∼700°C), or a treatment in which the temperature is maintained at 550°C for about 24 hours, is preferable not only for fine homogenization and stabilization of the inhibitor but also to reduce the (110) component and increase the (111) component. Thereafter, annealing is carried such that the oxygen potential of the atmosphere, temperature and time depend on the amount of C. For example, an atmosphere of wet hydrogen and a temperature of 700∼900°C for about 1∼15 minutes may be used, whereby the C in the steel is removed and also a primary recrystallization texture suitable for developing secondary recrystallized grains of Goss orientation in the subsequent annealing is formed.

Thereafter, the sheet is subjected to secondary recrystallization annealing at 800∼1100°C for about 1∼50 hours and further to purification annealing at 1100∼1250°C for about 5∼25 hours. According to the invention, a seed material having an orientation is joined, after hot rolling and before finish annealing, to an edge portion of the steel sheet in order to control the orientation of the seed material so that:$\begin{matrix}\begin{matrix}\text{|α| ≦ 5°} \\ \text{1 ≦ |β| ≦ 5°}\end{matrix}\end{matrix}$ where
- α:: angle defined by a projection line of the 〈001〉 axis of the seed material with respect to the rolling face of the steel sheet and the rolling direction of the steel sheet;
- β:: inclination angle of the 〈001〉 axis of the seed material with respect to the rolling face of the steel sheet.

The reason why the orientations of the seed material and the steel sheet are limited to |α|≦5° and |β|=1°∼5° is because when |α| exceeds 5°, the degradation of the B₁₀ value becomes excessive and the expected improvement of magnetic properties cannot be obtained.

With regard to β, when |β|<1° the width of the magnetic domain becomes excessively large causing degradation of the iron loss, while when |β|>5°, the B₁₀ value is degraded and hence the iron loss is also degraded.

In the above joint, it is important to contact the joint faces when in an activated state or to interpose an insert member having a low melting point between the joint faces.

The reason for the above is same as described in the above Experiment 1.

After the seed material and the treating material are contacted with each other when in an activated state or joined through interposition of the insert member, they are heated to a temperature which causes grain boundary movement.

The term "temperature which causes grain boundary movement" used herein means the temperature required to rearrange the crystal structure into a new crystal structure; generally it is not lower than the recrystallization temperature.

In such heat treatment, it is important that the steel sheet used as the treating material is in an energy state higher than that of the seed material because the seed material cannot grow when the energy state of the seed material is equal to or lower than that of the steel sheet.

The term "energy state" used herein is concerned with inner strain and surface as previously mentioned, and is mainly dependent upon the quantities and masses of the crystal grain boundary, dislocation, point defect and surface energy of crystal. As these quantities increase, the energy state becomes higher. Moreover, the seed materials used in some of the embodiments of the present invention are mainly single crystals having an aligned orientation, while the steel sheets used as the treating material are not only polycrystalline bodies but also contain a relatively large amount of dislocation or the like. Therefore, the energy state in the steel sheet is generally higher than that of the seed material, so that it is not usually necessary to perform special treatment to adjust the energy state. According to circumstances, for example, when the primary grain size is excessively large, it is advantageous to conduct treatment to introduce strain or the like. Furthermore, in order to hold the high energy state constant during annealing, it is necessary to maintain the primary grain size constant. For this purpose, it is effective to add at least one of N, S, Se, Te and compounds thereof to the separator in addition to the inhibitor originally contained in the steel sheet.

The temperature depends on the matrix and the production step, i.e., the energy state of the treating material or the like, but it is usually 650∼1200°C, preferably 800∼1150°C.

Furthermore, the heating system and the treating atmosphere are the same as described in Experiment 1.

Moreover, in the invention, when the joining treatment of the seed material is just before the finish annealing, the subsequent heating treatment may be the finish annealing.

Also, when raw material containing a relatively large amount of C is used and the decarburization treatment is not carried out before finish annealing, it is preferable that the annealing atmosphere is adjusted so as to have a decarburizing property by using MgO containing saturated crystal water or the like as a main component of the annealing separator in the subsequent secondary recrystallization annealing, whereby decarburization is carried out before the growth of secondary grains.

In addition, according to the invention, the magnetic properties can be further improved by applying a tension-type thin coating to the surface of the steel sheet after purification annealing in a well-known manner, or by introducing strain into the steel sheet to refine the magnetic domains.

### Experiment 3-1

A slab of steel comprising; C: 0.042%, Si: 3.40%, Mn: 0.035%, Se: 0.012%, Sb: 0.020%, Al: 0.025%, N: 0.0085%, with the balance being substantially Fe, was heated at 1300°C for 1 hour, hot rolled to a thickness of 2.3 mm, and then subjected to a cold rolling twice, wherein the first cold rolling was made in a direction parallel to the hot rolling direction at a reduction of 70% and the second cold rolling was made in a direction perpendicular thereto at a reduction of 57%, to obtain a cold rolled sheet having a final thickness of 0.30 mm. From the thus obtained cold rolled sheet were cut out four plates having length: 300 mm and width: 35 mm as raw materials A1, A2, whose longitudinal direction were the same as in the first rolling direction, and raw materials A3, A4, whose longitudinal direction were the same as in the second rolling direction.

Four single crystal plates having the same chemical composition as in the above cold rolled sheet and thickness: 0.30 mm, length: 280 mm, width: 5 mm and a plate face of (100) were provided as raw materials B1, B2, B3, B4.

Then, a section parallel to the longitudinal direction and perpendicular to the rolling face in each of A1∼A4, and the (110) face perpendicular to the plate face in each of B1, B2, B3, B4 were subjected to Emery polishing, buff polishing and float polishing to render them into a mirror state having a center-line average roughness Ra of not more than 10 nm. Thereafter, four sets of pairs of A and B were prepared to obtain A1-B1, A2-B2, A3-B3, A4-B4. After each polished surface of A and B had been subjected to ion sputtering with Ar under high vacuum (10⁻⁶ Torr) (1·33 × 10⁻⁴ Pa), the mirrored faces of each of A1-B1 and A3-B3 were contacted with each other so that the [001] axis of B was coincident with the rolling direction of A, which was heated in a surface activated state under a superhigh vacuum (10⁻¹⁰ Torr) (1·33 × 10⁻⁸ Pa). The mirrored surfaces of each of A2-B2 and A4-B4, after ion sputtering, were contacted with each other in a surface inactive state in a suitable N₂ atmosphere and then heated in the N₂ atmosphere. In both cases, heating was carried out from 200°C at a rate of temperature increase of 20°C/h and annealing at 970°C for 50 hours. Thereafter, they were subjected to purification annealing at 1180°C in H₂ for 5 hours.

As a result, a crystal grain boundary was formed at the joint face in A2-B2 and in A4-B4 to obtain crystal bodies in which the orientations between A2 and B2 and between A4 and B4 were different from each other. On the contrary, no grain boundary was observed at the joint face in A1-B1 and in A3-B3, so that the resulting joined body was a single crystal body in which the orientation of A1 and A3 was the same as in B1 and B3, repectively, when measuring the crystalline orientation around the joint face. Thus, the single crystal (nucleus of Goss grain) grew into a matrix, without changing orientation, by contacting and heating while controlling the atmosphere so as to not form an impurity film at the joint face.

Table 2-1 shows the measured magnetic properties of each joined body in the longitudinal direction.

**Table 2-1**

| | B₁₀ (T) | W_{17/50} (W/kg) | Remarks |
|---|---|---|---|
| A1-B1 | 2.018 | 1.43 | invention |
| A2-B2 | 1.38 | - | - |
| A3-B3 | 2.019 | 1.45 | invention |
| A4-B4 | 1.41 | - | - |

### Experiment 3-2

Four square plates cut out in the same manner as in Experiment 3-1 were heated from 200°C to 700°C at a rate of temperature increase of 20°C/h and then subjected to decarburization and primary recrystallization annealing at 820°C in a wet hydrogen for 3 minutes. The raw materials having the same longitudinal direction as in the first rolling direction were A1' and A2' and the raw materials having the same longitudinal direction as in the second rolling direction were A3', A4'.

Four single crystal plates having the same chemical composition as in the above cold rolled sheet and thickness: 0.30 mm, length: 280 mm, width: 5 mm and a plate face of (100) were provided as raw materials B1', B2', B3', B4'.

Then, a section parallel with the longitudinal direction and perpendicular to the rolling face in each of A1'∼A4', and the (100) face perpendicular to plate face in each of B1', B2', B3', B4', were subjected to Emery polishing, buff polishing and float polishing to render them into a mirror state having a center-line average roughness Ra of not more than 10 nm. Thereafter, four sets of pairs of A' and B' were prepared to obtain A1'-B1', A2'-B2', A3'-B3', A4'-B4'. After each polished surface of A' and B' had been subjected to ion sputtering with Ar under high vacuum (10⁻⁶ Torr) (1·33 × 10⁻⁴ Pa), the mirrored faces of each of A1'-B1' and A3'-B3' were contacted with each other so that the [001] axis of B' was coincident with the rolling direction of A', which was annealed at a surface activated state under a superhigh vacuum (10⁻¹⁰ Torr) (1·33 × 10⁻⁸ Pa). The mirrored surfaces of each of A2'-B2' and A4'-B4', after ion sputtering, were contacted with each other in a surface inactive state in a suitable N₂ atmosphere and annealed in the N₂ atmosphere. In this case, the annealing was carried out at 970°C for 50 hours followed by purification annealing at 1180°C in H₂ for 5 hours.

As a result, a crystal grain boundary was formed at the joint face in A2'-B2' and in A4'-B4', as in Experiment 3-1, to obtain crystal bodies in which the orientations between A2' and B2' and between A4' and B4' were different from each other. On the contrary, no grain boundary was observed at the joint face in A1'-B1' and in A3'-B3', so that the resulting joined body was a single crystal body in which the orientation of A1' and A3' was the same as in B1' and B3', respectively, when measuring the crystalline orientation around the joint face.

Table 2-2 shows the measured magnetic properties of each joined body in the longitudinal direction.

**Table 2-2**

| | B₁₀ (T) | W_{17/50} (W/kg) | Remarks |
|---|---|---|---|
| A1'-B1' | 2.015 | 1.42 | invention |
| A2'-B2' | 1.35 | - | - |
| A3'-B3' | 2.020 | 1.41 | invention |
| A4'-B4' | 1.30 | - | - |

### Experiment 3-3

A steel slab having the same chemical composition as in Experiment 3-1 was hot rolled to a thickness of 2.3 mm in the same manner, subjected to normalized annealing at 1020°C for 3 minutes and cold rolled in the same manner as in Experiment 3-1. Four square plates having length: 300 mm and width: 35 mm were then cut out as raw materials A1'', A2'' having a longitudinal direction the same as in the first rolling direction, and raw materials A3'', A4'' having a longitudinal direction the same as in the second rolling direction. Thereafter, they were subjected to decarburization and primary recrystallization annealing at 820°C for 3 minutes.

Four single crystal plates having the same chemical composition as in the above cold rolled sheet and thickness: 0.30 mm, length: 280 mm, width: 5 mm and a plate face of (100) were provided as raw materials B1'', B2'', B3'', B4''.

Then, a section parallel to the longitudinal direction and perpendicular to the rolling face in each of A1''∼A4'', as well as the (100) face perpendicular to plate face in each of B1'', B2'', B3'', B4'', were subjected to Emery polishing, buff polishing and float polishing to render them in to a mirror state having a center-line average roughness Ra of not more than 10 nm. Thereafter, four sets of pairs of A'' and B'' were prepared to obtain A1''-B1'', A2''-B2'', A3''-B3'', A4''-B4''. After each polished surface of A'', B'' had been subjected to ion sputtering with Ar under high vacuum (10⁻⁶ torr) (1·33 × 10⁻⁴ Pa), the mirrored faces of each of A1''-B1'' and A3''-B3'' were contacted with each other so that the [001] axis of B'' was coincident with the rolling direction of A'', which was annealed in a surface activated state under a superhigh vacuum (10⁻¹⁰ Torr) (1·33 × 10⁻⁸ Pa). The mirrored surfaces of each of A2''-B2'' and A4''-B4'', after ion sputtering, were contacted with each other in a surface inactive state in a suitable N₂ atmosphere and annealed in the N₂ atmosphere. In both cases, annealing was carried out at 970°C for 50 hours followed by purification annealing at 1180°C in H₂ for 5 hours.

As a result, a crystal grain boundary was formed at the joint face in A2''-B2'' and in A4''-B4'', as in Experiment 3-1, to obtain crystal bodies in which the orientations between A2'' and B2'' and between A4'' and B4'' were different from each other. On the contrary, no grain boundary was observed at the joint face in A1''-B1'' and in A3''-B3'', so that the resulting joined body was a single crystal body in which the orientation of A1'' and A3'' was same as in B1'' and B3'', respectively, when measuring the crystalline orientation around the joint face.

Table 2-3 shows the measured magnetic properties of each joined body in the longitudinal direction.

**Table 2-3**

| | B₁₀ (T) | W_{17/50} (W/kg) | Remarks |
|---|---|---|---|
| A1''-B1'' | 2.005 | 1.40 | Invention |
| A2''-B2'' | 1.83 | - | - |
| A3''-B3'' | 2.010 | 1.38 | Invention |
| A4''-B4'' | 1.57 | - | - |

Thus, according to the above embodiments of the present invention, very good magnetic properties were obtained in any direction crossing the rolling face. The strong effect of suppressing the grain growth is obtained through the reduction of the (110) component of the treating material and the uniform fine division and stabilization of the inhibitor when the primary recrystallisation after cold uses gradual heating and annealing. Thus, the growth of the seed material is facilitated and hence excellent magnetic properties result.

Moreover, in order to advantageously facilitate industrial production by further reducing the cost, the atmosphere in the heating is preferably an inert gas (N₂ or Ar) atmosphere rather a vacuum as described in the above production method of grain oriented silicon steel sheets. Industrial production may be effected by the interposition of a low melting point substance between the joint faces as mentioned above.

### Experiment 3-4

Each of the above raw materials A1, A3 and B1, B3 was subjected to a plate surface treatment of:
i) pickling with hydrochloric acid;
ii) grinding;
iii) Emery polishing;
iv) chemical polishing;
v) chemical polishing + ion etching
and then the treated surface was subjected to Sn plating at a thickness of 0.5 »m. Then, the Sn plated surfaces were contacted with each other as a set of A1 and B1, or A3 and B3, and heated in a N₂ atmosphere from 200°C at a rate of temperature increase of 20°C/h and the strain vertically applied to the contacted surface was varied for every plate surface treating condition. The above sets were further annealed at 970°C for 50 hours and at 1180°C in H₂ for 5 hours, and thereafter the presence (X) or absence (○) of a crystal grain boundary at the joint interface was observed.

The results are shown in Fig. 2, from which it can be seen that the pickling treatment with hydrochloric acid made the roughness large and caused many impurities to be retained on the surface thus requiring a strong applied load to remove the crystal grain boundary, while in the case of chemical polishing + ion etching the surface was made smooth and the number of impurities was reduced enabling the crystal grain boundary to be removed without the application of a load.

The results measured on the magnetic properties at an applied load of 10 g/mm² (0·098 MPa) are shown in Table 2-4.

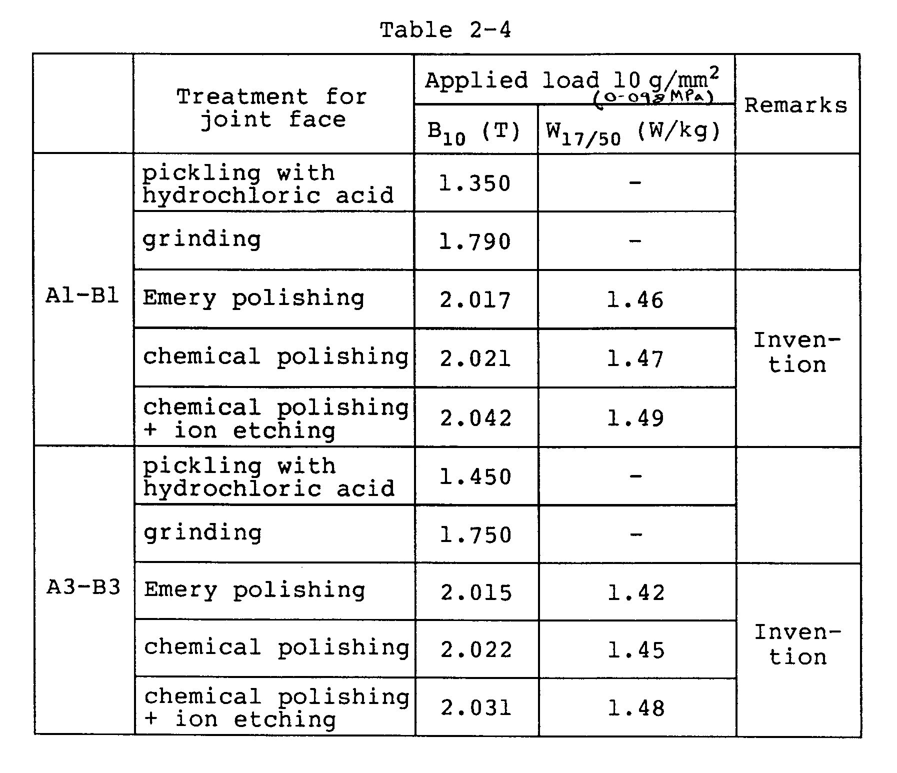

### Experiment 3-5

Each of the raw materials A1', A3' and B1', B3', and A1'', A3'' and B1'', B3'', subjected to the decarburization and primary recrystallization annealing before finish annealing was subjected to the plate surface treatment and the plating treatment in the same manner as in Experiment 2-1. Then, the plated surfaces were contacted with each other as a set of A1' and B1', A3' and B3', A1'' and B1'' or A3'' and B3'' and annealed in a N₂ atmosphere at 970°C for 50 hours and further at 1180°C in H₂ for 5 hours. Thereafter, the presence (X) or absence (○) of a crystal grain boundary at the joint interface was observed. The results obtained were approximately similar to the case shown in Fig. 2. The measured magnetic properties at an applied load of 10 g/mm² (0·098 MPa) are shown in Table 2-5.

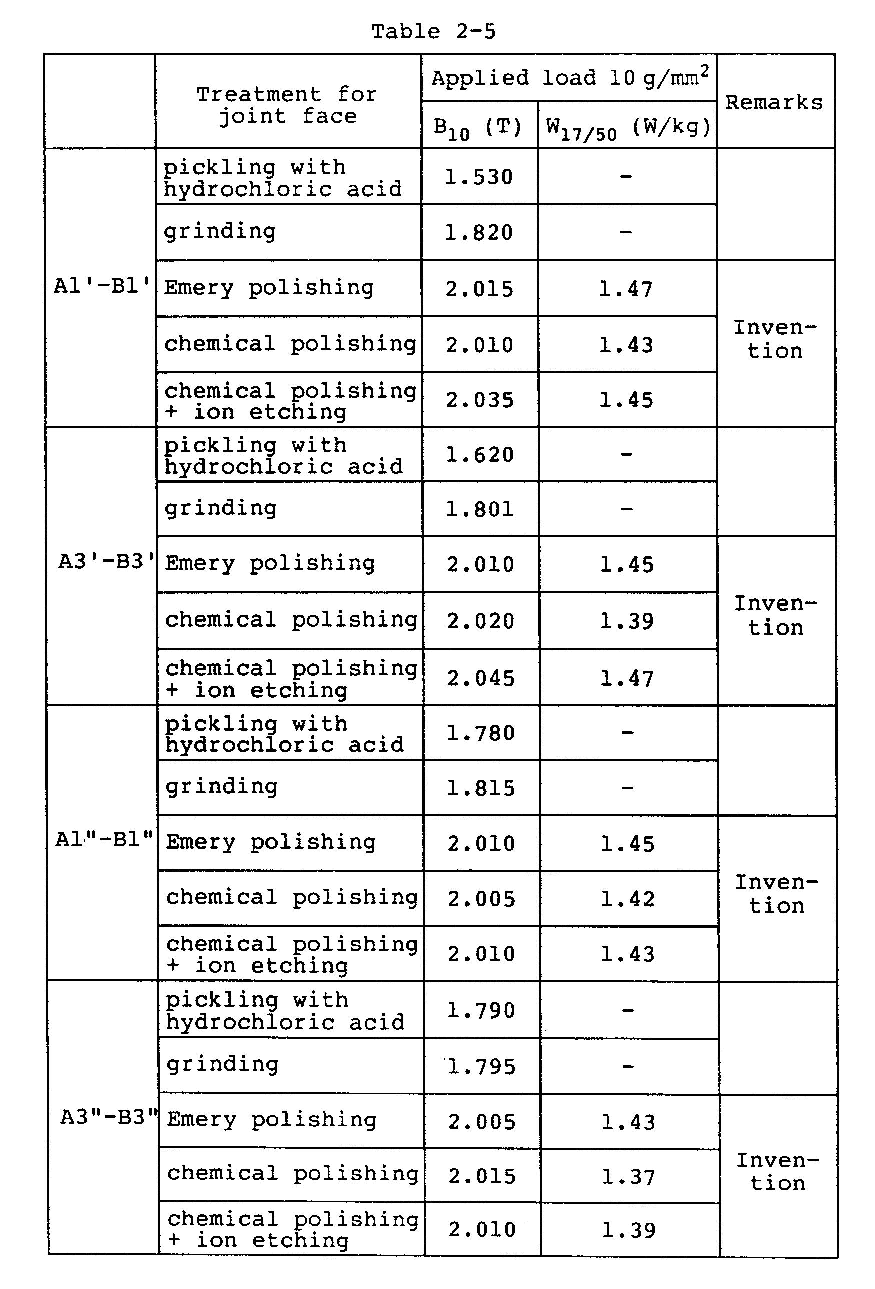

Thus, according to the above embodiments of the present invention, very good magnetic properties were obtained in any direction crossing the rolling face even in the practicable atmosphere.

The reason why the crystal grain boundary is removed by interposing the Sn film having a melting point as low as 232°C is considered to be the same as described in Experiment 1.

From the above experimental results, it has been found that bidirectional oriented silicon steel sheets can be easily produced by heating in the activated state or by the interposition of a low melting point metal.

These invention methods are described in the order of the production steps.

The starting material according to the invention is substantially the same as used for the grain oriented silicon steel sheet, and preferably may be raw material comprising any of; C: 0.005∼1.0%, Si: 0.1∼7.0% and Mn: 0.002∼1.5% as a main component and containing at least one of S: 0.005∼0.05%, Se: 0.005∼0.05%, Te: 0.003∼0.03%, Sb: 0.005∼0.100%, Sn: 0.03∼0.5%, Cu: 0.02∼0.3%, Mo: 0.005∼0.05%, B: 0.0003∼0.0040%, N: 0.001∼0.02%, Al: 0.005∼0.10%, Ti: 0.001∼0.05%, V: 0.001∼0.05% and Nb: 0.001∼0.05% as an inhibitor forming component.

These raw materials are made by the conventional well-known steel-making methods, such as steel-making in a convertor or electric furnace, and are further shaped into a slab or a sheet bar by the ingot blooming method, continuous casting method or roll rapid quenching method or the like, or into thin steel sheet directly. Thereafter, hot rolling, warm or cold rolling is carried out to form a silicon-containing steel sheet, if necessary. Then, the desired thickness is obtained by normalized annealing or one or more further cold rolling steps including intermediate annealing, if necessary. It is effective to conduct the cold rolling by crossing the rolling direction as disclosed in Japanese Patent Application Publication No. 35-2657.

It is easy and economical in industry if the first cold rolling is carried out in the same direction as in the hot rolling direction and then the steel sheet is cut into a constant length and subjected to the second cold rolling in a direction perpendicular thereto. Alternatively, after cutting into a constant length, the sheets are welded to form a strip which is continuously subjected to cold rolling. Moreover, normalized annealing or intermediate annealing is intended as a recrystallization treatment and decarburization treatment for homogenizing the crystal structure after rolling, and is usually carried out at 700∼1200°C for 30 seconds ∼ 10 minutes. In the present invention, it is preferable that the amount of C in the steel before the final cold rolling is reduced to not more than 0·010% even in the case of conducting cold rolling when the amount of C in the starting material exceeds 0.01%, by adjusting the oxygen potential in the atmosphere or the annealing time such that the normalized annealing or intermediate annealing is decarburization annealing. The reason is the same as that described in the production of the grain oriented silicon steel sheet.

Then, primary recrystallization annealing is carried out, if necessary. In primary recrystallization annealing, slow heating at a rate of, for example, about 20°C/h over a long time is preferable for completing the primary recrystallization (∼700°C), or a treatment in which the temperature is maintained at 550°C for about 24 hours is preferable for not only for fine homogenization and stabilization of inhibitor but also to reduce the (110) component and increase the (111) component. The annealing is carried out such that the oxygen potential of the atmosphere, temperature and time depend on the amount of C. For example, in an atmosphere of wet hydrogen and a temperature of 700∼900°C for about 1∼15 minutes may be used, whereby the C in the steel is removed and also a primary recrystallization texture suitable for developing secondary recrystallized grains of Goss orientation in the subsequent annealing is formed.

Thereafter, the sheet is subjected to secondary recrystallization annealing at 800∼1100°C for about 1∼50 hours and further to purification annealing at 1100∼1250°C for about 5∼25 hours. According to the invention, a seed material having an orientation is joined to an edge portion of the steel sheet in order to control the orientation of the seed material so that:$\begin{matrix}\begin{matrix}\text{|α| ≦ 10°} \\ \text{|β| ≦ 10°}\end{matrix}\end{matrix}$ where
- α:: angle defined by a projection line of the 〈001〉 axis of the seed material with respect to the rolling face of the steel sheet and the rolling direction of the steel sheet;
- β:: inclination angle of the {100} face of the seed material with respect to the rolling face of the steel sheet

after hot rolling and before purification annealing.

The reason why α and β are limited to |α|, |β|≦10° is because when |α|, |β| exceed 10°, the degradation of the B₁₀ value becomes excessive and the desired magnetic properties are not obtained.

In the above joint, it is important to contact the joint faces when in an activated state or to interpose an insert member having a low melting point between the joint faces.

The reason for the above is the same as described in the above Experiment 1.

After the seed material and the treating material are contacted with each other when in the activated state or joined through interposition of the insert member, they are heated to a temperature which causes grain boundary movement as in the aforementioned case for producing grain oriented silicon steel sheet.

Moreover, the heating conditions and the heating atmosphere may be the same as in the production of grain oriented silicon steel sheet.

In addition, the magnetic properties can be further improved by applying a tension-type thin coating to the surface of the steel sheet after purification annealing in a well-known manner, or by introducing strain into the steel sheet to refine the magnetic domains.

### Experiment 4

As mentioned in Experiments 1∼3, it has been found that substances having a given orientation can easily be produced by heating while holding the steel in an activated state or by the interposition of the low melting point metal. In order to promote mass production on an industrial scale, however, it is advantageous to perform the heating when the steel sheet is in a coiled state.

The embodiments described herein advantageously realize the heating treatment at such a coiled state.

The most preferable method of planting a seed material onto the coiled steel sheet is to ensure that the curvature of the steel sheet coincides with curvature of the seed material in the joint. Thus, a plate-like seed material of given shape is joined to the rolling face of the steel sheet and coiled, or a coiled steel sheet and a coiled seed material having the same curvature as the sheet are piled one upon the other and then joined. However, joining the seed material to the elongated steel sheet over the full length thereof prior to the coiling requires a complicated and time-consuming treating step. In addition, the joint between the edges of the coils suffers the problem that control of the orientation is difficult.

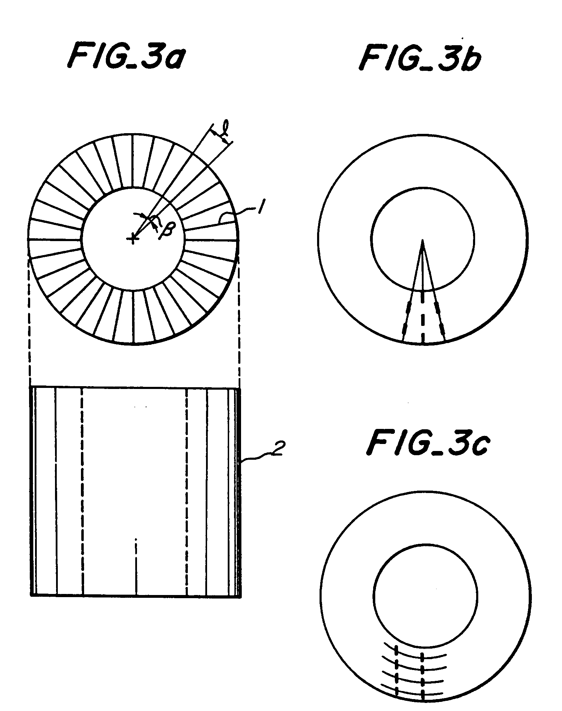

However, this problem can be solved by radially arranging an orientation controlled strip-like seed material onto an edge portion of the coil and joining them as shown in Fig. 3a. In Fig. 3a, the distance between the seed materials to be planted in the circumferential direction is ℓ, and the angle corresponding to ℓ when the seed material grows to ℓ is β. Here, β shows the shift of the seed material, which has an orientation in a tangential direction to the coil, from the rolling face of the steel sheet when the seed material or crystal grain grown from the seed material is displaced by distance ℓ in the circumferential direction. Thus, the orientation of the seed material shifts by β from the rolling face of the steel sheet when the seed material grows by amount ℓ.

Since curvature is existent in the steel sheet when in such a coiled state, the shifting of the orientation from the rolling face of the steel sheet is unavoidable at the stage of the crystal growth even if the orientation of the strip-like seed material is strictly controlled. In this regard, the shifting can be mitigated to an extent that it causes no problem by shortening the planting distance of the seed material in the circumferential direction.

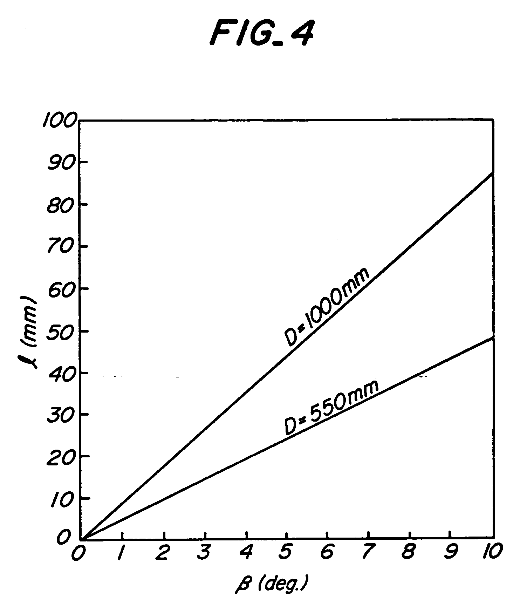

Fig. 4 shows the relationship between ℓ and β in the outermost coil and the innermost coil when the outer diameter is 1000 mm and the inner diameter is 550 mm. The shorter the planting distance of the seed material or the larger the coil diameter or the smaller the curvature, the smaller the shift (β) of the orientation of the coiled body from the seed material. However, the enlargement of the coil diameter is critical, so that it is preferable to shorten the planting distance of the seed material in order to suppress the shifting of the orientation.

In case of a coil having an inner diameter of 550 mm, assuming that one crystal grows from one seed material, in order to control the average shifting angle βₐᵥ of β in the longitudinal direction of the steel sheet to not more than 10° it is necessary that the crystal length of the inner coil portion in the circumferential direction is limited to not more than 100 mm; this is about 2 times the crystal length at β=10°, judging from Fig. 4. Similarly, it should be limited to not more than 180 mm in the outer coil portion having a diameter of 1000 mm. Therefore, the planting distance of the seed material must be 100 mm in order to maintain βₐᵥ ≦ 10° over the full length of the coil.

When planting the seed material, it is not necessary to extend the seed material continuously in the radial direction, and the discontinuous state may be adopted, as shown in Fig. 3b. Furthermore, as shown in Fig. 3c, it is not essential to arrange the seed material radially, and in this case it is necessary to change the orientation of the seed material depending on the position of the seed material used for holding a given orientation relationship to the coil.

Then, the method of the present invention is described in the order of the production steps.

Firstly, all the substances described in the above embodiments may be used as the treating material and the seed material.

The shape of the seed material may be coil-like as previously mentioned, but it is preferably radially arranged on a helical edge face of the coil as a strip.

In addition, the helical edge face of the coil is preferably subjected to a smoothing treatment for removing any surface unevenness or strain introduced portions. Moreover, in order to prevent the shifting between the coil-like steel sheets after the smoothening treatment, it is advantageous that the edge faces of the steel sheets opposite the given smoothed faces are joined by welding to mutually fix these steel sheets to each other prior to the smoothing treatment.

After the seed material and the treating material are contacted with each other when in an activated state or have been joined by the interposition of an insert member, they are heated to a temperature which causes grain boundary movement.

The heating conditions and the heating atmosphere may be the same as previously mentioned and will depend on the properties of the seed material and the treating material.

### BRIEF EXPLANATION OF DRAWING

Figs. 1a, b, c and d are flow sheets showing the production of a crystal body having a particular orientation according to the conventional method;
Fig. 2 is a graph showing the influence of the polished state of the surface of a joined body and the applied load upon the removal of the crystal grain boundary at the joint face;
Figs. 3a, b and c are schematic views showing the positioning of the seed material on a helical edge face of the coil according to the invention; and
Fig. 4 is a graph showing the relationship between the planting distance of the seed material and the shifting of the orientation from the rolling face using the coil diameter as a parameter.

### BEST MODE OF CARRYING OUT THE INVENTION

### Example 1

A block of Ag having a purity of 99.99% was divided into two parts A, B. Part A was annealed at 800°C under vacuum (10⁻⁶ Torr) (1·33 × 10⁻⁴ Pa) for 24 hours to make the recrystallized grains coarse. Single crystal plates of 1 mm thickness and 10 mm square were cut out from these coarse grains by electric arc method so as to make the orientation of the plate faces (100), (110), (111) in seed materials C, D and E, respectively.

Part B was rolled to obtain a sheet of 1 mm thickness, which was annealed at 300°C under vacuum (10⁻⁶ Torr) (1·33 × 10⁻⁴ Pa) for 30 minutes and 3% strain was introduced under tension to give it a high energy state as compared with the seed material. Three sheets of 10 mm square were then cut out therefrom as treating materials B₁, B₂, B₃.

The plate faces of B₁, B₂, B₃, C, D, E were finished to a mirror state of Ra≦0.01 »m by Emery polishing, buff polishing or float polishing. After the polished face had been activated by argon ion bombartment under vacuum (10⁻¹⁰ Torr) (1·33 × 10⁻⁸ Pa), the polished face of each of C, D, E was contacted with and joined to the polished face of each of B₁, B₂, B₃ under vacuum, followed by heating at 350°C for 100 hours.

In each of the thus obtained joined bodies, no border or grain boundary was observed at the joint face as measured from the sectional structure at the joint interface. Also, each of the joined materials B₁, B₂, B₃ was shown to have a crystal body having the same orientation as in each of C, D, E by the measured crystalline orientation.

### Example 2

From a block-like coarse grain comprising 3% Si, with the balance being Fe and inevitable impurities, were cut out three single crystal plates of 0.5 mm thickness and 10 mm square using the electric arc method. The plate faces had orientations (100), (110) and (111) in seed materials B, C and D, respectively.

A steel ingot comprising C: 0.002%, Mn: 0.001%, S: 0.002%, P: 0.001%, O: 0.001%, with the balance being Fe and inevitable impurities, was hot rolled to obtain a hot rolled sheet of 2 mm thickness. The hot rolled sheet was cold rolled in a direction perpendicular to the hot rolling direction to obtain a cold rolled sheet of 0.5 mm thickness. This sheet was annealed at 820°C in dry Ar for 10 minutes and 3% strain was introduced under tension to give it a high energy state as compared with the seed material. Three sheets of 10 mm square were then cut out as treating materials A₁, A₂, A₃.

Each plate face of A₁, A₂, A₃, B, C, D was then finished to a mirror surface of Ra≦0.2 »m by Emery polishing. After Sn film of 1 »m thickness had been plated onto the polished face, the plated face of each of B, C, D was closely joined to the plated face of each of A₁, A₂, A₃, followed by heating at 850°C in a dry Ar atmosphere for 24 hours while applying a compressive stress of 10 g/mm² (0·098 MPa) to the joint face.

In each of the thus obtained joined bodies, no border or grain boundary was observed at the joint face as measured from the sectional structure at the joint interface. Also, each of the joined materials A₁, A₂, A₃ was shown to have a crystal body having the same orientation as in each of B, C, D by the measured crystalline orientation.

### Example 3

From a block-like coarse grain comprising 3% Si, with the balance being Fe and inevitable impurities, were cut out three single, crystal plates of 1 mm thickness and 10 mm square using the electric arc method. The plate faces had orientations (100), (110) and (111) in seed materials B, C and D, respectively.

A steel ingot comprising Al: 2.5%, with the balance being Fe and inevitable impurities, was hot rolled to obtain a hot rolled sheet of 1 mm thickness. The hot rolled sheet was annealed at 900°C in dry Ar for 30 minutes and 2.5% tensile strain was introduced to give it a high energy state as compared with the seed material. Three sheets of 10 mm square were cut out as treating materials A₁, A₂, A₃.

Each thickness face in a section perpendicular to the plate face of A₁, A₂, A₃ in the rolling direction, in B and C in the [001] orientation and in D in the [112] orientation was finished to a mirror surface of Ra≦0.2 »m by Emery polishing. After Sn film of 1.5 »m thickness had been plated onto the polished face, the plated face of each of B, C, D was closely joined to the plated face of each of A₁, A₂, A₃, followed by heating in a temperature tilting furnace having a temperature gradient of 125°C/cm from 1150°C to 850°C. The feeding rate was 10 mm/h and joined parts A₁, A₂ and A₃ of the joined material were held at the low temperature side and joined parts B, C and D were held at the high temperature side.

In each of the thus obtained joined bodies, no border or grain boundary was observed at the joint face as measured from the plate face structure at the joint interface. Also, each of the joined A₁, A₂, A₃ was shown to have a crystal body having the same orientation as in each of B, C, D by the measured crystalline orientation.

### Example 4

An ingot of silicon steel containing C: 0.037%, Si: 3.00%, sol Al: 0.028%, N: 0.0085%, S: 0.031% was hot rolled to obtain a hot rolled sheet of 3 mm thickness. The hot rolled sheet was first cold rolled at a reduction of 30% and then annealed at 1100°C in H₂ for 5 minutes. Next, the sheet was cold rolled at a reduction of 85.7% to a final thickness of 0.3 mm, heated from 200°C to 700°C at a rate of temperature increase of 20°C/h and subjected to decarburization annealing at 800°C in a wet hydrogen atmosphere for 5 minutes. A piece having dimensions 150w × 300ℓ mm and containing a large amount of primary recrystallized grain boundary was cut out as the treating material A having high energy state.

A plate-like single crystal comprising 3.5% of Si, with the balance being Fe and inevitable impurities, in which the (110) face was coincident with the plate face was used as the seed material B.

Then, a section of A perpendicular to both the rolling direction and the rolling face, and the (001) face of B perpendicular to plate face, were finished to a mirror surface of Ra≦0.2 »m by Emery polishing. After Sn film of 1.0 »m in thickness had been plated onto the polished surface, a solution of SnCl₂ + ethanol was applied to the plated surface and both surfaces were heated to 350°C. Then the plated surfaces of A, B were contacted with each other and the plated surface of B was closely joined to the plated surface of A while applying a supersonic wave to the joint face and a compressive stress of 5 g/mm² (0·049 MPa) thereto. Heating was effected by feeding into a temperature tilting furnace having a temperature gradient of 10°C/cm from 1200°C to 950°C and a N₂ atmosphere at a feeding rate of 10 mm/h. A was at the low temperature side and B at high temperature side.

In each of the thus obtained joined bodies, no grain boundary was observed at A, B and the joint face, as measured from the crystal structure of the plate face at the joint interface, and also the joined A and B were shown to have the same crystal body by the measured crystalline orientation.

Moreover, when the same three steel sheets as in A before the treatment were subjected to the same tilting annealing without joining according to the invention, the B₁₀ values of the resulting steel sheets were as low as 1.70, 1.85, 1.95(T), respectively, and also the scattering was large, while the B₁₀ value of the joined body obtained according to the invention was as high as 2.00(T).

### Example 5

An ingot of silicon steel containing C: 0.035%, Si: 3.00%, Se: 0.020% was hot rolled to obtain a hot rolled sheet of 2.5 mm thickness. After a sheet of 0.4 mm thickness had been finished by cold rolling, it was annealed at 950°C in dry N₂ for 10 minutes. Thereafter, a sheet of 0.3 mm thickness was finished by cold rolling and decarburized at 820°C in a wet hydrogen atmosphere for 5 minutes and 2.75% strain was introduced under tension. A piece having dimensions 300ℓ × 1000W mm was cut out as the treating material A with a high energy state.

A plate-like single crystal comprising 3.5% Si, with the balance being Fe and inevitable impurities, in which the (110) face was coincident with the plate face was used as the seed material B.

A section of A parallel to the rolling direction and perpendicular to the rolling face, and the (110) face of B perpendicular to plate face, were then finished to a mirror surface of Ra≦0.2 »m by Emery polishing. After Sn film of 1.0 »m in thickness had been plated onto the polished surface, a solution of SnCl₂ + ethanol was applied to the plated surface and the plated faces of A, B were closely joined by rubbing while heating to 350°C and applying a supersonic wave. While the steel sheet was curved by applying a curvature of D=750 mm in ℓ direction, the joined body was heated by feeding into a temperature tilting furnace having a temperature gradient of 20°C/cm from 1150°C to 850°C in a N₂ atmosphere at a feeding rate of 10 mm/h while applying a compressive stress of 15 g/mm² (0·147 MPa) to the joint face. A was at the low temperature side and B at high temperature side.

In each of the thus obtained joined bodies, no grain boundary was observed at A, B and the joint face as measured from the crystal structure of the plate face at the joint interface. Also the joined pieces A and B were shown to have the same crystal body by the measured crystalline orientation.

In five samples obtained by applying MgO as a separator to the crystal body and annealing at 1200°C in H₂ for 5 hours, the B₁₀ value was 1.99∼2.02 (T) and the W_{17/50} value was 0.85∼0.95(W/kg), and their average magnetic properties were B₁₀: 2.01 (T),
W_{17/50}: 0.90 (W/kg).

### Example 6

From a block-like coarse grain comprising 2% Si, with the balance being Fe and inevitable impurities, were cut out three single crystal plates of 0.5 mm thickness and 10 mm × 30 mm using the electric arc method. The plate faces had orientations (100), (110) and (111) in seed materials B, C and D, respectively.

A steel ingot comprising C: 0.022%, Si: 0.37%, Mn: 0.43%, P: 0.019%, S: 0.011%, Cu: 0.11%, Ni: 0.20%, Cr: 17.50%, Al: 0.005%, N: 0.025%, with the balance being Fe and inevitable impurities, was hot rolled to obtain a hot rolled sheet of 2 mm thickness, and subjected to a combination of cold rollings in the hot rolling direction and a direction perpendicular thereto to obtain a cold rolled sheet of 0.5 mm thickness. The sheet was then annealed at 1000°C in N₂ for 3 hours and 2.5% strain was introduced under tension to give it a high energy state as compared with the seed material, and three sheets of 20 mm × 30 mm were cut out as treating materials A₁, A₂, A₃.

Each plate face of A₁, A₂, A₃, B, C, D was then finished to a mirror surface of Ra≦0.2 »m by Emery polishing and chemical polishing. After an alloy film of Sn and Pb of 1.5 »m thickness had been coated onto the polished face by vacuum deposition, the coated face of each of B, C, D was closely joined to the coated face of each of A₁, A₂, A₃, followed by heating at 1200°C in an Ar atmosphere for 100 hours while applying a compressive stress of 5 g/mm² (0·049 MPa) to the joint face.

In each of the thus obtained joined bodies, no border or grain boundary was observed at the joint face as measured from the sectional structure at the joint interface. Also each of the joined pieces A₁, A₂, A₃ was shown to have a crystal body having the same orientation as in each of B, C, D by the measured crystalline orientation.

### Example 7

From a coarse single crystal grain obtained by introducing strain into a Mo block having a purity of 99.9% and annealing, were cut out three single crystal plates of 0.5 mm thickness and 10 mm × 30 mm using the electric arc method so that the plate faces were given orientations (100), (110), (111) in seed materials B, C, D.

An ingot comprising Ca: 0.0025%, with the balance being Mo and inevitable impurities, was hot rolled to obtain a hot rolled sheet of 2 mm thickness, which was subjected to a combination of cold rollings in the hot rolling direction and the direction perpendicular thereto to obtain a cold rolled sheet of 0.5 mm thickness. Three square sheets of 20 mm × 30 mm were cut out from the cold rolled sheet as treating materials A₁, A₂, A₃.

Each plate face of A₁, A₂, A₃, B, C, D was then finished to a mirror surface of Ra≦0.2 »m by Emery polishing. After Fe film of 2 »m thickness had been plated onto the polished face, the plated face of each of B, C, D was closely joined to the plated face of each of A₁, A₂, A₃, and heated at 1200°C in an Ar atmosphere for 1 hour while applying a compressive stress of 5 g/mm² (0·049 MPa) to the joint face, and annealed at 1250°C in an Ar atmosphere for 50 hours after releasing the compressive stress.

In each of the thus obtained joined bodies, no border or grain boundary was observed at the joint face as measured from the plate face structure at the joint interface. Also each of the joined pieces A₁, A₂, A₃ was shown to have a crystal body having the same orientation as in each of B, C, D by the measured crystalline orientation.

### Example 8

From a block-like coarse single crystal grain comprising 23% of Fe, with the balance being Ni and inevitable impurities, were cut out three single crystal plates of 0.5 mm thickness and 10 mm × 30 mm using the electric arc method so that the plate faces were given orientations (100), (110), (111) in seed materials B, C, D.

A steel ingot comprising Fe: 22.9%, with the balance being Ni and inevitable impurities, was hot rolled to obtain a flat sheet of 13 mm thickness. After the thickness was reduced to 9 mm by cold rolling, the sheet was annealed at 800°C for 10 minutes and subjected to a combination of cold rollings in the hot rolling direction and the direction perpendicular thereto to obtain a cold rolled sheet of 0.5 mm thickness, from which three square sheets of 20 mm × 30 mm were cut out as treating materials A₁, A₂, A₃.

Each plate face of A₁, A₂, A₃, B, C, D was then finished to a mirror surface of Ra≦0.2 »m by Emery polishing. After Sn film of 1 »m in thickness had been coated onto the polished face by vacuum deposition, the coated face of each of B, C, D was closely joined to the coated face of each of A₁, A₂, A₃, followed by annealing at 1050°C in an Ar atmosphere for 24 hours while applying a compressive stress of 10 g/mm² (0·098 MPa) to the joint face.

In each of the thus obtained joined bodies, no border or grain boundary was observed at the joint face as measured from the plate face structure at the joint interface. Also each of the joined pieces A₁, A₂, A₃ was shown to have a crystal body having the same orientation as in each of B, C, D by the measured crystalline orientation.

### Example 9

From a coarse single crystal grain obtained by introducing strain into Cu block having a purity of 99.9% and annealing, were cut out three single crystal plates of 0.3 mm thickness and 10 mm × 30 mm, using the electric arc method so that the plate faces were given orientations (100), (110), (111) in seed materials B, C, D.

A square sheet of 30 mm thickness and 40 mm × 50 mm was cut out from commercially available pure copper (containing O: 0.0009%, P: 0.0003%, S: 0.001% as impurities), which was finished to a cold rolled sheet of 0.3 mm thickness while rotating the cold rolling direction by 90° every pass. Three square sheets of 20 mm × 30 mm were then cut out as treating materials A₁, A₂, A₃.

Each plate face of A₁, A₂, A₃, B, C, D was finished to a mirror surface of Ra≦0.2 »m by Emery polishing. After an alloy film of Sn-Bi of 1 »m thickness had been coated onto the polished face by vacuum deposition, the coated face of each of B, C, D was closely joined to the coated face of each of A₁, A₂, A₃, followed by annealing at 1000°C under a vacuum of 10⁻² Torr (1·33 Pa) for 24 hours while applying a compressive stress of 2 g/mm² (0·0196 MPa) to the joint face.

In each of the thus obtained joined bodies, no border or grain boundary was observed at the joint face as measured from the plate face structure at the joint interface. Also each of the joined pieces A₁, A₂, A₃ was shown to have a crystal body having the same orientation as in each of B, C, D by the measured crystalline orientation.

### Example 10

From a coarse single crystal grain obtained by introducing strain into Al block having a purity of 99.9% and annealing were cut out three single crystal plates of 0.3 mm thickness and 10 mm × 30 mm, using the electric arc method so that the plate face had orientations (100), (110), (111) in seed materials B, C, D.

A square sheet of 30 mm thickness and 40 mm × 50 mm was cut out from commercially available pure Al (containing Fe: 0.003%, Si: 0.004% as impurities), which was finished to a cold rolled sheet of 0.3 mm thickness while rotating the cold rolling direction by 90° every pass. Three square sheets of 20 mm × 30 mm were then cut out as treating materials A₁, A₂, A₃.

Each plate face of A₁, A₂, A₃, B, C, D was then finished to a mirror surface of Ra≦0.2 »m by Emery polishing. After an alloy film of Al-Si of 2 »m thickness had been coated onto the polished face by vacuum deposition, the coated face of each of B, C, D was closely joined to the coated face of each of A₁, A₂, A₃, followed by heating at 600°C in N₂ while applying a compressive stress of 10 g/mm² (0·098 MPa) to the joint face and applying a supersonic wave, and annealed at 625°C under vacuum of 10⁻² Torr (1·33 Pa) for 24 hours while applying a compressive stress of 2 g/mm² (0·0196 MPa) to the joint face.

In each of the thus obtained joined bodies, no border or grain boundary was observed at the joint face as measured from the plate face structure at the joint interface. Also each of the joined pieces A₁, A₂, A₃ was shown to have a crystal body having the same orientation as in each of B, C, D by the measured crystalline orientation.

### Example 11

An ingot of silicon steel comprising C: 0.042%, Si: 3.25%, Mn: 0.060%, S: 0.002%, Se: 0.019%, O: 0.005%, with the balance being Fe and inevitable impurities, was heated to 1350°C and hot rolled to obtain a hot rolled sheet of 2.5 mm thickness. Then, the sheet was subjected to a first cold rolling to an intermediate thickness of 0.4 mm and a second cold rolling to a thickness of 0.3 mm through intermediate annealing at 950°C in dry N₂ for 10 minutes. Thereafter, the sheet was subjected to decarburization and primary recrystallization annealing at 820°C in a wet hydrogen atmosphere for 5 minutes and 2.75% strain was introduced into the steel sheet under tension. Four specimens of ℓ=300 mm, W=160 mm were then cut out from the sheet as A1, A2, A3, A4.

An ingot of silicon steel having the same composition, except O: 0.0015%, was treated in the same manner as in A to obtain specimens B1, B2, B3, B4.

A plate-like single crystal comprising 3.5% Si, with the balance being Fe and inevitable impurities, and having α=0° and β=2° was used as joining material C.

Each plate face of A1∼A4, B1∼B4 and C was finished to a mirror surface by chemical polishing and subjected to argon sputtering under a superhigh vacuum (10⁻¹⁰ Torr) (1·33 × 10⁻⁸ Pa). Thereafter, each of A1, A2, B1, B2 was closely joined with C so that the sputtered faces were spaced only at a width of 5 mm in a direction perpendicular to the rolling direction so as to coincide the rolling direction with the 〈001〉 axis of C, and fed into a temperature tilting furnace having a temperature gradient of 10°C/cm between 1150∼850°C. The feeding rate was 10 mm/h and A1, A2, B1, B2 were at the low temperature side and C was at the high temperature side of the furnace and a compressive load of 10 g/mm² (0·098 MPa) was applied to the joint face. In addition, each of A3, A4, B3, B4 was fed into the same furnace without joining to C while holding the end face perpendicular to the rolling direction at the high temperature side, during which the heating was conducted under a superhigh vacuum.

Examination of the crystal structure of each of the thus obtained joined bodies showed that all of A3, A4, B3, B4 were coarse polycrystal bodies, while each of A1, A2, B1, B2 was a single crystal body and had no grain boundary even at the joint face. It was also confirmed from the measured crystalline orientation that each of the joining materials A1, A2, B1, B2 forms a crystal body having the same orientation as in the seed material C.

Furthermore, the B₁₀ values of A1, A2, A3, A4 were 1.99, 1.97, 1.68, 1.55 (T), respectively, and the B₁₀ values of B1, B2, B3, B4 were 2.00, 1.98, 1.70, 1.62 (T), respectively. Thus, even if the oxygen amount in the raw material is large or small, the B₁₀ value is greatly improved by joining a secondary recrystallized seed material.

After the application of MgO as a separator, A1, A2, B1, B2, were subjected to purification annealing at 1200°C in H₂ for 5 hours and a tension coating was applied thereto. The magnetic properties were then measured to obtain the results shown in Table 3.

**Table 3**

| | B₁₀ (T) | W_{17/50} (W/kg) |
|---|---|---|
| A1 | 2.00 | 0.83 |
| A2 | 1.98 | 0.88 |
| B1 | 2.01 | 0.80 |
| B2 | 1.99 | 0.83 |

### Example 12

An ingot of silicon steel comprising C: 0.042%, Si: 3.25%, Mn: 0.060%, S: 0.002%, Se: 0.019%, O: 0.005%, with the balance being Fe and inevitable impurities, was heated to 1350°C and hot rolled to obtain a hot rolled sheet of 2.5 mm thickness. Then, the sheet was subjected to a first cold rolling to an intermediate thickness of 0.4 mm and a second cold rolling to a thickness of 0.3 mm, through intermediate annealing at 950°C in dry N₂ for 10 minutes. Thereafter, the sheet was subjected to decarburization and primary recrystallization annealing at 820°C in a wet hydrogen atmosphere for 5 minutes and 2.75% strain was introduced into the steel sheet under tension. Four specimens of ℓ=300 mm, W=160 mm were then cut out from the steel sheet as A1, A2, A3, A4.

An ingot of silicon steel having the same composition, except O: 0.0015%, was treated in the same manner as in A to obtain specimens B1, B2, B3, B4.

Furthermore, a plate-like single crystal comprising 3.5% Si, with the balance being Fe and inevitable impurities, and having α=0° and β=2° was used as joining material C.

Each sectional face of A1∼A4, B1∼B4 parallel to the rolling direction and perpendicular to the rolling face, and the (110) face of C perpendicular to plate face, were finished to a mirror surface of Ra<0.2 »m by Emery polishing. After a Sn film of 1.0 »m had been plated on each of the polished surfaces, each plated surface of A1, A2, B1, B2 was closely joined with the plated surface of C. The joined bodies, as well as non-joined bodies, were then heated by feeding into a temperature tilting furnace having a temperature gradient of 10°C/cm between 1150∼850°C at a feeding rate of 10 mm/h, while applying a compressive load of 15 g/mm² (0·147 MPa) to the joint face. A1, A2, B1, B2 were at the low temperature side and C at the high temperature side; the plated surfaces of A3, A4, B3, B4 which were not joined with C were at the high temperature side.

Examination of the crystal structure of each of the thus obtained joined bodies showed that all of A3, A4, B3, B4 were coarse polycrystal bodies, while each of A1, A2, B1, B2 was a single crystal body and had no grain boundary even at the joint face. It was also confirmed from the measured crystalline orientation that each of the joining materials A1, A2, B1, B2 forms a crystal body having the same orientation as in the seed material C.

Furthermore, the B₁₀ values of A1, A2, A3, A4 were 1.95, 1.99, 1.70, 1.62 (T), respectively, and the B₁₀ values of B1, B2, B3, B4 were 1.99, 1.97, 1.75, 1.85 (T), respectively. Thus, even if the oxygen amount in the raw material is large or small, the B₁₀ value is largely improved by joining a secondary recrystallized seed material.

After the application of MgO as a separator, A1, A2, B1, B2, were subjected to purification annealing at 1200°C in H₂ for 5 hours. The magnetic properties were then measured to obtain the results shown in Table 4.

**Table 4**

| | B₁₀ (T) | W_{17/50} (W/kg) |
|---|---|---|
| A1 | 1.97 | 0.90 |
| A2 | 2.00 | 0.85 |
| B1 | 2.00 | 0.82 |
| B2 | 1.98 | 0.85 |

### Example 13

An ingot of silicon steel comprising C: 0.060%, Si: 3.25%, Mn: 0.060%, S: 0.022%, sol Al: 0.015%, N: 0.0085%, with the balance being Fe and inevitable impurities, was heated to 1250°C and hot rolled to obtain a hot rolled sheet of 1.9 mm thickness. Then, the sheet was annealed at 1120°C for 2 minutes, finished to a thickness of 0.20 mm by cold rolling and subjected to decarburization and primary recrystallization annealing at 820°C in a wet hydrogen atmosphere for 5 minutes. Four specimens of ℓ=300 mm, W=160 mm were then cut out from the steel sheet as A1, A2, A3, A4.

An ingot of silicon steel having the same composition, except Al: 0.050%, was treated in the same manner as in A to obtain specimens B1, B2, B3, B4.

A plate-like single crystal comprising 3.0% Si, with the balance being Fe and inevitable impurities, and having α=0° and β=2.5° was used as joining material C.

Each plate face of A1∼A4, B1∼B4 and C was finished to a mirror surface by chemical polishing and the mirror surface was subjected to argon sputtering under superhigh vacuum (10⁻¹⁰ Torr) (1·33 × 10⁻⁸ Pa). Thereafter, each of A1∼A4, B1∼B4 was closely joined with C so that the sputtered faces were spaced only at a width of 5 mm in a direction perpendicular to the rolling direction so as to coincide the rolling direction with the 〈001〉 axis of C, and heated under the following conditions while applying a compressive load of 10 g/mm² (0·098 MPa) to the joint face. Each of A1, A2, B1, B2 was annealed in a uniform furnace having a N₂ atmosphere at 990°C for 24 hours. Each of A3, A4, B3, B4 was heated by feeding into a temperature tilting furnace having a temperature gradient of 5°C/cm between 1150∼850°C at a feeding rate of 10 mm/h while holding A3, A4, B3, B4 at the low temperature side and C at the high temperature side.

Examination of the crystal structure of each of the thus obtained joined bodies showed that each of A1, A2, B1, B2 partly contained a coarse polycrystalline body, while each of A3, A4, B3, B4 was a single crystal body. Furthermore, no grain boundary was observed at the joint face in all of A1∼A4, B1∼B4, and it has also been confirmed from the measured crystalline orientations that they form a crystal body having the same orientation as in the seed material C around the joint face.

After the application of MgO as a separator, A1∼A4, B1∼B4 were subjected to purification annealing at 1200°C in H₂ for 20 hours, and then the magnetic properties were measured to obtain the results shown in the following Table 5.

**Table 5**

| | B₁₀ (T) | W_{17/50} (W/kg) | | B₁₀ (T) | W_{17/50} (W/kg) |
|---|---|---|---|---|---|
| A1 | 2.00 | 0.80 | B1 | 1.98 | 0.86 |
| A2 | 1.98 | 0.85 | B2 | 1.99 | 0.85 |
| A3 | 1.99 | 0.83 | B3 | 1.97 | 0.87 |
| A4 | 1.97 | 0.88 | B4 | 1.95 | 0.89 |

Thus, whether the amount of Al in the raw material is small or large, or whether the secondary recrystallization annealing is carried out in a temperature tilting furnace or a uniform temperature furnace, a very high B₁₀ value and a low iron loss value are obtained.

### Example 14

An ingot of silicon steel comprising C: 0.060%, Si: 3.25%, Mn: 0.060%, S: 0.022%, sol Al: 0.015%, N: 0.0085%, with the balance being Fe and inevitable impurities, was heated to 1250°C and hot rolled to obtain a hot rolled sheet of 1.9 mm thickness. Then, the sheet was annealed at 1120°C for 2 minutes, finished to a thickness of 0.20 mm by cold rolling and subjected to decarburization and primary recrystallization annealing at 820°C in a wet hydrogen atmosphere for 5 minutes, from which four specimens of ℓ=300 mm, W=160 mm were cut out as A1, A2, A3, A4.

An ingot of silicon steel having the same composition, except Al: 0.050%, was treated in the same manner as in A to obtain specimens B1, B2, B3, B4.

Furthermore, a plate-like single crystal comprising 3.0% of Si, with the balance being Fe and inevitable impurities, and having α=0° and β=2.5° was used as joining material C.

Each sectional face of A1∼A4, B1∼B4 parallel to the rolling direction and perpendicular to the rolling face, as well as the (110) face of C perpendicular to the plate face, were finished to a mirror surface of Ra<0.2 »m by Emery polishing. After Sn film of 1.0 »m had been plated onto each polished surface, each plated surface of A1∼A4, B1∼B4 was closely joined with the plated surface of C, and heated under the following conditions while applying a compressive load of 10 g/mm² (0·098 MPa) to the joint face. Each of A1, A2, B1, B2 was annealed in a uniform furnace having a N₂ atmosphere at 990°C for 24 hours. Each of A3, A4, B3, B4 was heated by feeding into a temperature tilting furnace having a temperature gradient of 5°C/cm between 1150∼850°C at a feeding rate of 10 mm/h, while holding A3, A4, B3, B4 at the low temperature side and C at the high temperature side.

Examination of the crystal structure of each of the thus obtained joined bodies showed that each of A1, A2, B1, B2 partly contained a coarse polycrystalline body, while each of A3, A4, B3, B4 was a single crystal body. Furthermore, no grain boundary was observed at the joint face in all of A1∼A4, B1∼B4, and it has also been confirmed from the measured crystalline orientations that they form a crystal body having the same orientation as in the seed material C around the joint face.

After the application of MgO as a separator, A1∼A4, B1∼B4 were subjected to purification annealing at 1200°C in H₂ for 20 hours, and then the magnetic properties were measured to obtain the results shown in the following Table 6.

**Table 6**

| | B₁₀ (T) | W_{17/50} (W/kg) | | B₁₀ (T) | W_{17/50} (W/kg) |
|---|---|---|---|---|---|
| A1 | 1.99 | 0.82 | B1 | 1.98 | 0.85 |
| A2 | 1.97 | 0.88 | B2 | 1.96 | 0.89 |
| A3 | 1.98 | 0.83 | B3 | 2.00 | 0.82 |
| A4 | 2.02 | 0.80 | B4 | 2.01 | 0.80 |

Thus, whether the amount of Al in the raw material is small or large, or whether the secondary recrystallization annealing is carried out in a temperature tilting furnace or a uniform temperature furnace, a very high B₁₀ value is obtained.

### Example 15

An ingot of silicon steel comprising C: 0.085%, Si: 3.00%, Mn: 0.080%, S: 0.015%, sol Al: 0.030%, N: 0.0085%, with the balance being Fe and inevitable impurities, was heated to 1350°C and immediately hot rolled to a thickness of 0.35 mm. Then, two sheets having a length: 150 mm and a width: 50 mm were cut out and decarburized at 750°C in a wet hydrogen atmosphere for 3 hours as A1, A2.

Two single crystal plates comprising 3.0% Si, with the balance being Fe and inevitable impurities, and having thickness: 0.35 mm, length: 150 mm, width: 5 mm, α=0° and β=2° were provided as B1, B2.

Then, one-side end portion of the rolling face of A at a width of 5 mm in longitudinal direction and one-side of the full rolling face of B were finished to a mirror surface of Ra<0.1 »m by Emery polishing, chemical polishing and ion sputtering. Thereafter, the mirrored surfaces of A1 and B1 were closed together and were heated from 1000°C to 1200°C at a rate temperature increase of 5°C/h under a vacuum of 10⁻⁶ Torr (1·33 × 10⁻⁴ Pa). An insert member of Sn of 1 »m thickness was deposited onto the mirrored surfaces of A2 and B2, and heated while the surfaces were closed together in N₂ having a dew point of -50°C, in the same manner as in A1, B1. After MgO was applied as a separator, it was subjected to purification annealing at 1200°C in H₂ for 20 hours. Then a tension coating was applied, and thereafter the magnetic properties of A were measured to obtain the results shown in the following table.

**Table 7**

| | B₁₀ (T) | | W_{17/50} (W/kg) | |
|---|---|---|---|---|
| Presence or absence of insert member | presence | absence | presence | absence |
| Magnetization in the same direction as in hot rolling | 2.01 | 1.99 | 0.95 | 0.97 |

### Example 16

An ingot of silicon steel having the same composition as in Example 1 was heated to 1350°C and hot rolled to a thickness of 0.35 mm. Then, two square specimens having length: 200 mm and width: 50 mm were cut out therefrom, and were annealed at 1050°C in dry H₂ for 3 minutes and decarburized at 750°C in wet hydrogen for 1 hour to obtain A3, A4.

Two single crystal plates comprising 3.0% Si, with the balance being Fe and inevitable impurities, and having thickness: 0.35 mm, length: 200 mm, width: 5 mm, α=0° and β=2° were provided as B3, B4.

Then, one-side end portion of the rolling face of A at a width of 5 mm in longitudinal direction and one-side of the full rolling face of B were finished to a mirror surface of Ra<0.1 »m by Emery polishing, chemical polishing and ion sputtering. After Sn of 0.5 »m in thickness had been deposited onto the mirrored surfaces of A4, B4 by ion coating, the mirrored surfaces of A3 and B3, as well as the coated surfaces of A4 and B4, were closed together and a compressive load: 7 g/mm² (0·069 MPa) was applied to the joint face. The joints were heated under a vacuum of 10⁻⁶ Torr (1·33 × 10⁻⁴ Pa) in case of A3, B3 (which were not coated with Sn), or in N₂ having a dew point of -10°C in case of A4, B4 (which were coated with Sn) by feeding into a temperature tilting furnace having a temperature gradient of 5°C/cm between 1150°C∼900°C at a feeding rate of 10 mm/h. A was held at the low temperature side and B at the high temperature side.

After MgO was applied as a separator, it was subjected to purification annealing at 1200°C in H₂ for 20 hours and then a tension coating was applied. Thereafter the magnetic properties were measured to obtain the results shown in the following table.

**Table 8**

| | B₁₀ (T) | | W_{17/50} (W/kg) | |
|---|---|---|---|---|
| Presence or absence of insert member | presence | absence | presence | absence |
| Magnetization in the same direction as in hot rolling | 2.03 | 1.99 | 0.91 | 0.94 |

### Example 17

An ingot of silicon steel comprising C: 0.175%, Si: 3.01%, Mn: 0.075%, Al: 0.035%, N: 0.0111%, S: 0.011%, Se: 0.007%, Te: 0.005%, Sb: 0.007%, with the balance being Fe and inevitable impurities, was heated at 1350°C for 1 hour and hot rolled to a thickness of 1.9 mm. Then, the sheet was cold rolled to a thickness of 0.23 mm, from which two square specimens having length: 150 mm and width: 50 mm were cut out and heated at a rate of temperature increase of 20°C/h between 200°C∼700°C and subjected to decarburization annealing at 750°C in a wet hydrogen atmosphere for 3 hours to obtain raw material A.

Thereafter, the same procedure as in Example 15 was repeated to obtain the results shown in the following table.

**Table 9**

| Insert member | B₁₀ (T) | W_{17/50} (W/kg) |
|---|---|---|
| presence | 2.02 | 0.67 |
| absence | 2.01 | 0.68 |

### Example 18

An ingot of silicon steel comprising C: 0.049%, Si: 3.35%, Mn: 0.075%, S: 0.018%, Al: 0.032%, N: 0.0085%, with the balance being Fe and inevitable impurities, was heated to 1350°C and hot rolled to a thickness of 1.15 mm. Then, the sheet was subjected to decarburization annealing at 725°C in wet H₂ for 3 hours and then cold rolled to a thickness of 0.20 mm, from which four square specimens having a length: 150 mm and a width: 50 mm were cut out. Among these specimens, two specimens (A1, A2) were subjected to primary recrystallization annealing at 850°C for 5 minutes and the remaining two specimens (A3, A4) were not subjected to such annealing.

Four single crystal plates comprising 3.0% Si, with the balance being Fe and inevitable impurities, and having thickness: 0.23 mm, length: 150 mm, width: 5 mm, α=0° and β=2° were provided as B1, B2, B3, B4.

The same procedure as in Example 16 was repeated to obtain the results shown in the following table.

**Table 10**

| Primary recrystallization annealing | Insert member | B₁₀ (T) | W_{17/50} (W/kg) |
|---|---|---|---|
| presence | presence | 2.015 | 0.72 |
| | absence | 2.010 | 0.74 |
| absence | presence | 2.010 | 0.73 |
| | absence | 2.007 | 0.75 |

### Example 19

An ingot of silicon steel comprising C: 0.023%, Si: 3.0%, Mn: 0.040%, Se: 0.011%, Al: 0.051%, N: 0.0105%, with the balance being Fe and inevitable impurities, was heated to 1225°C and immediately hot rolled to a thickness of 0.23 mm. Then, two square sheets (A3, A4) having a length: 200 mm and a width: 50 mm were cut out therefrom and subjected to decarburization annealing at 850°C in a wet hydrogen for 5 minutes.

Two single crystal plates having the same composition as the above hot rolled sheet, and thickness: 0.23 mm, length: 2.00 mm, width: 5 mm, α=0° and β=2° were provided as B3, B4.

The same procedure as in Example 16 was repeated to obtain the results shown in the following table.

**Table 11**

| Insert member | B₁₀ (T) | W_{17/50} (W/kg) |
|---|---|---|
| presence | 2.02 | 0.67 |
| absence | 2.01 | 0.68 |

### Example 20

An ingot of silicon steel comprising C: 0.205%, Si: 3.42%, Mn: 0.035%, Al: 0.032%, N: 0.0095%, Se: 0.008%, with the balance being Fe and inevitable impurities, was heated at 1225°C for 1 hour and hot rolled to a thickness of 0.30 mm. Then, two square sheets having length: 200 mm and width: 50 mm were cut out therefrom and annealed at 1100°C in dry N₂ for 1 minute and then annealed at 725°C in a wet hydrogen atmosphere for 5 hours to obtain raw material A.

Thereafter, the same procedure as in Example 16 was repeated to obtain the results shown in the following table.

**Table 12**

| Insert member | B₁₀ (T) | W_{17/50} (W/kg) |
|---|---|---|
| presence | 2.02 | 0.78 |
| absence | 2.00 | 0.79 |

### Example 21

An ingot of silicon steel comprising C: 0.083%, Si: 3.05%, Mn: 0.045%, Se: 0.012%, Al: 0.040%, N: 0.0090%, with the balance being Fe and inevitable impurities, was heated at 1200°C for 1 hour and hot rolled to a thickness of 1.9 mm. Then, the sheet was cold rolled to a thickness of 0.30 mm, from which two square sheets having length: 150 mm and width: 50 mm were cut out and subjected to decarburization annealing at 725°C in a wet hydrogen atmosphere for 1 hour to obtain raw material A.

Thereafter, the same procedure as in Example 15 was repeated to obtain the results shown in the following table.

**Table 13**

| Insert member | B₁₀ (T) | W_{17/50} (W/kg) |
|---|---|---|
| presence | 2.03 | 0.82 |
| absence | 2.01 | 0.83 |

### Example 22

An ingot of silicon steel comprising C: 0.085%, Si: 4.0%, Mn: 0.050%, S: 0.013%, Al: 0.035%, N: 0.0080%, with the balance being Fe and inevitable impurities, was heated to 1200°C and hot rolled to a thickness of 1.15 mm. Then, the sheet was subjected to decarburization annealing at 725°C in wet H₂ for 3 hours and then cold rolled to a thickness of 0.20 mm, from which four square specimens having length: 150 mm and width: 50 mm were cut out. Among these specimens, two specimens (A1, A2) were subjected to decarburization and primary recrystallization annealing at 850°C for 5 minutes and the remaining two specimens (A3, A4) were not subjected to such annealing.

Four single crystal plates comprising 3.0% Si, with the balance being Fe and inevitable impurities, and having thickness: 0.23 mm, length: 150 mm, width: 5 mm, α=0° and β=2° were provided as B1, B2, B3, B4.

The same procedure as in Example 16 was repeated to obtain the results shown in the following table.

**Table 14**

| Primary recrystallization annealing | Insert member | B₁₀ (T) | W_{17/50} (W/kg) |
|---|---|---|---|
| presence | presence | 1.970 | 0.83 |
| | absence | 1.965 | 0.85 |
| absence | presence | 1.967 | 0.84 |
| | absence | 1.972 | 0.82 |

### Example 23

A sheet bar (thickness: 30 mm) of silicon steel comprising C: 0.125%, Si: 3.0%, Mn: 0.080%, Al: 0.030%, N: 0.0085%, Sb: 0.030%, with the balance being Fe and inevitable impurities, casted through a belt caster was heated at 950°C for 1 hour and hot rolled to a thickness of 1.15 mm. Then, the sheet was subjected to decarburization annealing at 725°C in wet hydrogen for 5 hours and cold rolled to a thickness of 0.20 mm, from which six square sheets having length: 150 mm and width: 50 mm were cut out. Among these sheets, three sheets (A1, A2, A3) were subjected to primary recrystallization annealing at 850°C for 5 minutes and the remaining three sheets (A4, A5, A6) were not subjected to such annealing.

Six single crystal plates comprising 3.0% Si, with the balance being Fe and inevitable impurities, and having thickness: 0.23 mm, length: 150 mm, width: 5 mm, α=0° and β=2° were provided as B1, B2, B3, B4, B5, B6.

Then, three sets of A and B polished into mirror surface in the same manner as in Example 16 were provided in the presence or absence of primary recrystallization annealing. After S, Sb, Zn of 0.5 »m in thickness had been deposited on the mirrored surfaces of each set by ion coating, the coated surfaces of each set were closed together.

The same procedure as in Example 16 was repeated to obtain the results shown in the following table.

**Table 15**

| Primary recrystallization annealing | Insert member | B₁₀ (T) | W_{17/50} (W/kg) |
|---|---|---|---|
| presence | S | 2.01 | 0.71 |
| | Sb | 2.00 | 0.73 |
| | Zn | 2.02 | 0.70 |
| absence | S | 2.01 | 0.72 |
| | Sb | 2.00 | 0.74 |
| | Zn | 2.01 | 0.73 |

### Example 24

An ingot of silicon steel comprising C: 0.040%, Si: 3.10%, Mn: 0.055%, S: 0.012%, sol Al: 0.020%, N: 0.0095%, with the balance being Fe and inevitable impurities, was heated at 1200°C and hot rolled to a thickness of 1.15 mm.

Then, the sheet was subjected to decarburization annealing at 725°C in wet hydrogen for 5 hours and cold rolled to a thickness of 0.20 mm, from which four square sheets having ℓ=150 mm and W=50 mm were cut out (A1, A2, A3, A4). Then, only A2 and A4 were subjected to primary recrystallization annealing at 800°C in dry H₂ for 2 minutes.

Four single crystal plates comprising 3.0% Si, with the balance being Fe and inevitable impurities, and having thickness: 0.23 mm, length: 150 mm, width: 5 mm, α=0° and β=2° were provided as B1, B2, B3, B4.

Then, one-side end portion of the rolling face of A at a width of 5 mm in longitudinal direction and one-side of the full rolling face of B were finished to a mirror surface of Ra<0.1 »m by Emery polishing, chemical polishing and ion sputtering. After Sn of 1 »m in thickness had been deposited onto the mirrored surfaces of B1 and B2 by ion coating, the mirrored surface and the coated surface of A1 and B1, as well as A2 and B2, were closed together so as to coincide in the lengthwise direction and joined by heating at 900°C in dry N₂. Furthermore, the lengthwise direction of A3 and B3, as well as A4 and B4, were coincided with each other so as to overlap the ion sputtered mirror surfaces only at a width of 5 mm in the rolling direction and direction perpendicular thereto, and joined by heating at 900°C under vacuum of 10⁻⁸ Torr (1·33 × 10⁻⁶ Pa). While a compressive load: 7 g/mm² (0·069 MPa) was applied to the joint face, the joined sheets were heated by feeding into a temperature tilting furnace having a temperature gradient of 5°C/cm between 1150°C∼900°C at a feeding rate of 10 mm/h in a N₂ atmosphere having a dew point of -50°C. A was held at the low temperature side and B at the high temperature side.

After MgO was applied as a separator, it was subjected to purification annealing at 1200°C in H₂ for 20 hours and then a tension coating was applied. Thereafter the magnetic properties were measured to obtain the following results.

| | B₁₀ (T) | W_{17/50} (W/kg) |
|---|---|---|
| A1-B1 | 2.013 | 0.74 |
| A2-B2 | 2.022 | 0.76 |
| A3-B3 | 2.017 | 0.75 |
| A4-B4 | 2.015 | 0.77 |

Thus, when the decarburization was carried out prior to the rolling, even if the primary recrystallization annealing before the finish annealing had been omitted, or even if the atmosphere for the primary recrystallization annealing had been dry H₂, good magnetic properties were obtained.

### Example 25

An ingot of silicon steel comprising C: 0.003%, Si: 3.2%, Mn: 0.10%, S: 0.005%, N: 0.0085%, sol Al: 0.035%, with the balance being Fe and inevitable impurities, was heated at 1180°C and hot rolled to a thickness of 0.30 mm. Then, four square sheets having ℓ=150 mm and W=50 mm were cut out therefrom (A1, A2, A3, A4). Next, only A2 and A4 were subjected to primary recrystallization annealing at 850°C in dry H₂ for 1 minute.

The same procedure as in Example 24 was repeated to obtain the following results.

| | B₁₀ (T) | W_{17/50} (W/kg) |
|---|---|---|
| A1-B1 | 2.015 | 0.95 |
| A2-B2 | 2.020 | 0.97 |
| A3-B3 | 2.019 | 0.96 |
| A4-B4 | 2.018 | 0.98 |

### Example 26

An ingot of silicon steel comprising C: 0.003%, Si: 3.25%, Mn: 0.05%, S: 0.010%, N: 0.080%, Al: 0.050%, with the balance being Fe and inevitable impurities, was heated at 1200°C and hot rolled to a thickness of 2.3 mm. Then, the sheet was annealed at 950°C in dry N₂ for 2 minutes and cold rolled to a thickness of 0.3 mm, from which four square sheets having ℓ=150 mm W=50 mm were cut out (A1, A2, A3, A4). Next, only A2 and A4 were subjected to primary recrystallization annealing at 850°C in dry H₂ for 1 minute.

The same procedure as in Example 24 was repeated to obtain the following results.

| | B₁₀ (T) | W_{17/50} (W/kg) |
|---|---|---|
| A1-B1 | 2.013 | 0.98 |
| A2-B2 | 2.011 | 0.99 |
| A3-B3 | 2.012 | 0.97 |
| A4-B4 | 2.010 | 0.98 |

### Example 27

An ingot of silicon steel comprising C: 0.035%, Si: 3.35%, Mn: 0.045%, S: 0.008%, N: 0.0085%, Al: 0.045%, with the balance being Fe and inevitable impurities, was heated at 1225°C and hot rolled to a thickness of 2.3 mm. Then, the sheet was annealed at 850°C in wet hydrogen for 15 minutes and cold rolled to a thickness of 1.15 mm. Furthermore, it was annealed at 850°C in wet hydrogen for 15 minutes and cold rolled to a thickness of 0.20 mm, from which four square sheets having ℓ=150 mm and W=50 mm were cut out (A1, A2, A3, A4). Next, only A2 and A4 were subjected to primary recrystallization annealing at 850°C in wet hydrogen for 3 minutes.

The same procedure as in example 24 was repeated to obtain the following results.

| | B₁₀ (T) | W_{17/50} (W/kg) |
|---|---|---|
| A1-B1 | 2.013 | 0.75 |
| A2-B2 | 2.016 | 0.77 |
| A3-B3 | 2.015 | 0.76 |
| A4-B4 | 2.014 | 0.74 |

### Example 28

An ingot of silicon steel comprising C: 0.005%, Si: 3.30%, Mn: 0.055%, Se: 0.019%, Sb: 0.025%, Mo: 0.015%, with the balance being Fe and inevitable impurities, was heated at 1350°C and hot rolled to a thickness of 2.3 mm. Then, the sheet was cold rolled two times to a thickness of 0.30 mm through an intermediate annealing at 950°C in dry N₂ for 2 minutes, from which four square sheets having ℓ=150 mm and W=50 mm were cut out (A1, A2, A3, A4). Next, only A2 and A4 were subjected to primary recrystallization annealing at 850°C in dry H₂ for 1 minute.

The same procedure as in Example 24 was repeated to obtain the following results.

| | B₁₀ (T) | W_{17/50} (W/kg) |
|---|---|---|
| A1-B1 | 2.010 | 0.97 |
| A2-B2 | 2.008 | 0.96 |
| A3-B3 | 2.007 | 0.98 |
| A4-B4 | 2.009 | 0.95 |

### Example 29

An ingot of silicon steel comprising C: 0.075%, Si: 3.25%, Mn: 0.070%, S: 0.015%, Mo: 0.015%, Al: 0.025%, N: 0.0099%, with the balance being Fe and inevitable impurities, was heated at 1300°C and hot rolled to a thickness of 2.3 mm. Then, the sheet was cold rolled to a thickness of 0.30 mm, subjected to decarburization annealing at 840°C in wet hydrogen for 10 minutes and then cold rolled to a thickness of 0.20 mm. Four square sheets having ℓ=150 mm and W=50 mm were then cut out (A1, A2, A3, A4). Next, only A2 and A4 were subjected to primary recrystallization annealing at 800°C in dry H₂ for 1 minute.

Four single crystal plates each comprising 3.0% Si, with the balance being Fe and inevitable impurities, and having thickness: 0.20 mm, length: 150 mm, width: 5 mm, α=0° and β=2° were provided as B1, B2, B3, B4.

Then, one-side end portion of the rolling face of A at a width of 5 mm in longitudinal direction and one-side of the full rolling face of B were finished to a mirror surface by Emery polishing, chemical polishing and ion sputtering.

After Sn of 2 »m had been plated onto each of A1, A2, B1 and B2, a solution of SnCl₂ + ethanol was applied to these plated surfaces. The plated surfaces of A1 and B1, as well as A2 and B2, were closed together so as to coincide in longitudinal direction and heated to 350°C while a compressive stress of 5 g/mm² (0·049 MPa) and a supersonic wave were applied to the joint face and The plated surfaces were rubbed with each other to closely join the plated surface of B onto the plated surface of A. The ion sputtered mirror surfaces of A3 and B3, as well as A4 and B4, were overlapped at a width of only 5 mm in the rolling direction and the direction perpendicular thereto so as to coincide the longitudinal directions, and were joined by heating at 950°C under vacuum of 10⁻⁸ Torr (1·33 × 10⁻⁶ Pa). After MgO containing 15% of SrSO₄ had been applied as a separator, the joined body was heated in N₂ having a dew point of -30°C at a rate of temperature increase of 20°C/h and subjected to purification annealing at 1200°C for 24 hours. A tension coating was then applied, and thereafter the magnetic properties were measured to obtain the following results.

| | B₁₀ (T) | W_{17/50} (W/kg) |
|---|---|---|
| A1-B1 | 2.015 | 0.75 |
| A2-B2 | 2.020 | 0.77 |
| A3-B3 | 2.017 | 0.76 |
| A4-B4 | 2.019 | 0.78 |

### Example 30

An ingot of silicon steel comprising C: 0.003%, Si: 3.1%, Mn: 0.09%, S: 0.010%, N: 0.0080%, sol Al: 0.030%, with the balance being Fe and inevitable impurities, was heated at 1180°C and hot rolled to a thickness of 0.30 mm. Then, the sheet was annealed at 550°C in N₂ for 24 hours, from which four square sheets having ℓ=150 mm and W=50 mm were cut out (A1, A2, A3, A4). Next, only A3 and A4 were subjected to primary recrystallization annealing at 850°C in dry H₂ for 1 minute.

The same procedure as in Example 29 was repeated to obtain the following results.

| | B₁₀ (T) | W_{17/50} (W/kg) |
|---|---|---|
| A1-B1 | 2.017 | 0.96 |
| A2-B2 | 2.021 | 0.98 |
| A3-B3 | 2.018 | 0.97 |
| A4-B4 | 2.019 | 0.99 |

### Example 31

An ingot of silicon steel comprising C: 0.003%, Si: 3.2%, Mn: 0.10%, S: 0.005%, N: 0.0085%, sol Al: 0.025%, with the balance being Fe and inevitable impurities, was heated at 1180°C and hot rolled to a thickness of 0.50 mm. Then, the sheet was cold rolled to a thickness of 0.23 mm, from which four square sheets having ℓ=150 mm and W=50 mm were cut out (A1, A2, A3, A4). Next, only A3 and A4 were subjected to primary recrystallization annealing at 850°C in dry H₂ for 1 minute.

The same procedure as in Example 29 was repeated to obtain the following results.

| | B₁₀ (T) | W_{17/50} (W/kg) |
|---|---|---|
| A1-B1 | 2.015 | 0.81 |
| A2-B2 | 2.020 | 0.80 |
| A3-B3 | 2.019 | 0.83 |
| A4-B4 | 2.016 | 0.82 |

### Example 32

An ingot of silicon steel comprising C: 0.025%, Si: 3.45%, Mn: 0.20%, S: 0.007%, sol Al: 0.033%, N: 0.0080%, with the balance being Fe and inevitable impurities, was heated at 1350°C and hot rolled to a thickness of 0.30 mm, from which four square sheets having ℓ=150 mm and W=50 mm were cut out (A1, A2, A3, A4). Next, only A3 and A4 were subjected to primary recrystallization annealing at 850°C in wet H₂ for 2 minutes.

The same procedure as in Example 29 was repeated by adopting decarburization using saturated water of MgO as a separator to obtain the following results.

| | B₁₀ (T) | W_{17/50} (W/kg) |
|---|---|---|
| A1-B1 | 2.005 | 0.95 |
| A2-B2 | 2.002 | 0.93 |
| A3-B3 | 2.003 | 0.94 |
| A4-B4 | 2.006 | 0.92 |

### Example 33

An ingot of silicon steel comprising C: 0.057%, Si: 3.45%, Mn: 0.29%, S: 0.003%, sol Al: 0.032%, N: 0.0090%, with the balance being Fe and inevitable impurities, was heated at 1350°C and hot rolled to a thickness of 0.30 mm. Then, the sheet was annealed at 850°C in wet hydrogen for 5 minutes, from which four square sheets having ℓ=150 mm and W=50 mm were cut out (A1, A2, A3, A4). Next, only A3 and A4 were subjected to an annealing at 970°C in dry N₂ for 1 minute.

The same procedure as in Example 29 was repeated to obtain the following results.

| | B₁₀ (T) | W_{17/50} (W/kg) |
|---|---|---|
| A1-B1 | 2.007 | 0.95 |
| A2-B2 | 2.005 | 0.97 |
| A3-B3 | 2.003 | 0.94 |
| A4-B4 | 2.004 | 0.93 |

### Example 34

An ingot of silicon steel comprising C: 0.030%, Si: 3.42%, Mn: 0.25%, S: 0.010%, sol Al: 0.027%, N: 0.0091%, with the balance being Fe and inevitable impurities, was heated at 1350°C and hot rolled to a thickness of 0.50 mm. Then, the sheet was cold rolled to a thickness of 0.23 mm, from which four square sheets having ℓ=150 mm and W=50 mm were cut out (A1, A2, A3, A4). Next, only A3 and A4 were subjected to primary recrystallization annealing at 850°C in wet H₂ for 2 minutes.

The same procedure as in Example 29 was repeated by using saturated water of MgO as a separator to obtain the following results.

| | B₁₀ (T) | W_{17/50} (W/kg) |
|---|---|---|
| A1-B1 | 2.007 | 0.81 |
| A2-B2 | 2.008 | 0.80 |
| A3-B3 | 2.006 | 0.79 |
| A4-B4 | 2.009 | 0.81 |

### Example 35

Molten steel comprising C: 0.079%, Si: 3.25%, Mn: 0.073%, S: 0.012%, sol Al: 0.025%, N: 0.0089%, with the balance being Fe and inevitable impurities, was slantly cast to a thickness of 150 mm from 1600°C in a water-cooled copper mold, quenched to 1150°C, held at the same temperature for 5 minutes and immediately hot rolled to a thickness of 2.5 mm.

Then, the sheet was hot rolled to a thickness of 0.22 mm, from which a steel sheet having length of 150 mm and width of 100 mm was cut out. Next, the sheet was heated from 200°C to 700°C at a rate of temperature increase of 20°C/h and subjected to decarburization annealing at 820°C in wet hydrogen for 3 minutes to obtain a treating material.

A single crystal plate comprising Si: 3.0%, with the balance being Fe and inevitable impurities, and having a thickness of 0.22 mm, a length of 150 mm, a width of 5 mm, α=0° and β=2° was provided as a seed material.

Then, one-side end portion of the rolling face of the treating material at a width of 5 mm in longitudinal direction and one-side of the full rolling face of the seed material were finished to a mirror surface of Ra<0.1 »m by grinding and polishing.

Next, In of 1 »m thickness was plated onto the mirrored surface of the seed material, while Sn of 1 »m thickness was plated onto the mirrored surface of the treating material. These plated surfaces were closed together by rubbing so as to coincide the longitudinal directions and joined by heating in dry N₂ while a compressive stress: 7 g/mm² (0·069 MPa) was applied to the joint face and a supersonic wave was applied.

After MgO containing 1.7% of SnSO₄ was applied as a separator, the joined body was heated in dry N₂ by feeding into an annealing furnace having a temperature gradient of 1°C/cm between 1150∼900°C at a feeding rate of 5 mm/h, while holding the treating material at the low temperature side and the seed material at the high temperature side. Then, the body was subjected to purification annealing at 1200°C in H₂ for 20 hours and a tension coating was applied thereto. As a result, the magnetic properties of the treating material were B₈=2.01 (T) and W_{17/50}=0.69 (W/kg).

### Example 36

Molten steel having the same composition as in Example 35 was cast to a thickness of 25 mm from 1600°C in a horizontal thin slab casting machine, quenched to 950°C, held at this temperature for 3 minutes and immediately hot rolled to a thickness of 0.35 mm, and held at 550°C for 24 hours and cooled. Then, a steel sheet having a length of 150 mm and a width of 100 mm was cut out therefrom and heated from 200°C to 700°C at a temperature rising rate of 20°C/h and subjected to decarburization annealing at 820°C in a wet hydrogen for 5 minutes to obtain a treating material.

Then, the same procedure as in Example 35 was repeated to obtain B₈=2.01 (T) and W_{17/50}=0.96 (W/kg).

### Example 37

Molten steel having the same composition as in Example 35 was slantly cast to a thickness of 5 mm from 1600°C in a water-cooled copper mold, quenched to 600°C and immediately warm rolled to a thickness of 0.22 mm. Then, a steel sheet having a length of 150 mm and a width of 100 mm was cut out therefrom, heated from 200°C to 700°C at a rate of temperature increase 20°C/h and then subjected to decarburization annealing at 820°C in wet hydrogen for 3 minutes to obtain a treating material.

Then, the same procedure as in Example 35 was repeated to obtain B₈=2.00 (T) and W_{17/50}=0.68 (W/kg).

### Example 38

A thin sheet of 350 »m thickness was made by directly cooling from molten steel comprising C: 0.028%, Si: 3.12%, Mn: 0.075%, S: 0.012%, sol Al: 0.019%, N: 0.0095%, with the balance being Fe and inevitable impurities. This thin sheet was immediately warm rolled to a thickness of 0.20 mm by heating to 550°C, and held at this temperature for 24 hours and cooled. Then, a steel sheet having a length of 150 mm and a width of 100 mm was cut out therefrom, heated from 200°C to 700°C at a rate of temperature of 20°C/h and subjected to decarburization annealing at 820°C in wet hydrogen for 3 minutes to obtain a treating material.

Then, the same procedure as in Example 35 was repeated to obtain B₈=2.01 (T) and W_{17/50}=0.65 (W/kg).

### Example 39

An ingot of silicon steel comprising C: 0.075%, Si: 2.85%, Mn: 0.065%, S: 0.014%, sol Al: 0.025%, N: 0.0087%, with the balance being Fe and inevitable impurities, was heated to 1350°C and hot rolled to a thickness of 1.6 mm. Then, the sheet was annealed at 1130°C for 2 minutes, cold rolled at a reduction of 60% in the same direction as in the hot rolling direction and then rolled in a direction perpendicular thereto to a thickness of 0.23 mm. Next, two square sheets having a length of 200 mm and a width of 150 mm were cut out therefrom and decarburized at 750°C in wet hydrogen for 1 hour (A1 and A2).

Two single crystal plates having the same composition as in the hot rolled sheet, thickness: 0.23 mm, length: 200 mm and width: 5 mm, in which the plate face was the (100) face and the lengthwise direction was the [001] orientation, were provided as B1 and B2.

Then, one-side end portion of the rolling face of A at a width of 5 mm in longitudinal direction and one-side of the full rolling face of B were finished to a mirror surface of Ra<0.1 »m by Emery polishing, chemical polishing and ion etching. Next, the mirrored surfaces of A1 and B1, as well as A2 and B2, were closed together and heated in N₂ having a dew point of -25°C by feeding into a temperature tilting furnace having a temperature gradient of 5°C/cm between 1150°C∼900°C, at a feeding rate of 10 mm/h, while a compressive stress: 8 g/mm² (0·078 MPa) was applied to the joint face in the case of A1 and B1, but was not applied in the case of A2 and B2. A was held at the low temperature side and B at the high temperature side.

After MgO was applied as a separator, the joined body was subjected to purification annealing at 1200°C in H₂ for 20 hours.

The magnetic properties of the thus obtained joined bodies were as follows.

**Table 16**

| | B₁₀ (T) | | W_{17/50} (W/kg) | |
|---|---|---|---|---|
| Presence or absence of load | presence | absence | presence | absence |
| Magnetization in the same direction as in hot rolling direction | 2.00 | 1.97 | 1.41 | 1.49 |
| Magnetization in direction perpendicular to hot rolling direction | 2.01 | 1.98 | 1.39 | 1.47 |

As seen from the above table, the magnetic properties in both the hot rolling direction and the direction perpendicular thereto were very good.

### Example 40

An ingot of silicon steel comprising C: 0.085%, Si: 3.00%, Mn: 0.080%, S: 0.015%, sol Al: 0.030%, N: 0.0085%, with the balance being Fe and inevitable impurities, was heated to 1350°C and hot rolled to a thickness of 0.35 mm. Then, two square sheets having a length of 150 mm and a width of 150 mm were cut out therefrom and decarburized at 750°C in wet hydrogen for 3 hours as A3 and A4.

Two single crystal plates having the same composition as in the hot rolled sheet, thickness: 0.35 mm, length: 150 mm and width: 5 mm, in which the plate face was the (100) face and the lengthwise direction was the [001] orientation, were provided as B3 and B4.

Then, one-side end portion of the rolling face of A at a width of 5 mm in longitudinal direction and one-side of the full rolling face of B were finished into a mirror surface of Ra<0.1 »m by Emery polishing, chemical polishing and ion etching. Next, the mirrored surfaces of A and B were closed together and heated from 900°C to 1200°C at a rate of temperature increase of 5°C/h under vacuum of 10⁻⁸ Torr (1·33 × 10⁻⁶ Pa). After MgO was applied as a separator, the joined body was subjected to purification annealing at 1200°C in H₂ for 20 hours and then the magnetic properties of A were measured to obtain the results shown in the following table.

**Table 17**

| | B₁₀ (T) | | W_{17/50} (W/kg) | |
|---|---|---|---|---|
| Presence or absence of load | presence | absence | presence | absence |
| Magnetization in the same direction as in hot rolling direction | 2.01 | 1.99 | 1.63 | 1.69 |
| Magnetization in direction perpendicular to hot rolling direction | 2.02 | 1.98 | 1.57 | 1.72 |

### Example 41

Three sets of A and B, polished into mirror surface in the same manner as in Example 39, were provided. After S, Sb or Cu of 0.5 »m had been formed on the mirrored surface of each set by ion coating, the coated surfaces of each set were closed together with each other and heated from 1000°C to 1200°C at a rate of temperature increase of 5°C/h in N₂. After MgO had been applied as a separator, the joined body was subjected to purification annealing at 1200°C in H₂ for 20 hours.

The magnetic properties of each A portion of the thus obtained joined bodies were as follows.

**Table 18**

| | Magnetization in the same direction as in hot rolling direction | | Magnetization in direction perpendicular to hot rolling direction | |
|---|---|---|---|---|
| | B₁₀ (T) | W_{17/50} (W/kg) | B₁₀ (T) | W_{17/50} (W/kg) |
| S coating | 2.01 | 1.62 | 2.00 | 1.60 |
| Sb coating | 2.00 | 1.65 | 2.01 | 1.59 |
| Cu coating | 2.02 | 1.60 | 2.00 | 1.63 |

As seen from the above table, the magnetic properties in both the hot rolling direction and the direction perpendicular thereto were very good.

### Example 42

An ingot of silicon steel having the same composition as in Example 39 was heated to 1350°C and hot rolled to a thickness of 0.35 mm. Then, two square sheets having a length of 200 mm and a width of 150 mm were cut out therefrom and decarburized at 750°C in wet hydrogen for 1 hour (A5 and A6).

Two single crystal plates having the same composition as in the above hot rolled sheet, thickness: 0.35 mm, length: 200 mm and width: 5 mm, in which the plate face was the (100) face and the lengthwise direction was the [001] orientation, were provided as B5 and B6.

Then, one-side end portion of the rolling face of A at a width of 5 mm in longitudinal direction and one-side of the full rolling face of B were finished to a mirror surface of Ra<0.1 »m by Emery polishing and chemical polishing. Next, after Sn of 0.5 »m had been formed on each mirrored surface by ion coating, the coated surfaces of A5 and B5, as well as A6 and B6, were closed together, and were heated in N₂ having a dew point of -10°C by feeding into a temperature tilting furnace having a temperature gradient of 5°C/cm between 1150°C∼900°C, at a feeding rate of 10 mm/h, while applying a compressive stress of 7 g/mm² (0·069 MPa) to the joint face in the case of A5 and B5, but not applying any stress in the case of A6 and B6. A was kept at the low temperature side and B at the high temperature side.

After MgO was applied as a separator, the joined body was subjected to purification annealing at 1200°C in H₂ for 20 hours. The measured magnetic properties are shown in the following table.

**Table 19**

| | B₁₀ (T) | | W_{17/50} (W/kg) | |
|---|---|---|---|---|
| Presence or absence of load | presence | absence | presence | absence |
| Magnetization in the same direction as in hot rolling direction | 2.03 | 1.99 | 1.55 | 1.63 |
| Magnetization in direction perpendicular to hot rolling direction | 2.02 | 2.00 | 1.60 | 1.61 |

Thus, the magnetic properties in both the hot rolling direction and the direction perpendicular thereto were very good.

### Example 43

An ingot of silicon steel comprising C: 0.025%, Si: 3.30%, Mn: 0.075%, S: 0.020%, sol Al: 0.020%, N: 0.0095%, with the balance being Fe and inevitable impurities, was heated to 1350°C and hot rolled to a thickness of 0.5 mm. Then, the sheet was subjected to decarburization annealing at 700°C in wet hydrogen for 3 hours. From the annealed sheet were cut out two square specimens having a length of 300 mm and a width of 35 mm, A having the lengthwise direction the same as in the hot rolling direction and B having the lengthwise direction perpendicular thereto.

Two single crystal plates having the same composition as in the above hot rolled sheet, thickness: 0.50 mm, length: 280 mm and width: 5 mm, in which the plate face was the (100), were provided as raw material C.

Then, sectional faces of A and B parallel to the lengthwise direction and perpendicular to the rolling face, as well as the (100) face of C perpendicular to the plate face, were finished to a mirror surface of Ra<0.2 »m by Emery polishing. After Sn of 0.5 »m in thickness had been deposited onto the treated surfaces, the Sn deposited surfaces as a set of A and C, B and C were closed with each other and joined by rubbing while supersonic wave was applied. Heating was effected in a dry N₂ atmosphere by feeding into a temperature tilting furnace having a temperature gradient of 5°C/cm between 1150°C∼850°C at a feeding rate of 10 mm/h, while applying a compressive stress of 10 g/mm² (0·098 MPa) to the joint face and holding A and B at the low temperature side and C at the high temperature side.

After MgO was applied as a separator, the joined body was subjected to purification annealing at 1200°C in H₂ for 20 hours to obtain the magnetic properties as shown in the following table.

**Table 20**

| | B₁₀ (T) | W_{17/50} (W/kg) |
|---|---|---|
| A-C | 2.02 | 1.95 |
| B-C | 2.00 | 1.88 |

Thus, the magnetic properties in both the hot rolling direction and the direction perpendicular thereto were very good.

### Example 44

An ingot of silicon steel having the same composition as in Example 43 was heated to 1350°C and hot rolled to a thickness of 1.15 mm. Then, the sheet was cold rolled at a reduction of 60% in the same direction as in the hot rolling direction, and further at a reduction of 50% in a direction perpendicular thereto to give a thickness of 0.23 mm.

Then, the sheet was subjected to decarburization annealing at 820°C in wet hydrogen for 10 minutes. From the annealed sheet were cut out two square specimens having a length of 300 mm and a width of 35 mm, D having the lengthwise direction the same as in the hot rolling direction and E having the lengthwise direction perpendicular thereto.

Two single crystal plates having the same composition as in the above hot rolled sheet, thickness: 0.23 mm, length: 280 mm and width: 5 mm, in which the plate face was the (100), were provided as raw material F.

Then, the same procedure as in Example 39 was repeated and the magnetic properties of the thus obtained joined bodies were measured to obtain the results shown in Table 21.

**Table 21**

| | B₁₀ (T) | W_{17/50} (W/kg) |
|---|---|---|
| D-F | 2.01 | 1.42 |
| E-F | 1.99 | 1.35 |

The magnetic properties in both the hot rolling direction and the direction perpendicular thereto were very good as in Example 39.

### Example 45

An ingot of silicon steel having the same composition as in Example 43 was heated to 1250°C and hot rolled to a thickness of 0.30 mm.

The magnetic properties of the joined body, obtained by repeating the same procedure as in Example 43, are shown in Table 22.

**Table 22**

| | B₁₀ (T) | W_{17/50} (W/kg) |
|---|---|---|
| A-C | 2.020 | 1.047 |
| B-C | 2.015 | 1.045 |

### Example 46

An ingot of silicon steel comprising C: 0.175%, Si: 3.0%, Mn: 0.040%, Se: 0.010%, sol Al: 0.055%, N: 0.0105%, with the balance being Fe and inevitable impurities, was heated to 1225°C and hot rolled to a thickness of 0.30 mm. Two square specimens were then cut out, each having a length of 300 mm and a width of 35 mm, A having the lengthwise direction the same as in the hot rolling direction and B having the lengthwise direction perpendicular thereto. These specimens were subjected to decarburization annealing at 750°C.

The magnetic properties of the joined body, obtained by repeating the same procedure as in Example 43, are shown in Table 23.

**Table 23**

| | B₁₀ (T) | W_{17/50} (W/kg) |
|---|---|---|
| A-C | 2.010 | 1.30 |
| B-C | 2.017 | 1.35 |

### Example 47

An ingot of silicon steel comprising C: 0.205%, Si: 4.2%, Mn: 0.050%, S: 0.012%, sol Al: 0.060%, N: 0.0110%, with the balance being Fe and inevitable impurities, was heated to 1225°C and hot rolled to a thickness of 0.35 mm.

The magnetic properties of the joined body, obtained by repeating the same procedure as in Example 43, are shown in Table 24.

**Table 24**

| | B₁₀ (T) | W_{17/50} (W/kg) |
|---|---|---|
| A-C | 1.967 | 1.42 |
| B-C | 1.970 | 1.47 |

### Example 48

An ingot of silicon steel having the same composition as in Example 43 was heated to 1325°C and hot rolled to a thickness of 1.15 mm. Then, the sheet was subjected to decarburization annealing at 725°C in wet hydrogen for 10 hours. Then, the sheet was cold rolled at a reduction of 60% in the same direction as in the hot rolling direction, and further at a reduction of 50% in a direction perpendicular thereto to give a thickness of 0.23 mm. Four square specimens of ℓ=150 mm and w=50 mm, having the lengthwise direction (ℓ) same as in the hot rolling direction (A1 and A2) and having the lengthwise direction perpendicular thereto (B1 and B2) were cut from the sheet. Only A2 and B2 were annealed at 800°C in dry H₂ for 2 minutes.

Four single crystal plates each comprising Si: 3.0%, with the balance being Fe and inevitable impurities, and having thickness: 0.23 mm, length: 150 mm and width: 5 mm, in which the plate face and the lengthwise direction were shifted by 2° from the (100) face and the [001] axis, respectively, were provided as C1, C2, C3 and C4.

Then, one-side end portions of the rolling faces of A1, A2, B1 and B2 at a width of 5 mm in longitudinal direction and one-side of the full rolling faces of C1, C2, C3 and C4 were finished to a mirror surface of Ra<0.1 »m by Emery polishing, chemical polishing and ion sputtering. After Sn of 1 »m had been formed onto the mirrored surfaces of C1, C2, C3 and C4 by ion coating, the mirrored surface and the coated surface of A1 and C1, A2 and C2, B1 and C3, and B2 and C4 were closed together so as to coincide in the lengthwise direction and heated in N₂ having a dew point of -10°C by feeding into a temperature tilting furnace having a temperature gradient of 5°C/cm between 1150°C∼900°C, while applying a compressive stress: 7 g/mm² (0·069 MPa) to the joint face and also applying a supersonic wave thereto. A and B were held at the low temperature side and C at the high temperature side.

After MgO was applied as a separator, the joined body was subjected to purification annealing at 1200°C in H₂ for 20 hours and a tension coating was applied thereto. The measured magnetic properties are shown in Table 25.

**Table 25**

| | B₁₀ (T) | W_{17/50} (W/kg) |
|---|---|---|
| A1-C1 | 2.015 | 0.84 |
| A2-C2 | 2.010 | 0.88 |
| B1-C3 | 2.013 | 0.85 |
| B2-C4 | 2.018 | 0.87 |

Thus, when decarburization was carried out before the rolling, even if decarburization annealing was omitted before the finish annealing or the annealing atmosphere was dry H₂, good magnetic properties were obtained. Furthermore, the considerable improvement of magnetic properties had been achieved by slightly shifting the (100) face from the rolling face.

### Example 49

An ingot of silicon steel comprising C: 0.005%, Si: 3.2%, Mn: 0.10%, S: 0.005%, N: 0.0080%, sol Al: 0.032%, with the balance being Fe and inevitable impurities, was heated to 1180°C and hot rolled to a thickness of 0.30 mm, from which were provided four square specimens of ℓ=150 mm and w=50 mm, having the lengthwise direction (ℓ) the same as in the hot rolling direction (A1 and A2), and having the lengthwise direction perpendicular thereto (B1 and B2). Only A2 and B2 were annealed at 850°C in dry H₂ for 1 minute.

Then, the same procedure as in Example 48 was repeated to obtain the following results.

**Table 26**

| | B₁₀ (T) | W_{17/50} (W/kg) |
|---|---|---|
| A1-C1 | 2.017 | 0.98 |
| A2-C2 | 2.015 | 1.02 |
| B1-C3 | 2.021 | 0.97 |
| B2-C4 | 2.018 | 1.01 |

### Example 50

An ingot of silicon steel comprising C: 0.004%, Si: 3.10%, Mn: 0.052%, S: 0.011%, N: 0.0085%, sol Al: 0.045%, with the balance being Fe and inevitable impurities, was heated to 1250°C and hot rolled to a thickness of 2.3 mm. Then, the sheet was annealed at 900°C in dry N₂ for 3 hours and subjected to a combination of cold rollings in the same direction as in the hot rolling direction and in a direction perpendicular thereto to give a thickness of 0.30 mm. Four square specimens of ℓ=150 mm and w=50 mm, having the lengthwise direction (ℓ) the same as in the hot rolling direction (A1 and A2), and having the lengthwise direction perpendicular thereto (B1 and B2), were then cut from the sheet. Only A2 and B2 were annealed at 975°C in dry H₂ for 1 minute.

Then, the same procedure as in Example 48 was repeated to obtain the following results.

**Table 27**

| | B₁₀ (T) | W_{17/50} (W/kg) |
|---|---|---|
| A1-C1 | 2.015 | 0.98 |
| A2-C2 | 2.025 | 0.97 |
| B1-C3 | 2.012 | 1.01 |
| B2-C4 | 2.027 | 0.96 |

### Example 51

An ingot of silicon steel comprising C: 0.040%, Si: 3.15%, Mn: 0.050%, S: 0.008%, N: 0.0095%, sol Al: 0.042%, with the balance being Fe and inevitable impurities, was heated to 1200°C and hot rolled to a thickness of 2.3 mm. Then, the sheet was subjected to decarburization annealing at 850°C in wet hydrogen for 10 minutes, and cold rolled to a thickness of 1.15 mm. Further, the sheet was annealed at 850°C in wet hydrogen for 10 minutes and subjected to a combination of cold rollings in the same direction as in the hot rolling direction, and in a direction perpendicular thereto to give a thickness of 0.2 mm. Four square specimens of ℓ=150 mm and w=50 mm, having the lengthwise direction (ℓ) the same as in the hot rolling direction as (A1 and A2), and having the lengthwise direction perpendicular thereto as (B1 and B2), were cut from the sheet. Only A2 and B2 were annealed at 950°C in dry H₂ for 1 minute.

Then, the same procedure as in Example 48 was repeated to obtain the following results.

**Table 28**

| | B₁₀ (T) | W_{17/50} (W/kg) |
|---|---|---|
| A1-C1 | 2.011 | 0.79 |
| A2-C2 | 2.022 | 0.77 |
| B1-C3 | 2.013 | 0.76 |
| B2-C4 | 2.025 | 0.75 |

### Example 52

An ingot of silicon steel comprising C: 0.018%, Si: 3.25%, Mn: 0.065%, S: 0.013%, sol Al: 0.018%, N: 0.0085%, with the balance being Fe and inevitable impurities, was heated to 1350°C and hot rolled to a thickness of 0.35 mm. Then, a square sheet having a length of 150 mm and a width of 150 mm was cut out therefrom as a treating material.

A single crystal plate having the same composition as in the above hot rolled sheet, thickness: 0.30 mm, length: 150 mm and width: 5 mm, in which the plate face was the (100) face and the lengthwise direction was the [001] axis, was provided as a seed material.

Then, one-side end portion of the rolling face of the treating material at a width of 5 mm and one-side of the full rolling face of the seed material were finished to a mirror surface of Ra<0.1 »m by Emery polishing, chemical polishing and ion etching. Next, the mirrored surfaces of the treating material and the seed material were brought together and heated from 900°C to 1200°C at a rate of temperature increase of 5°C/h under vacuum of 10⁻⁸ Torr (1·33 × 10⁻⁶ Pa) while applying a supersonic wave. After MgO had been applied as a separator, the joined body was subjected to purification annealing at 1200°C in H₂ for 20 hours and the magnetic properties of the treating material were measured to give the results shown in the following table.

**Table 29**

| Magnetization direction | B₁₀ (T) | W_{17/50} (W/kg) |
|---|---|---|
| Hot rolling direction | 2.01 | 1.62 |
| Direction perpendicular to hot rolling | 2.01 | 1.58 |

### Example 53

An ingot of silicon steel having the same composition as in Example 52 was heated to 1350°C and hot rolled to a thickness of 2.2 mm. Then, the sheet was cold rolled at a reduction of 60% in the same direction as in the hot rolling direction, and further rolled in a direction perpendicular thereto to obtain a sheet with a thickness of 0.23 mm. Next, a square sheet having a length of 150 mm and a width of 150 mm was cut out therefrom as a treating material.

The magnetic properties of the treating material obtained by repeating the same procedure as in Example 52 are shown in the following table.

**Table 30**

| Magnetization direction | B₁₀ (T) | W_{17/50} (W/kg) |
|---|---|---|
| Hot rolling direction | 2.01 | 1.40 |
| Direction perpendicular to hot rolling | 2.00 | 1.38 |

### Example 54

An ingot of silicon steel having the same composition as in Example 52 was heated to 1200°C and hot rolled to a thickness of 0.35 mm. Then, a square sheet having a length of 150 mm and a width of 150 mm was cut out therefrom as a treating material.

The magnetic properties of the treating material obtained by repeating the same procedure as in Example 52 are shown in the following table.

**Table 31**

| Magnetization direction | B₁₀ (T) | W_{17/50} (W/kg) |
|---|---|---|
| Hot rolling direction | 2.00 | 1.61 |
| Direction perpendicular to hot rolling | 2.01 | 1.59 |

### Example 55

An ingot of silicon steel comprising C: 0.005%, Si: 3.00%, Mn: 0.045%, S: 0.011%, sol Al: 0.015%, N: 0.0080%, with the balance being Fe and inevitable impurities, was heated to 1220°C and hot rolled to a thickness of 2.2 mm. Then, the sheet was cold rolled at a reduction of 60% in the same direction as in the hot rolling direction, and further rolled in a direction perpendicular thereto to obtain a sheet having a thickness of 0.23 mm. Next, a square sheet having a length of 150 mm and a width of 150 mm was cut out therefrom as a treating material.

The magnetic properties of the treating material obtained by repeating the same procedure as in Example 52 are shown in the following table.

**Table 32**

| Magnetization direction | B₁₀ (T) | W_{17/50} (W/kg) |
|---|---|---|
| Hot rolling direction | 2.00 | 1.41 |
| Direction perpendicular to hot rolling | 2.01 | 1.37 |

### Example 56

An ingot of silicon steel comprising C: 0.075%, Si: 3.25%, Mn: 0.042%, S: 0.013%, sol Al: 0.017%, N: 0.0088%, with the balance being Fe and inevitable impurities, was heated to 1225°C and hot rolled to a thickness of 0.35 mm. Then, a square sheet having a length of 150 mm and a width of 150 mm was cut out therefrom and decarburized at 750°C in a wet hydrogen atmosphere for 3 hours as a treating material.

The magnetic properties of the treating material obtained by repeating the same procedure as in Example 52 are shown in the following table.

**Table 33**

| Magnetization direction | B₁₀ (T) | W_{17/50} (W/kg) |
|---|---|---|
| Hot rolling direction | 2.01 | 1.60 |
| Direction perpendicular to hot rolling | 2.01 | 1.62 |

### Example 57

An ingot of silicon steel having the same composition as in Example 56 was heated to 1225°C and hot rolled to a thickness of 2.2 mm. Then, the sheet was cold rolled at a reduction of 60% in the same direction as in the hot rolling direction, and further rolled in a direction perpendicular thereto to obtain a sheet having a thickness of 0.23 mm. Next, a square sheet having a length of 150 mm and a width of 150 mm was cut out therefrom, heated from 200°C to 700°C at a rate of 50°C/h and decarburized at 750°C in a wet hydrogen atmosphere for 1 hour as a treating material.

The magnetic properties of the treating material obtained by repeating the same procedure as in Example 52 are shown in the following table.

**Table 34**

| Magnetization direction | B₁₀ (T) | W_{17/50} (W/kg) |
|---|---|---|
| Hot rolling direction | 2.00 | 1.39 |
| Direction perpendicular to hot rolling | 1.99 | 1.41 |

### Example 58

An ingot of silicon steel having the same composition as in Example 56 was heated to 1225°C and hot rolled to a thickness of 1.15 mm. Then, the sheet was subjected to decarburization annealing at 750°C in wet hydrogen for 5 hours. It was then cold rolled at a reduction of 60% in the same direction as in the hot rolling direction, and further rolled in a direction perpendicular thereto to obtain a sheet having a thickness of 0.23 mm. Next, a square sheet having a length of 150 mm and a width of 150 mm was cut out therefrom as a treating material.

The magnetic properties of the treating material obtained by repeating the same procedure as in Example 52 are shown in the following table.

**Table 35**

| Magnetization direction | B₁₀ (T) | W_{17/50} (W/kg) |
|---|---|---|
| Hot rolling direction | 2.01 | 1.40 |
| Direction perpendicular to hot rolling | 2.00 | 1.41 |

### Example 59

An ingot of silicon steel comprising C: 0.024%, Si: 3.10%, Mn: 0.072%, S: 0.015%, sol Al: 0.022%, N: 0.0079%, with the balance being Fe and inevitable impurities, was heated to 1350°C and hot rolled to a thickness of 0.34 mm. Then, a square sheet having a length of 150 mm and a width of 150 mm was cut out therefrom as a treating material.

Alternatively, a single crystal plate comprising Si: 3.0%, with the balance being Fe and inevitable impurities, and having thickness: 0.23 mm, length: 150 mm and width: 5 mm, in which the plate face was the (100) face and the lengthwise direction was the [001] axis, was provided as a seed material.

Then, one-side end portion of the rolling face of the treating material at a width of 5 mm in the lengthwise direction and one-side of the full rolling face of the seed material were finished to a mirror surface of Ra<0.1 »m by grinding and polishing. After In of 2 »m in thickness had been plated onto the mirror surface of the seed material, the plated surface brought together with the mirror surface of the treating material so as to coincide in the lengthwise directions, and joined by heating in dry N₂ through the application of supersonic wave while a compressive load: 7 g/mm² (0·069 MPa) was applied to the joint face.

After Al₂O₃ containing 15% of SrSO₄ had been applied as a separator, the joined body was heated in dry N₂ by feeding into a temperature tilting furnace having a temperature gradient of 5°C/cm between 1150∼900°C at a feeding rate of 10 mm/h while holding the treating material at the low temperature side and the seed material at the high temperature side.

Then, it was subjected to purification annealing at 1200°C in H₂ for 20 hours and a tension coating was applied thereto. The magnetic properties were then measured to give the results shown in the following table.

**Table 36**

| Magnetization direction | B₁₀ (T) | W_{17/50} (W/kg) |
|---|---|---|
| Hot rolling direction | 2.01 | 1.10 |
| Direction perpendicular to hot rolling | 2.00 | 1.15 |

### Example 60

An ingot of silicon steel having the same composition as in Example 59 was heated at 1350°C and hot rolled to a thickness of 2.2 mm. Then, the sheet was cold rolled at a reduction of 60% in the same direction as in the hot rolling direction and further rolled in a direction perpendicular thereto to a thickness of 0.22 mm. Next, a square sheet having a length of 150 mm and a width of 150 mm was cut out therefrom as a treating material.

The procedure of Example 59 was then repeated to give the following results.

**Table 37**

| Magnetization direction | B₁₀ (T) | W_{17/50} (W/kg) |
|---|---|---|
| Hot rolling direction | 2.00 | 0.90 |
| Direction perpendicular to hot rolling | 1.99 | 0.95 |

### Example 61

An ingot of silicon steel comprising C: 0.005%, Si: 3.25%, Mn: 0.075%, S: 0.013%, sol Al: 0.015%, N: 0.0085%, with the balance being Fe and inevitable impurities, was heated to 1225°C and hot rolled to a thickness of 2.2 mm. Then, the sheet was cold rolled at a reduction of 60% in the same direction as in the hot rolling direction and further rolled in a direction perpendicular thereto to a thickness of 0.22 mm. Then, a square sheet having a length of 150 mm and a width of 150 mm was cut out therefrom as a treating material.

Alternatively, a single crystal plate comprising Si: 3.0%, with the balance being Fe and inevitable impurities, and having thickness: 0.22 mm, length: 150 mm and width: 5 mm, in which the plate face was the (100) face and the lengthwise direction was the [001] axis, was provided as a seed material.

Then, one-side end portion of rolling face of the treating material at a width of 5 mm in lengthwise direction was thoroughly degreased and cleaned in a strong alkali solution through the application of a supersonic wave. Alternatively, one-side of the full surface of the seed material was finished to a mirror surface of Ra<0.1 »m by grinding and polishing. Then, In of 1 »m was plated onto the mirror surface of the seed material, while Sn of 1 »m in thickness was plated onto the cleaned surface of the treating material. These plated surfaces were closed together by rubbing so as to coincide the lengthwise directions, and joined by heating in dry N₂ through the application of supersonic wave while applying a compressive stress: 100 g/mm² (0·98 MPa) to the joint face.

Then, the joined body was coated with an annealing separator and heated in dry N₂ by feeding into a temperature tilting furnace having a temperature gradient of 5°C/cm between 1150∼900°C at a feeding rate of 10 mm/h, while holding the treating material at the low temperature side and the seed material at the high temperature side.

Next, it was subjected to purification annealing at 1200°C in H₂ for 20 hours and a tension coating was applied thereto. The magnetic properties were then measured to give the results shown in the following table.

**Table 38**

| Magnetization direction | B₁₀ (T) | W_{17/50} (W/kg) |
|---|---|---|
| Hot rolling direction | 2.01 | 1.15 |
| Direction perpendicular to hot rolling | 2.00 | 1.13 |

### Example 62

An ingot of silicon steel comprising C: 0.045%, Si: 3.17%, Mn: 0.074%, S: 0.014%, sol Al: 0.020%, N: 0.0081%, with the balance being Fe and inevitable impurities, was heated to 1225°C and hot rolled to a thickness of 2.2 mm. Then, the sheet was subjected to decarburization annealing at 750°C in wet hydrogen for 3 hours, cold rolled at a reduction of 60% in the same direction as in the hot rolling direction, and further rolled in a direction perpendicular thereto to obtain a sheet having a thickness of 0.22 mm. Then, a square sheet having a length of 150 mm and a width of 150 mm was cut out therefrom, heated from 200°C to 700°C at a rate of temperature increase of 20°C/h and then subjected to decarburization annealing at 820°C in wet hydrogen for 3 minutes as a treating material.

Alternatively, a single crystal plate comprising Si: 3.0%, with the balance being Fe and inevitable impurities, and having thickness: 0.22 mm, length: 150 mm and width: 5 mm, in which the plate face was the (100) face and the lengthwise direction was the [001] axis, was provided as a seed material.

Then, one-side end portion of the rolling face of the treating material at a width of 5 mm in lengthwise direction, and one full side of the surface of the seed material were finished to a mirror surface of Ra<0.1 »m by grinding and polishing. Next, In of 1 »m thickness and Sn of 1 »m thickness were plated onto the mirror surface of the seed material and the cleaned surface of the treating material, respectively. These plated surfaces were closed together by rubbing so as to coincide the lengthwise directions, and were joined by heating in dry N₂ by the application of supersonic wave while applying a compressive stress: 7 g/mm² (0·069 MPa) to the joint face.

After MgO containing 1.7% of SrSO₄ had been applied as a separator, the joined body was heated in dry N₂ by feeding into a temperature tilting furnace having a temperature gradient of 1°C/cm between 1150∼900°C at a feeding rate of 5 mm/h, while holding the treating material at the low temperature side and the seed material at the high temperature side.

Then, it was subjected to purification annealing at 1200°C in H₂ for 20 hours and a tension coating was applied thereto. The magnetic properties were measured to obtain the results shown in the following table.

**Table 39**

| Magnetization direction | B₁₀ (T) | W_{17/50} (W/kg) |
|---|---|---|
| Hot rolling direction | 2.00 | 1.08 |
| Direction perpendicular to hot rolling | 1.99 | 1.11 |

### Example 63

Molten steel comprising C: 0.0085%, Si: 3.17%, Mn: 0.070%, S: 0.008%, sol Al: 0.017%, N: 0.0082%, with the balance being Fe and inevitable impurities, was slantly cast to a thickness of 150 mm from 1600°C in a water-cooled copper mold, quenched to 1150°C, held at this temperature for 5 minutes and immediately hot rolled to a thickness of 2.5 mm.

Then, the sheet was cold rolled at a reduction of 60% in the same direction as in the hot rolling direction and further rolled in a direction perpendicular thereto to obtain a thickness of 0.22 mm. Next, a square sheet having a length of 150 mm and a width of 150 mm was cut out therefrom, heated from 200°C to 700°C at a temperature rising rate of 20°C/h and then subjected to decarburization annealing at 820°C in wet hydrogen for 5 minutes as a treating material.

Then, the same procedure as in Example 61 was repeated to obtain the following results.

**Table 40**

| Magnetization direction | B₁₀ (T) | W_{17/50} (W/kg) |
|---|---|---|
| Hot rolling direction | 2.01 | 1.12 |
| Direction perpendicular to hot rolling | 2.01 | 1.15 |

### Example 64

Molten steel having the same composition as in Example 63 was cast to a thickness of 25 mm from 1600°C in a horizontal thin slab casting machine, quenched to 950°C, held at this temperature for 3 minutes and immediately hot rolled to a thickness of 0.35 mm, which was held at 550°C for 24 hours and cooled. Then, a square sheet having a length of 150 mm and a width of 150 mm was cut out therefrom and subjected to decarburization annealing at 750°C for 1 hour as a treating material.

Then, the same procedure as in Example 61 was repeated to obtain the results shown in the following table.

**Table 41**

| Magnetization direction | B₁₀ (T) | W_{17/50} (W/kg) |
|---|---|---|
| Hot rolling direction | 2.00 | 1.61 |
| Direction perpendicular to hot rolling | 2.01 | 1.55 |

### Example 65

Molten steel having the same composition as in Example 63 was slantly cast to a thickness of 5 mm from 1600°C in a water-cooled copper mold, quenched to 600°C and immediately warm rolled to a thickness of 0.22 mm. Then, a square sheet having a length of 150 mm and a width of 150 mm was cut out therefrom, heated from 200°C to 700°C at a rate of temperature increase of 20°C/h and then subjected to decarburization annealing at 820°C in wet hydrogen for 5 minutes as a treating material.

Then, the same procedure as in Example 61 was repeated to obtain the following results.

**Table 42**

| Magnetization direction | B₁₀ (T) | W_{17/50} (W/kg) |
|---|---|---|
| Hot rolling direction | 2.00 | 1.13 |
| Direction perpendicular to hot rolling | 2.01 | 1.14 |

### Example 66

A thin ribbon of 3500 »m in thickness was made by direct quenching from molten steel comprising C: 0.025%, Si: 3.5%, Mn: 0.072%, S: 0.009%, sol Al: 0.017%, N: 0.0085%, with the balance being Fe and inevitable impurities. This thin ribbon was warm rolled to a thickness of 0.20 mm while heating to 550°C, which was held for 24 hours and cooled. Then, a square sheet having a length of 150 mm and a width of 150 mm was cut out therefrom, heated from 200°C to 700°C at a rate of temperature increase of 20°C/h and then subjected to decarburization annealing at 820°C in wet hydrogen for 3 minutes as a treating material.

Then, the same procedure as in Example 61 was repeated to obtain the following results.

**Table 43**

| Magnetization direction | B₁₀ (T) | W_{17/50} (W/kg) |
|---|---|---|
| Hot rolling direction | 2.00 | 1.10 |
| Direction perpendicular to hot rolling | 2.01 | 1.11 |

### Example 67

An ingot of silicon steel comprising C: 0.065%, Si: 3.25%, Mn: 0.070%, S: 0.018%, P: 0.0080%, sol Al: 0.035%, N: 0.0080%, with the balance being Fe and inevitable impurities, was heated to 1350°C, hot rolled to a thickness of 1.9 mm, cold rolled to a thickness of 0.20 mm, heated from 200°C to 700°C at a temperature rising rate of 20°C/h and then subjected to decarburization annealing at 820°C in wet hydrogen for 5 minutes. After an annealing separator of MgO containing 15% of SrSO₄ had been applied to the thus obtained steel sheet, three coils having a thickness of 10 mm, a diameter of 550 mm, 700 mm, 1000 mm and a width of 100 mm were prepared as treating materials A, B, C.

In these treating materials, 0·5 mm of the edge portion of the coil was removed in widthwise direction from the steel sheet by grinding in a direction perpendicular to the rolling face, and finished to a clean mirror surface of Ra<0.2 »m by polishing and sputtering.

Alternatively, a surface of a single crystal plate comprising Si: 3.0%, with the balance being Fe and inevitable impurities, and having length: 10 mm, width of 5 mm and thickness of 0.2 mm, in which the (110) face was parallel to the plate face and the lengthwise direction was the [110] orientation, was finished to a clean mirror surface of Ra<0.2 »m by polishing and argon sputtering; this was seed material D.

Then, the seed material D was closely joined to the polished surfaces of A, B, C, respectively, at an interval of 20 mm so that the lengthwise direction of the seed material was directed toward the center of the coil in the treating materials A, B, C, and then annealed in a vacuum furnace of 10⁻⁴ Torr (1·33 × 10⁻² Pa) at 980°C for 24 hours while applying a compressive stress of 10 g/mm² (0·098 MPa) to the joint face. After the flattening annealing at 800°C for 3 hours, the crystal structures of the treating materials A, B, C were examined, from which it was confirmed that the seed material D had grown into all of the treating materials.

In this case, the magnetic flux density B₁₀ at a magnetization force of 1000 A/m was as follows.

| | B₁₀ (T) |
|---|---|
| A | 1.95 |
| B | 1.98 |
| C | 2.01 |

As seen from the above table, the larger the coil diameter, the easier the magnetization and the smaller the shift in orientation from the rolling face.

### Example 68

When the treating material C and the seed material D in Example 67 were closely joined with each other in the same manner as in Example 67, D was arranged at an interval of 10 mm, 40 mm, 80 mm to obtain treating materials C-1, C-2, C-3. Then, these materials were treated in the same manner as in Example 67 in the case of X, and in the same manner as in Example 67 except that the annealing atmosphere was N₂ having a dew point of -30°C in the case of Y.

When the crystal structure of each of the thus obtained coils was examined, it was observed in the case of X that the seed material D grew in the treating material, but the growth was partly observed in the case of Y.

The B₁₀ value of each coil was as follows.

| | B₁₀ (T) | |
|---|---|---|
| | X | Y |
| C-1 | 2.03 | 1.92 |
| C-2 | 1.98 | 1.91 |
| C-3 | 1.93 | 1.90 |

The B₁₀ value is high in the case of X since the atmosphere is a vacuum and the joint face is in an activated state, as compared with the case of Y that in which the atmosphere is oxidizable and the joint face is in an inactivated state. Further, as the planting interval of the seed material becomes shorter, the B₁₀ value becomes higher, which shows that the magnetization is easy and the shifting of orientation from the rolling face is smaller.

### Example 69

B1, B2 were materials before and after annealing of the treating material B used in Example 67, respectively, the edge portions of whose coils were finished to a clean mirror surface in the same manner as in Example 67. Then, the coils B1 and B2 were piled one upon the other so as to close the mirrored surfaces together with each other. Heating was effected by feeding into a temperature tilting furnace having a temperature gradient of 5°C/cm between 1150°C∼900°C at a feeding rate of 10 mm/h while holding B1 at the low temperature side and B2 at the high temperature side. Moreover, the inside of the furnace was maintained under vacuum of 10⁻⁴ Torr (1·33 × 10⁻² Pa).

After flattening annealing at 800°C for 3 hours, the B₁₀ value of B1 was measured as B₁₀=1.99∼1.98 (T). By continuously planting the seed in the circumferential direction of the coil, the high B₁₀ value equal to that of the seed material B2 was obtained at about the self-weight of the seed material B2 without particularly applying stress.

### Example 70

Three sets of the treating materials B1, B2 used in Example 69 were provided. After Sn, Sb, Cu had been deposited onto the cleaned mirror surfaces of each set at a thickness of 1 »m by sputtering each of the set, the coils were piled one upon the other so as to close the deposited surfaces together with each other for every one of the set and joined by heating through the application of supersonic wave. The heating was performed in N₂ having a dew point of -30°C by feeding into a temperature tilting furnace having a temperature gradient of 5°C/cm between 1150°C∼900°C while holding B2 at the high temperature side.

After flattening annealing at 800°C for 3 hours, the B₁₀ value of B2 of each set was measured to obtain the following results.

| | B₁₀ (T) |
|---|---|
| Sn coating | 1.98∼1.99 |
| Sb coating | 1.97∼1.99 |
| Cu coating | 1.96∼1.98 |

By joining through the interposition of the insert member, good results equal to that of the seed material B1 were obtained even when the annealing was carried out in an oxidizing atmosphere.

### Example 71

An ingot of iron alloy comprising C: 0.035%, Al: 3.00%, Mn: 0.065%, Se: 0.020%, P: 0.008%, with the balance being Fe and inevitable impurities, was heated to 1350°C, hot rolled to a thickness of 2.3 mm and then subjected to two-times cold rolling through intermediate annealing to a thickness of 0.20 mm. Then, the sheet was subjected to decarburization and primary recrystallization annealing at 820°C in wet hydrogen for 5 minutes, coated with an annealing separator and wound into a coil having a thickness of 10 mm, a diameter of 700 mm and a width of 100 mm as a treating material E. After the coil edge portion had been finished to a clean mirror surface in the same manner as in Example 67, Sn was deposited at a thickness of 1 »m by sputtering, and the resulting coil edge portion was closed together with the deposited surface of the seed material B2 in Example 70 having Sn of 1 »m in thickness, and piled one upon the other and treated in the same manner as in Example 70.

After flattening annealing at 800°C for 3 hours, the orientations of crystal grains in the treating material E and the seed material B2 were measured, and as a result, the shifting of the orientation from (100)[001] in both was 3° on average, and the orientation of the seed material was well transferred to the treating material.

### Example 72

An ingot of silicon steel comprising C: 0.059%, Si: 3.35%, Mn: 0.065%, S: 0.015%, sol Al: 0.025%, N: 0.0095%, with the balance being Fe and inevitable impurities, was heated to 1350°C, hot rolled to a thickness of 2.2 mm, cold rolled to a thickness of 0.20 mm, heated from 200°C to 700°C at a rate of temperature increase of 20°C/h and subjected to decarburization annealing at 820°C in wet hydrogen for 3 minutes. After MgO containing 15% of SrSO₄ had been applied to the thus obtained steel sheet as an annealing separator, a coil having a thickness of 10 mm, a diameter of 550 mm and a width of 1000 mm was prepared as a treating material.

After 0·5 mm of the coil edge portion of the treating material had been removed in the widthwise direction of the steel sheet by polishing in a direction perpendicular to the rolling face, it was finished to a mirror surface of Ra<0.2 »m by polishing.

Alternatively, a surface of plate-like single crystal comprising Si: 3.0%, with the balance being Fe and inevitable impurities, and having length: 10 mm, width: 5 mm and thickness: 0.2 mm, in which the (110) face was parallel to the plate face and the lengthwise direction was the [110] orientation, was finished to a clean mirror surface of Ra<0.2 »m by grinding and polishing. It was then coated with Sn of 1 »m in thickness by plating to obtain a seed material.

Then, the plated surface of the seed material was closed together with the polished surface of the treating material at an interval of 20 mm, so that the seed material was directed toward the center of the coil of the treating material, and joined by heating through the application of supersonic wave of 60 kHz while applying a compressive stress of 10 g/mm² (0·098 MPa) to the joint face.

Next, the joined body was placed in a usual box furnace and heated to 1200°C at a rate of temperature increase of 20°C/h in N₂ while applying a compressive stress of 3 g/mm² (0·029 MPa) to the joint face. After flattening annealing at 800°C for 3 hours, the crystal structure of the treating material was measured, from which it was confirmed that the seed material had grown into the treating material.

In this case, the magnetic flux density B₁₀ value at a magnetization force of 1000 A/m was B₁₀=1.97 (T).

### Example 73

When the treating material and seed material in Example 72 were joined in the same manner as in Example 72, the joining was carried out under vacuum of 10⁻³ Torr (0·133 Pa). After the annealing to 1100°C in N₂ under atmospheric pressure, the heating was again carried out to 1200°C under vacuum of 10⁻³ Torr (0·133 Pa).

After flattening annealing at 800°C for 3 hours, the crystal structure of the treating material was measured, from which it was confirmed that the seed material had grown into the treating material.

In this case, the magnetic flux density B₁₀ value at a magnetization force of 1000 A/m was B₁₀=1.98 (T).

### Example 74

An ingot of silicon steel comprising C: 0.020%, Mn: 0.075%, S: 0.016%, sol Al: 0.021%, N: 0.0090%, with the balance being Fe and inevitable impurities, was heated to 1250°C, hot rolled to a thickness of 2.2 mm, cold rolled to a thickness of 0.22 mm, heated from 200°C to 700°C at a rate of temperature increase of 20°C/h. It was then subjected to decarburization annealing at 850°C in wet hydrogen for 5 minutes. The thus obtained steel sheet was subjected to skin-pass rolling to introduce 2% plastic strain thereinto. After MgO containing 15% of SrSO₄ had been applied to the steel sheet as an annealing separator, a coil having a thickness of 10 mm, a diameter of 550 mm and a width of 1000 mm was prepared as a treating material.

After 0·5 mm of the coil edge portion of the treating material had been removed in the widthwise direction of the steel sheet by grinding in a direction perpendicular to the rolling face, it was finished to a clean mirror surface of Ra<0.2 »m by polishing.

Alternatively, a surface of plate-like single crystal comprising Si: 2.0%, with the balance being Fe and inevitable impurities, and having length: 10 mm, width: 5 mm and thickness: 0.2 mm, in which the (110) face was parallel to the plate face and the lengthwise direction was the [110] orientation, was finished to a clean mirror surface of Ra<0.2 »m by grinding and polishing and then coated with Sn of 1 »m in thickness by plating to obtain a seed material.

Then, the plated surface of the seed material was closed together with the polished surface of the treating material at an interval of 20 mm, so that the seed material was directed toward the center of the coil of the treating material, and joined by heating through the application of supersonic wave of 60 kHz while applying a compressive stress of 10 g/mm² (0·098 MPa) to the joint face.

Next, the joined body was placed in a usual box furnace and heated in N₂ at a maximum temperature not exceeding 910°C while applying a compressive stress of 3 g/mm² (0·029 MPa) to the joint face. After flattening annealing at 800°C for 3 hours, the crystal structure of the treating material was measured, from which it was confirmed that the seed material had grown into the treating material.

In this case, the magnetic flux density B₁₀ value at a magnetization force of 1000 A/m was B₁₀=2.13 (T).

### Example 75

Molten steel comprising C: 0.058%, Si: 3.15%, Mn: 0.075%, S: 0.015%, sol Al: 0.025%, N: 0.0075%, with the balance being Fe and inevitable impurities, was slantly cast to a thickness of 150 mm from 1600°C in a water-cooled copper mold, quenched to 1150°C, held at this temperature for 5 minutes and immediately hot rolled to a thickness of 2.5 mm. Then, the sheet was cold rolled to a thickness of 0.22 mm and heated in Ar from 200°C to 700°C at a rate of temperature increase of 20°C/h. Next, the sheet was subjected to decarburization annealing at 820°C in wet hydrogen for 3 minutes and coated with MgO annealing separator containing MgSO₄: 1.7%, from which a coil having a thickness of 10 mm, an inner diameter of 550 mm and a width of 1000 mm was prepared as a treating material.

After 0·5 mm of the coil edge portion of the treating material had been removed in the widthwise direction of the steel sheet by grinding in a direction perpendicular to the rolling face, it was finished to a clean mirror surface of Ra<0.2 »m by polishing.

On the other hand, a surface of plate-like single crystal comprising Si: 3.0%, with the balance being Fe and inevitable impurities, and having length: 10 mm, width: 5 mm and thickness: 0.2 mm, in which the (110) face was parallel to the plate face and the lengthwise direction was the [001] orientation, was finished to a clean mirror surface of Ra<0.2 »m by grinding and polishing and then coated with Sn of 2 »m in thickness by plating to obtain a seed material.

Then, the plated surface of the seed material was closely joined with the polished surface of the treating material at an interval of 20 mm, so that the seed material was directed toward the center of the coil of the treating material, and heated through the application of supersonic wave while applying a compressive stress of 10 g/mm² (0·098 MPa) to the joint face. The heating was carried out by supplying heat to the side end portion of the seed materials and raising the temperature at a rate of 20°C/h, whereby the temperature at an end portion opposite to the seed material was raised to 1100°C.

Next, both the end portions were subjected to purification annealing at 1200°C in hydrogen for 20 hours. The average magnetic property in the widthwise direction of the obtained coil was B₈=2.00 (T).

### Example 76

Molten steel having the same composition as in Example 75 was cast to a thickness of 25 mm from 1600°C in a horizontal thin slab casting machine, quenched to 950°C, held for 3 minutes and immediately hot rolled to a thickness of 0.35 mm, which was held at 550°C for 24 hours and cooled. Then, the steel sheet was subjected to decarburization annealing at 820°C in wet hydrogen for 5 minutes and coated with MgO annealing separator containing SrSO₄: 1.7%. A coil having a thickness of 10 mm, an inner diameter of 550 mm and a width of 100 mm was prepared therefrom as a treating material.

After 0·5 mm of the coil edge portion of the treating material had been removed in the widthwise direction of the steel sheet by grinding in a direction perpendicular to the rolling face, it was finished to a clean mirror surface of Ra<0.2 »m by polishing.

Alternatively, a surface of plate-like single crystal comprising Si: 3.0%, with the balance being Fe and inevitable impurities, and having length: 10 mm, width: 5 mm and thickness: 0.2 mm, in which the (100) face was parallel to the plate face and the lengthwise direction was the [001] orientation, was finished into a clean mirror surface of Ra<0.2 »m by grinding and polishing and then coated with In of 2 »m in thickness by plating to obtain a seed material.

The average magnetic properties in the widthwise direction of the coil obtained by the same procedure as in Example 75 were; magnetization property in the hot rolling direction B₈=2.00 (T) and magnetization property in a direction perpendicular to the hot rolling direction B₈=2.01 (T).

### Example 77

Molten steel having the same composition as in Example 75 was slantly cast to a thickness of 5 mm from 1600°C in a water-cooled copper mold, quenched to 600°C and immediately warm rolled to a thickness of 0.22 mm. Then, the sheet was heated in Ar from 200°C to 700°C at rate of temperature increase of 20°C/h and subjected to decarburization annealing at 820°C in wet hydrogen for 3 minutes and coated with MgO annealing separator containing 4% of ferromanganese nitride. A coil having a thickness of 10 mm, an inner diameter of 550 mm and a width of 100 mm was prepared therefrom as a treating material.

The average magnetic property in the widthwise direction of the coil obtained by the same procedure as in Example 75 was B₈=2.00 (T).

### Example 78

A thin ribbon of 350 »m in thickness was made by direct quenching from molten steel comprising C: 0.005%, Si: 4.5%, Mn: 0.080%, S: 0.012%, sol Al: 0.015%, N: 0.0080%, with the balance being Fe and inevitable impurities. The thin ribbon was warm rolled to a thickness of 0.20 mm while heating to 550°C, which was held at 550°C for 24 hours and cooled. Then, the steel sheet was subjected to decarburization annealing at 820°C in wet hydrogen for 3 minutes and coated with MgO annealing separator. A coil having a thickness of 10 mm, an inner diameter of 550 mm and a width of 100 mm was prepared therefrom as a treating material.

The average magnetic properties in the widthwise direction of the coil obtained by the same procedure as in Example 68 were; magnetization property in the hot rolling direction B₈=2.01 (T) and magnetization property in a direction perpendicular to the hot rolling direction B₈=1.90 (T).

### INDUSTRIAL APPLICABILITY

Using the invention, not only is strict control to particular orientation possible, but also mass production of crystal bodies having such orientation is possible. Hence the invention largely contributes to an improvement in the properties of the product and to an improvement in the yield. For example, in grain oriented electromagnetic steel sheets and bidirectional oriented electromagnetic steel sheets, the magnetic flux density can be greatly improved, and particularly the 〈111〉 axis as a poor magnetization axis is not included in the rolling face of the bidirectional oriented electromagnetic steel sheet. Hence, such sheets are useful as an iron core for rotating bodies and magnetization at the corner portion of transformers is easy, which contributes to energy-saving.

Furthermore, according to the invention, the crystalline orientation of the coil unit can be controlled, so that not only the strict control of crystalline orientation but also the practical mass production in industry, which have never been established in the conventional technique, are possible. Thus the invention contributes greatly to the stable improvement of properties depending upon the crystalline orientation and the stable supplement of good products.

Moreover, the invention contributes to basic studies on the orientation dependency of properties because crystal bodies of particular orientation are easily obtained. Hence it is considered that the invention largely contributes to the development of studies.

## Claims

1. A method of producing crystal bodies having a controlled crystalline orientation, wherein a seed material which has a crystal structure the same as that of a treating material and a predetermined crystalline orientation and which is in a lower energy state than that of the treating material is joined to the treating material, wherein either the faces of the seed material and the treating material which are to be joined have been activated or an insert member which has a melting point lower than those of the seed material and the treating material is placed between the faces to be joined, and wherein the seed material and the treating material are heated to a temperature so that grain boundary movement renders the whole joined body into a single crystal body having the predetermined crystalline orientation.

2. A method for producing grain oriented electromagnetic steel sheets having improved magnetic properties using the method of claim 1, the method comprising the steps:
(a) forming the treating material by hot rolling a slab of silicon-containing steel, forming the hot rolled sheet into a final thickness, optionally by annealing and/or cold rolling, and then subjecting it to finish annealing;
(b) joining recrystallized seed material on to an edge portion of the treating material after hot rolling and before finish annealing so that the following orientation relationships are satisfied$\begin{matrix}\begin{matrix}\text{¦α¦ ≦ 5°} \\ \text{1 ≦ ¦β¦ ≦ 5°}\end{matrix}\end{matrix}$ where α = the angle defined by a projection line of the 〈001〉 axis of the seed material with respect to the rolling face of the steel sheet and the rolling direction of the steel sheet;
β = the inclination angle of the 〈001〉 axis of the seed material with respect to the rolling face of the steel sheet, and
(c) heating the joint to a temperature sufficient to cause grain boundary movement so that orientation of the seed material grows over the whole of the steel sheet.

3. A method for producing bidirectional oriented electromagnetic steel sheets having improved magnetic properties using the method of claim 1, the method comprising the steps:
(a) forming the treating material by hot rolling a slab of silicon-containing steel, forming the hot rolled sheet into a final thickness, optionally by annealing and/or cold rolling, and then subjecting it to a finish annealing,
(b) joining recrystallized seed material on to an edge portion of the steel sheet after hot rolling and before finish annealing so that the following orientation relationships are satisfied$\begin{matrix}\begin{matrix}\text{¦α¦ ≦ 10°} \\ \text{¦β¦ ≦ 10°}\end{matrix}\end{matrix}$ where α = the angle defined by a projection line of the 〈001〉 axis of the seed material with respect to the rolling face of the steel sheet and the rolling direction of the steel sheet;
β = the inclination angle of the {001} face of the seed material with respect to the rolling face of the steel sheet, and
(c) heating the joint to a temperature sufficient to cause grain boundary movement so that orientation of the seed material grows over the whole of the steel sheet.

4. A method as claimed in claim 2 or 3 wherein the method further includes the step of subjecting the steel sheet to primary recrystallisation annealing before finish annealing.

5. A method as claimed in claim 2, 3 or 4, wherein the amount of C in the steel before the cold rolling is reduced to not more than 0.010 wt%.

6. A method of producing orientation controlled steel sheets as claimed in any of claims 2 to 5 wherein a coil-like steel sheet is used as the treating material and the seed material is contacted and joined with a coiled end face of the coil-like steel sheet and heated so that the coil-like steel sheet becomes a crystal body having the predetermined crystalline orientation.

7. A method as claimed in any preceding claim wherein the treating material and the seed material are joined under the application of stress.

8. A method as claimed in any preceding claim wherein heating is performed in a non-oxidizing atmosphere.

## Patentansprüche

1. Verfahren zur Herstellung von Kristallkörpern mit einer kontrollierten Kristallorientierung,
wobei das Behandlungsmaterial mit einem Keimmaterial zusammengebracht wird, das diesselbe Kristallstruktur hat wie das Behandlungsmaterial, das eine vorbestimmte Kristallorientierung besitzt und das in einem niedrigeren Energiezustand ist als das Behandlungsmaterial;
wobei entweder die zusammenzufügenden Flächen des Keimmaterials und des Behandlungsmaterials aktiviert werden oder zwischen den zusammenzufügenden Flächen ein Einschubteil angeordnet wird, das einen niedrigeren Schmelzpunkt hat als das Keimmaterial und das Behandlungsmaterial,
wobei das Keimmaterial und das Behandlungsmaterial auf eine Temperatur erwärmt werden, so daß die Korngrenzenbewegung den ganzen Verbundkörper in einen Einkristallkörper mit einer vorbestimmten Kristallorientierung umwandelt.

2. Verfahren zur Herstellung kornorientierter, elektromagnetischer Stahlbleche, die bessere magnetische Eigenschaften haben, mittels des Verfahrens nach Anspruch 1, wobei das Verfahren die Schritte umfaßt:
(a) Formen des Behandlungsmaterials durch Heißwalzen einer Bramme aus siliciumhaltigem Stahl, Formen des heißgewalzten Blechs auf eine Enddicke, gegebenenfalls durch Tempern und/oder Kaltwalzen, und dann Unterwerfen des Blechs einem Endtempern;
(b) nach dem Heißwalzen oder vor dem Endtempern, Fügen von rekristallisiertem Keimmaterial an einen Kantenabschnitt des Behandlungsmaterials, so daß die nachstehenden Orientierungsbeziehungen erfüllt werden:$\begin{matrix}\begin{matrix}\text{¦α¦ ≦ 5°} \\ \text{1 ≦ ¦β¦ ≦ 5°}\end{matrix}\end{matrix}$ worin α der Winkel ist, der von der Verlängerungslinie der 〈001〉-Achse des Keimmaterials bestimmt wird und zwar bezüglich der Walzseite und der Walzrichtung des Stahlblechs;
β der Neigungswinkel der 〈001〉-Achse des Keimmaterials ist und zwar bezüglich der Walzseite des Stahlblechs; und
(c) Erwärmen des Verbunds auf eine Temperatur, die hoch genug ist, um eine Korngrenzenbewegung zu verursachen, so daß sich die Orientierung des Keimmaterials über das ganze Stahlblech ausbreitet.

3. Verfahren zur Herstellung bidirektional gerichteter, elektromagnetischer Stahlbleche, die bessere magnetische Eigenschaften haben, wobei das Verfahren nach Anspruch 1 verwendet wird und die Schritte umfaßt:
(a) Formen des Behandlungsmaterials durch Heißwalzen einer Bramme aus siliciumhaltigem Stahl, Formen des heißgewalzten Blechs auf eine Enddicke, gegebenenfalls durch Tempern und/oder Kaltwalzen, und Unterwerfen des Blechs einem Endtempern;
(b) nach Heißwalzen und vor dem Endtempern, Zusammenbringen des rekristallisierten Keimmaterial mit einem Kantenabschnitt des Stahlblechs, so daß die folgenden Orientierungsbeziehungen erfüllt werden:$\begin{matrix}\begin{matrix}\text{¦α¦ ≦ 10°} \\ \text{¦β¦ ≦ 10°}\end{matrix}\end{matrix}$ worin α der Winkel ist, der von der Verlängerungsline der 〈001〉-Achse des Keimmaterials bestimmt wird und zwar bezüglich der Walzseite des Stahlblechs und der Walzrichtung des Stahlblechs;
β der Neigungswinkel der {001}-Seite des Keimmaterials ist und zwar bezüglich der Walzseite des Stahlblechs, und
(c) Erwärmen des Verbunds auf eine Temperatur, die hoch genug ist, um eine Korngrenzenbewegung zu verursachen, so daß sich die Orientierung des Keimmaterials über das ganze Stahlblech ausbreitet.

4. Verfahren nach Anspruch 2 oder 3, wobei das Verfahren ferner den Schritt umfaßt: Unterwerfen des Stahlblechs vor dem Endtempern einem ersten Rekristallisationstempern.

5. Verfahren nach Anspruch 2, 3 oder 4, wobei die Menge an C im Stahl vor dem Kaltwalzen auf nicht mehr als 0,010 Gew.% reduziert wird.

6. Verfahren zur Herstellung orientierungskontrollierter Stahlbleche nach irgendeinem der Ansprüche 2 bis 5, wobei als Behandlungsmaterial ein Stahlblech-Coil verwendet wird und das Keimmaterial mit einer Coil-Stirnseite des Stahlblech-Coils in Kontakt gebracht, zusammengefügt und erwärmt wird, so daß das Stahlblech-Coil zu einem Kristallkörper mit einer vorbestimmten Kristallorientierung wird.

7. Verfahren nach irgendeinem vorhergehenden Anspruch, wobei das Behandlungsmaterial und das Keimmaterial unter Anwendung von Druck miteinander verbunden werden.

8. Verfahren nach irgendeinem vorhergehenden Anspruch, wobei das Erwärmen unter einer nichtoxidierenden Atmosphäre erfolgt.

## Revendications

1. Procédé de fabrication de corps cristallins ayant une orientation cristalline réglée, dans lequel un matériau germe qui a une structure cristalline identique à celle d'un matériau de traitement et une orientation cristalline prédéterminée et qui est à un état d'énergie inférieur à celui du matériau de traitement est raccordé au matériau de traitement, dans lequel soit les faces du matériau germe et du matériau de traitement qui doivent être raccordés ont été activées, soit un organe rapporté ayant une température de fusion inférieure à celle du matériau germe et du matériau de traitement est placé entre les faces à raccorder, et dans lequel le matériau germe et le matériau de traitement sont chauffés à une température telle que le mouvement aux limites des grains transforme l'ensemble du corps raccordé en un corps monocristallin ayant l'orientation cristalline prédéterminée.

2. Procédé de fabrication de tôles d'acier électromagnétique à grains orientés ayant d'excellentes propriétés magnétiques par mise en oeuvre du procédé de la revendication 1, le procédé comprenant les étapes suivantes :
(a) la formation du matériau de traitement par laminage à chaud d'une billette d'acier contenant du silicium, la mise de la feuille laminée à chaud à une épaisseur finale, éventuellement avec recuit et/ou laminage à froid, puis l'application d'un recuit de finition,
(b) le raccordement d'un matériau germe recristallisé sur une partie de bord du matériau de traitement après le laminage à chaud et avant le recuit de finition afin que les relations suivantes d'orientation soient obtenues$\begin{matrix}\begin{matrix}\text{|α| ≦ 5°} \\ \text{1 ≦ |β| ≦ 5°}\end{matrix}\end{matrix}$ α étant l'angle formé par une droite de projection de l'axe 〈001〉 du matériau germe par rapport à la face de laminage de la tôle d'acier et la direction de laminage de la tôle d'acier, et β étant l'angle d'inclinaison de l'axe 〈001〉 du matériau germe par rapport à la face de laminage de la tôle d'acier, et
(c) le chauffage du raccord à une température suffisante pour provoquer un déplacement aux limites des grains afin que l'orientation du matériau germe croisse sur toute la feuille d'acier.

3. Procédé de fabrication de tôles d'acier électromagnétique à orientation bidirectionnelle ayant d'excellentes propriétés magnétiques par mise en oeuvre du procédé de la revendication 1, le procédé comprenant les étapes suivantes :
(a) la formation du matériau de traitement par laminage à chaud d'une billette d'acier contenant du silicium, la mise à l'épaisseur finale de la tôle laminée à chaud, éventuellement avec recuit et/ou laminage à froid, puis l'application d'un recuit de finition,
(b) le raccordement d'un matériau germe recristallisé sur une partie de bord de la tôle d'acier après le laminage à chaud et avant le recuit de finition afin que les relations suivantes d'orientation soient obtenues$\begin{matrix}\begin{matrix}\text{|α| ≦ 10°} \\ \text{|β| ≦ 10°}\end{matrix}\end{matrix}$ α étant l'angle délimité par une projection de l'axe 〈001〉 du matériau germe par rapport à la face de laminage de la tôle d'acier et la direction de laminage de la tôle d'acier, et β l'angle d'inclinaison de la face {001} du matériau germe par rapport à la face de laminage de la tôle d'acier, et
(c) le chauffage du raccord à une température suffisante pour qu'il provoque un mouvement des limites des grains tel que l'orientation du matériau germe se propage dans toute la tôle d'acier.

4. Procédé selon la revendication 2 ou 3, dans lequel le procédé comprend en outre l'étape d'un recuit de recristallisation primaire de la tôle d'acier avant le recuit de finition.

5. Procédé selon la revendication 2, 3 ou 4, dans lequel la quantité de carbone de l'acier avant laminage à froid est réduite à une valeur qui ne dépasse pas 0,010 % en poids.

6. Procédé de production de tôles d'acier à orientation réglée selon l'une des revendications 2 à 5, dans lequel une tôle d'acier sous forme enroulée est utilisée comme matériau de traitement, et le matériau germe est mis au contact de la face d'extrémité enroulée de la tôle d'acier enroulée et raccordé à cette face puis chauffé de manière que la tôle d'acier enroulée devienne un corps cristallin ayant une orientation cristalline prédéterminée.

7. Procédé selon l'une quelconque des revendications précédentes, dans lequel le matériau de traitement et le matériau germe sont raccordés par application d'une contrainte.

8. Procédé selon l'une quelconque des revendications précédentes, dans lequel le chauffage est réalisé en atmosphère non oxydante.
